(19) Europäisches Patentamt / European Patent Office / Office européen des brevets

(11) **EP 3 304 101 B1**

(12) **EUROPEAN PATENT SPECIFICATION**

(45) Date of publication and mention of the grant of the patent:
**15.05.2019   Bulletin 2019/20**

(51) Int Cl.:
***G01R 22/06*** ***(2006.01)***

(21) Application number: **16745859.5**

(22) Date of filing: **03.06.2016**

(86) International application number:
**PCT/IT2016/000145**

(87) International publication number:
**WO 2016/194013 (08.12.2016 Gazette 2016/49)**

(54) **METHOD FOR DETERMINING ELECTRICAL LOSSES OF A POWER LINE, DUE TO A MALFUNCTIONING OR TAMPERING OF AN ELECTRICITY METER AND/OR TO AN ILLEGAL CONNECTION TO SAID POWER LINE**

VERFAHREN ZUR BESTIMMUNG DER ELEKTRISCHEN VERLUSTE EINER STROMLEITUNG AUFGRUND EINER FUNKTIONSSTÖRUNG ODER DER MISSBRÄUCHLICHEN BENUTZUNG EINES STROMZÄHLERS UND/ODER EINER ILLEGALEN VERBINDUNG ZU DIESER STROMLEITUNG

PROCÉDÉ DE DÉTERMINATION DES PERTES ÉLECTRIQUES D'UNE LIGNE ÉLECTRIQUE, DUES À UN DYSFONCTIONNEMENT OU UNE ALTÉRATION D'UN COMPTEUR ÉLECTRIQUE ET/OU À UNE CONNEXION ILLÉGALE À LADITE LIGNE ÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.06.2015   IT UB20151210**

(43) Date of publication of application:
**11.04.2018   Bulletin 2018/15**

(73) Proprietors:
• **AGT S.r.l.**
**00192 Roma (RM) (IT)**
• **LISO S.r.l.**
**60020 Camerata Picena (AN) (IT)**

(72) Inventors:
• **VACCARIO, Giacomo**
**00192 Roma (RM) (IT)**
• **UGOLINI, Filippo**
**00192 Roma (RM) (IT)**
• **DE LUCCIA, Marco**
**00192 Roma (RM) (IT)**
• **TRAMONTI, Francesco**
**00192 Roma (RM) (IT)**
• **TRAMONTI, Alessandro**
**00192 Roma (RM) (IT)**

(74) Representative: **Santi, Filippo et al**
**Barzanò & Zanardo Roma S.p.A.**
**Via Piemonte 26**
**00187 Roma (IT)**

(56) References cited:
• **FOURIE J W ET AL: "A statistical method to minimize electrical energy losses in a local electricity distribution network", AFRICON, 2004. 7TH AFRICON CONFERENCE IN AFRICA GABORONE, BOTSWANA SEPT. 15-17, 2004, PISCATAWAY, NJ, USA,IEEE, vol. 2, 15 September 2004 (2004-09-15), pages 667-673, XP010780534, DOI: 10.1109/AFRICON.2004.1406768 ISBN: 978-0-7803-8605-1**
• **ABHISHEK CHAUHAN ET AL: "Non-Technical Losses in power system: A review", POWER, ENERGY AND CONTROL (ICPEC), 2013 INTERNATIONAL CONFERENCE ON, IEEE, 6 February 2013 (2013-02-06), pages 558-561, XP032423684, DOI: 10.1109/ICPEC.2013.6527720 ISBN: 978-1-4673-6027-2**

- **SHIH-CHE HUANG ET AL: "Non-Technical Loss Detection Using State Estimation and Analysis of Variance", IEEE TRANSACTIONS ON POWER SYSTEMS, IEEE SERVICE CENTER, PISCATAWAY, NJ, US, vol. 28, no. 3, 1 August 2013 (2013-08-01) , pages 2959-2966, XP011520925, ISSN: 0885-8950, DOI: 10.1109/TPWRS.2012.2224891**

- **NIZAR A H ET AL: "Power Utility Nontechnical Loss Analysis With Extreme Learning Machine Method", IEEE TRANSACTIONS ON POWER SYSTEMS, IEEE SERVICE CENTER, PISCATAWAY, NJ, US, vol. 23, no. 3, 1 August 2008 (2008-08-01) , pages 946-955, XP011231767, ISSN: 0885-8950, DOI: 10.1109/TPWRS.2008.926431**

**Description**

The present invention relates to a method for determining electrical losses of a power line due to a malfunctioning or tampering of an electricity meter and/or to an illegal connection to said power line.

Illegal connection is defined as at least one load abusively connected to the power line, therefore without that an electricity meter can measure the energy consumed by said load.

In particular, the present invention relates to a method that allows to determine possible frauds to the detriment of an entity responsible for the supply of electrical energy. Such frauds may be caused by a tampered electricity meter or by an illegal connection to a power line.

With reference to a tampered electricity meter, the electricity meter can be tampered with, for example, by applying a magnet over it, so that electrical energy continues to be consumed but is not quantified correctly and therefore not paid by the user associated with such a counter of electricity.

An electricity meter allows to monitor the trend of flows of electricity consumed during the day, allowing to evaluate a possible tariff change or redistribution of daily electricity consumption.

However, if tampered, the electricity meter is no longer able to provide the actual value of the electrical energy consumption.

Electricity meter is defined as an electric meter or an electronic meter by which it is possible to control the energy consumption of a user.

The electricity meter allows at any time to know how much electricity is consumed by a user and to measure the power absorbed by electrical appliances of said user. In fact, although the electricity consumed by a user is displayed by means of an electricity meter, the electricity meter also measures the power absorbed by said user.

Below, reference will be made to the power absorbed by a user as the power absorbed by the electrical equipment of said user.

**Prior art**

A method of known type for measuring the electrical losses of a power line is based on genetic algorithms, i.e. algorithms based on the principle of natural selection and biological evolution to solve optimization problems.

A drawback of said method is that the operation is connected with the possibility of access to a high amount of data, which, however, need to be subjected to an appropriate processing, with the risk of excluding a good part of said data.

For example, in the publication "Detection of Abnormaliteis and Electricity Theft using Genetic support vector machines" of Nagi et al, data concerning daily average electrical consumption of 265870 users for a period of 9125 days have been collected.

With reference to the data relating to said average electrical consumption, about 30% of said data was discarded and 70% of them has been subjected to a further processing, before implementation of a genetic algorithm.

Therefore a drawback of such a method is that filtering steps requiring time are necessary and that more than one processing in order to implement a genetic algorithm are necessary, with the ensuing costs.

A further drawback is the fact that such a method is not particularly efficient to find possible defrauders.

In the publication mentioned above it is stated that the method has a low efficiency because with respect to a number of possible defrauders equal to 100, as a result from said method, only 37 were found to be actual defrauders, after a check by the operators assigned to control possible frauds.

Further relevant prior art documents are:

FOURIE J W ET AL: "A statistical method to minimize electrical energy losses in a local electricity distribution network", AFRICON, 2004. 7TH AFRICON CONFERENCE IN AFRICA GABORONE, BOTSWANA SEPT. 15-17, 2004, PISCATAWAY, NJ, USA, IEEE, vol. 2, 15 September 2004 (2004-09-15), pages 667-673;

ABHISHEK CHAUHAN ET AL: "Non-Technical Losses in power system: A review", POWER, ENERGY AND CONTROL (ICPEC), 2013 INTERNATIONAL CONFERENCE ON, IEEE, 6 February 2013 (2013-02-06), pages 558-561;

SHIH-CHE HUANG ET AL: "Non-Technical Loss Detection Using State Estimation and Analysis of Variance", IEEE TRANSACTIONS ON POWER SYSTEMS, IEEE SERVICE CENTER, PISCATAWAY, NJ, US, vol. 28, no. 3, 1 August 2013 (2013-08-01), pages 2959-2966;

NIZAR A H ET AL: "Power Utility Nontechnical Loss Analysis With Extreme Learning Machine Method", IEEE TRANSACTIONS ON POWER SYSTEMS, IEEE SERVICE CENTER, PISCATAWAY, NJ, US, vol. 23, no. 3, 1 August 2008 (2008-08-01), pages 946-955.

J

## Object of the invention

Object of the invention is the overcoming of said drawbacks by providing a method for determining electrical losses of a power line due to a malfunctioning of an electricity meter or tampering of the electricity meter itself and/or to an illegal connection to said power line, whose efficiency is greater with respect to the methods of known type.

In particular, the method object of the present invention according to claim 1 allows to identify one or more users whose electricity meter is malfunctioning or tampered, as well as the presence of a possible illegal connection to the power line, where said malfunctioning or tampered electricity meter and/or said possible illegal connection cause electrical losses of said power line.

A second object of the present invention is to provide a computer program according to claim 9 to perform the steps of said method.

A further object of the present invention is a system according to claim 10 for determining said electrical losses.

It is therefore specific object of the invention a method for determining electrical losses of at least one power line due to a malfunctioning or tampering of an electricity meter and/or to an illegal connection to said power line, where said at least one power line is connected to a plurality of users and a transformer room for providing with electric current, through said at least one power line, to said plurality of users, and with at least one power meter to measure the power supplied from said transformer room to said power line in predetermined time units present in a predetermined period of time, said power meter being arranged on said at least one power line between said transformer room and said users..

Said method comprising the following steps:

A) acquiring an average value of power s with reference to the power supplied from said transformer room to said power line and measured by said power meter, in such a way as to obtain a sequence of average values of power in each predetermined time unit present in the predetermined time period $(s)_k$, with k=1,...,M where M is a positive integer, where k is the index of the number of the predetermined time units in the predetermined time period;

B) calculating the average value $\bar{s}$ of the average values of power with reference to the average values of each sequence of power values $(s)_k$ and a standard deviation $\sigma_S$ referred to the power supplied from said transformer room to said power line and measured by said power meter:

$$\bar{s} = \frac{1}{M} \sum_{k=1}^{M} (s)_k$$

$$\sigma_S = \frac{1}{M} \sqrt{\sum_{k=1}^{M} ((s)_k - \bar{s})^2}$$

C) acquiring the power absorbed by each user in each predetermined time unit present in the predetermined time period, so as to obtain for each user a respective sequence of values of absorbed power $(f_i)_k$, with i=1,...,N where N is a positive integer, where i is the index of number of users

$\{(f_1)_1, (f_1)_2 \cdots (f_1)_M\}$
$\{(f_2)_1, (f_2)_2 \cdots (f_2)_M\}$
$\{(f_N)_1, (f_N)_2 \cdots (f_N)_M\}$

D) calculating the mean value $\bar{f_i}$ and the standard deviation $\sigma_i$ of each sequence of values of power absorbed by each user:

$$\bar{f_i} = \frac{1}{M} \sum_{k=1}^{M} (f_i)_k$$

$$\sigma_i = \frac{1}{M} \sqrt{\sum_{k=1}^{M} ((f_i)_k - \bar{f_i})^2}$$

E) calculating a sequence of difference values $(D)_k$, each of which is equal to the difference between the power supplied from said transformer room to said power line and measured by said power meter and the sum of the powers absorbed by each user for each predetermined time unit present in the predetermined time period:

$$(D)_k = (s)_k - \sum_{i=1}^{N} (f_i)_k$$

F) calculating the mean value $\overline{D}$ and the standard deviation $\sigma_D$ of said sequence of difference values:

$$\overline{D} = \frac{1}{M} \sum_{k=1}^{M} (D)_k$$

$$\sigma_D = \frac{1}{M} \sqrt{\sum_{k=1}^{M} ((D)_k - \overline{D})^2}$$

G) determining an average value of efficiency $\overline{e}$ associated with said power line in the predetermined time period with the following formula:

$$\overline{e} = \frac{1}{M} \sum_{k=1}^{M} \left( \frac{\sum_{i=1}^{N} (f_i)_k}{(s)_k} \right)$$

H) comparing said average value of efficiency $\overline{e}$ with a predetermined first threshold or predetermined efficiency threshold;

I) if the average value of said efficiency $\overline{e}$ is greater than or equal to the predetermined efficiency threshold, no electrical loss is reported to an entity responsible for the supply of electricity with reference to electrical losses due to a malfunctioning or tampering with a electricity meter associated with a respective user;

L) if the average value of said efficiency $\overline{e}$ is less than said predetermined efficiency threshold, performing the following steps:

L1) calculating the statistical correlation coefficient $\rho_i$ associated with each user between each sequence of values of power absorbed $(f_i)_k$ by a respective user and said sequence of difference values $(D)_k$ in the predetermined time period, normalized with the product of the standard deviations $\sigma_i$ of the respective sequences of values of power consumed and the standard deviation $\sigma_D$ of the sequence of difference values, with the following formula:

$$\rho_i = \frac{\sum_{k=1}^{M} ((f_i)_k - \bar{f_i})((D)_k - \overline{D})}{\sigma_i \sigma_D}$$

L2) comparing the statistical correlation coefficient $\rho_i$ associated with each user with a predetermined second threshold or predetermined correlation threshold;

L3) if one or more statistical correlation coefficients $\rho_i$ associated to one or more respective users are greater or equal to said predetermined correlation threshold, reporting said users to an entity responsible for the supply of electricity with reference to electrical losses due to a malfunctioning or tampering of one or more electricity meters associated with said users;

M) determining the presence of at least one illegal connection to said power line by the following steps:

M1) defining a M-dimensional column vector y formed by a sequence of difference values $(D)_K$:

$$y = \begin{pmatrix} (D)_1 \\ (D)_2 \\ . \\ . \\ . \\ (D)_M \end{pmatrix}$$

M2) defining a matrix X with M rows and N+1 columns, where the first column is a column of constant values $\alpha$, equal to each other, and each of the remaining columns is composed of a sequence of values of power absorbed by a respective user in each predetermined time unit:

$$X = \begin{pmatrix} \alpha & (f_1)_1 & (f_2)_1 & . & . & . & (f_N)_1 \\ \alpha & (f_1)_2 & (f_2)_2 & . & . & . & (f_N)_2 \\ . & . & . & & . & . & . & . \\ . & . & . & & . & . & . & . \\ . & . & . & & . & . & . & . \\ \alpha & (f_1)_M & (f_2)_M & . & . & . & (f_N)_M \end{pmatrix}$$

M3) defining a linear equation in matrix form with the following formula:

$$\theta = \left( X^T X \right)^{-1} X^T y$$

where $\theta$ is a column vector so defined:

$$\theta = \begin{pmatrix} \theta_0 \\ \theta_1 . \\ . \\ . \\ \theta_N \end{pmatrix}$$

$\theta_0, \theta_1 ... \theta_N$ are the components of the column vector $\theta$ constituting the parameters that solve said linear equation in matrix form,
$X^T$ is the transposed matrix of the matrix X,
$(X^T X)^{-1}$ is the pseudo inverse matrix of Moore-Penrose of the matrix resulting from the multiplication of the transposed matrix $X^T$ and the matrix X,
y is the M-dimensional column vector defined at the step M1);

M4) comparing the first parameter $\theta_0$ of said column vector $\theta$ with a predetermined third threshold, where said predetermined third threshold is selected such that the result of the multiplication between the said predetermined third threshold and a constant value $\alpha$ is a predetermined average value of absorbed power for unit of time above which at least one illegal connection to said power line is to be found;

M5) if said first parameter $\theta_0$ is greater than or equal to said predetermined third threshold, reporting at least one electrical loss to an entity responsible for the supply of electricity due to at least one illegal connection to said power line.

After the step I), said method can comprise the following steps:

I1) calculating the autocorrelation $A_D$ of said sequence of difference values $(D)_k$ normalized with the square of the standard deviation $\sigma_D$ of said sequence of difference values:

$$A_D = \frac{\sum_{k=1}^{M-\tau}\left((D)_k - \overline{D}\right)\left((D)_{k+\tau} - \overline{D}\right)}{\sigma_D^2}$$

where $\tau$ is the ratio between a further predetermined time period and a predetermined time unit, where said further predetermined time period and said predetermined time unit have the same units of measurement;

I2) calculating the autocorrelations $A$ of each of said sequence of values of power absorbed $(f_i)_k$ by each user normalized with the square of the standard deviation $\sigma_i$ of each sequence of values of absorbed power:

$$A_i = \frac{\sum_{k=1}^{M-\tau}\left((f_i)_k - \bar{f}_i\right)\left((f_i)_{k+\tau} - \bar{f}_i\right)}{\sigma_i^2}$$

I3) obtaining a weighted average $\overline{A}$ of said autocorrelations $A_i$ of sequences of values of power absorbed by each user:

$$\overline{A} = \sum_{i=1}^{N} \beta_i A_i = \sum_{i=1}^{N} \frac{\bar{f}_i}{\overline{s} - \overline{D}} A_i$$

where $\beta_i$ is a weight defined by the ratio between said average value $\bar{f}_i$ of each sequence of values of absorbed power and the difference between said average value $\overline{s}$ of the average values of power and said average value $\overline{D}$ of said sequence of difference values;

I4) comparing the value of said autocorrelation $A_D$ with the value of said weighted average $\overline{A}$;

15) if the value of said autocorrelation $A_D$ is greater than the value of said weighted average $\overline{A}$, reporting at least one electrical loss to an entity responsible for the supply of electricity due to at least one illegal connection to said power line.

In particular, the values of said sequence of values of power absorbed $(f_i)_k$ by each user, the mean value $\bar{f}_i$ and the standard deviation $\sigma_i$ of each sequence of values of power absorbed $(f_i)_k$ by each user, the values of said sequence of difference values $(D)_k$, the mean value $\overline{D}$ and the standard deviation $\sigma_D$ of said sequence of difference values $(D)_k$ can be values of derivatives of order zero or, in alternative, values of higher order derivatives.

In the latter case, it is preferable that said higher order derivatives are derivatives of the first order.

With reference to said predetermined third threshold, said predetermined third threshold is chosen in function of the unit of measurement used for the powers absorbed by each user and for the sequences of values of power absorbed $(f_i)_k$ by a respective user.

Furthermore, when the standard deviation $\sigma_i$ of one or more sequences of values of absorbed power $\{(f_1)_1,(f_1)_2...(f_1)_M; (f_2)_1,(f_2)_2...(f_2)_M;... (f_N)_1,(f_N)_2...(f_N)_M\}$ by a respective user is equal to zero, it is not possible to calculate the statistical correlation coefficient $\rho_i$ of said one or more sequences of values of absorbed power $(f_i)_k$, and the respective user is reported to said entity responsible for the supply of electricity.

Advantageously, said predetermined correlation threshold can be chosen in a first range of values, from a value greater than or equal to 0,4 to a value equal to 1, or in a second range of values, from a value greater than or equal to 0,2 to a value lower than 0,4, or in a third range of values, from a value greater than or equal to 0,1 to a value lower than 0,2.

Furthermore, it is an object of the invention a computer program, comprising code means configured in such a way that, when executed on a computer, it performs the steps of the method above mentioned.

It is a specific object of the invention also a system for determining electrical losses of at least one power line, to which a plurality of users is connected, where said system comprising said at least one power line, as well as:

- a transformer room for providing with electric current to said users of said plurality of users through said at least one power line,
- at least one electricity meter associated with a respective user of said plurality of users for measuring the power absorbed by said user, said electricity meter measuring the power absorbed by each user of said plurality of users in predetermined time units present in a predetermined time period, so as to obtain for each user a respective sequence of values of absorbed power $(f_i)_k$, with $i$ index of the number of users, $i=1,...,N$, with N a positive integer, and k index of the predetermined time unit, $k=1,...,M$, with M a positive integer, and
- at least a power meter for measuring the power supplied from said transformer room to said at least one power line in predetermined time units present in a predetermined time period, so as to obtain a sequence of average values of power $(s)_k$ in each of said predetermined time units, said power meter being positioned on said power line between said transformer room and said users.

Said system comprises a central unit with a computer configured to receive said sequence of values of absorbed power $(f_i)_k$ and said sequence of average values of power $(s)_k$, through a communication channel, and to run said program.

The present invention will be now described, for illustrative, but not limitative purposes, according to its embodiment, making particular reference to the enclosed figures, wherein:

Figure 1 shows a block diagram of the method according to the invention;
Figure 2 shows an example of application of the method of the invention.

Detailed description of the embodiment of the invention

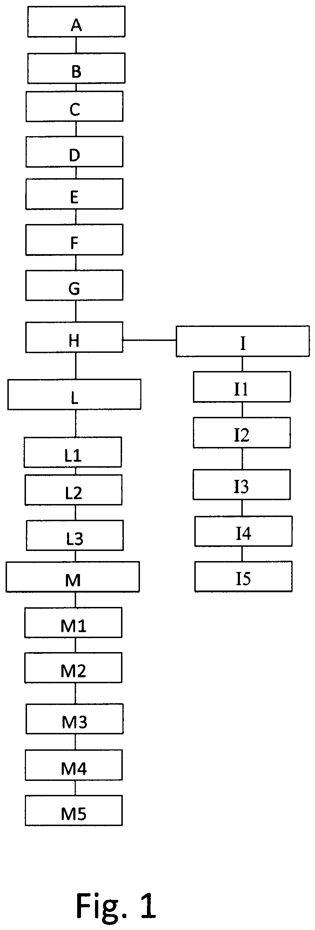

With reference to figure 1, a method for determining electrical losses of a power line, which are not due to the Joule effect is described.

In fact, it is known that a power line has electrical losses due to the Joule effect.

However, the method object of the invention is intended to determine that electrical losses due to a malfunctioning of a electricity meter or to a possible fraud, by means of tampering of a electricity meter associated with a user and/or an illegal connection to the power line.

In case of tampering of an electricity meter, the bill will show a consumption of electrical energy lower than the actual consumption of electrical energy.

In the case of an illegal connection to the power line, it is clear that no bill will exist.

In the example being described, reference is made to a power line to which a plurality of users $U_1,U_2...U_N$ are connected, each of which is associated with an electricity meter (not shown).

Furthermore, an transformer room for providing electric current to said users $U_1,U_2...U_N$ feeds the electrical equipment of said users via said power line, and a power meter to measure the output power to said transformer room (i.e. the power supplied from said electric cabin to said power line) is arranged on said power line between said transformer room and said users $U_1,U_2...U_N$.

With transformer room it is meant any electrical unit capable of transmitting electric current which, via the power line, reaches the same users.

Moreover, the measurement of power by said power meter is performed in predetermined time units present in a predetermined period of time.

Although not described, in the case of more transformer rooms and more power lines, each of which is connected to a respective transformer room, a respective electric power meter is present for each power line.

Said method comprises the following steps:

A) acquiring an average value of power s with reference to the power supplied from said transformer room to said power line and measured by said power meter, in such a way as to obtain a sequence of average values of power in each predetermined time unit present in the predetermined time period $(s)_k$, with $k=1,...,M$ where M is a positive integer, where k is the index of the number of the predetermined time units in the predetermined time period;

B) calculating the average value $\bar{s}$ of the average values of power with reference to the average values of each sequence of power values $(s)_k$ and a standard deviation $\sigma_s$ referred to the power supplied from said transformer room to said power line and measured by said power meter:

$$\bar{s} = \frac{1}{M} \sum_{k=1}^{M} (s)_k$$

$$\sigma_S = \frac{1}{M} \sqrt{\sum_{k=1}^{M} ((s)_k - \bar{s})^2}$$

C) acquiring the power absorbed by each user $U_1, U_2 ... U_N$ in each predetermined time unit present in the predetermined time period, so as to obtain for each user $U_1, U_2 ... U_N$ a respective sequence of values of absorbed power $(f_i)_k$, with $i=1,...,N$ where N is a positive integer, where $i$ is the index of number of users:

$$\{(f_1)_1, (f_1)_2 ... (f_1)_M\}$$
$$\{(f_2)_1, (f_2)_2 ... (f_2)_M\}$$
$$\{(f_N)_1, (f_N)_2 ... (f_N)_M\}$$

D) calculating the mean value $\bar{f_i}$ and the standard deviation $\sigma_i$ of each sequence of values of power absorbed by each user $U_1, U_2 ... U_N$:

$$\bar{f_i} = \frac{1}{M} \sum_{k=1}^{M} (f_i)_k$$

$$\sigma_i = \frac{1}{M} \sqrt{\sum_{k=1}^{M} ((f_i)_k - \bar{f_i})^2}$$

E) calculating a sequence of difference values $(D)_k$, each of which is equal to the difference between the power supplied from said transformer room to said power line and measured by said power meter and the sum of the powers absorbed by each user $U_1, U_2 ... U_N$ for each predetermined time unit present in the predetermined time period:

$$(D)_k = (s)_k - \sum_{i=1}^{N} (f_i)_k$$

F) calculating the mean value $\bar{D}$ and the standard deviation $\sigma_D$ of said sequence of difference values:

$$\bar{D} = \frac{1}{M} \sum_{k=1}^{M} (D)_k$$

$$\sigma_D = \frac{1}{M} \sqrt{\sum_{k=1}^{M} ((D)_k - \bar{D})^2}$$

G) determining an average value of efficiency $\bar{e}$ associated with said power line in the predetermined time period with the following formula:

$$\overline{e} = \frac{1}{M} \sum_{k=1}^{M} \left( \frac{\sum_{i=1}^{N} (f_i)_k}{(s)_k} \right)$$

H) comparing said average value of efficiency $\overline{e}$ with a predetermined first threshold or predetermined efficiency threshold;

I) if the average value of said efficiency $\overline{e}$ is greater than or equal to the predetermined efficiency threshold, no electrical loss due to a malfunctioning or tampering of a electricity meter is reported to an entity responsible for the supply of electricity and the following steps for verifying the presence of at least an illegal connection to said power line are performed:

11) calculating the autocorrelation $A_D$ of said sequence of difference values $(D)_k$ normalized with the square of the standard deviation $\sigma_D$ of said sequence of difference values:

$$A_D = \frac{\sum_{k=1}^{M-\tau} \left( (D)_k - \overline{D} \right)\left( (D)_{k+\tau} - \overline{D} \right)}{\sigma_D^2}$$

where $\tau$ is the ratio between a further predetermined time period and a predetermined time unit, where said further predetermined time period and said predetermined time unit have the same units of measurement;

12) calculating the autocorrelations $A_i$ of each of said sequence of values of power absorbed $(f_i)_k$ by each user $U_1, U_2 ... U_N$ normalized with the square of the standard deviation $\sigma_i$ of each sequence of values of absorbed power:

$$A_i = \frac{\sum_{k=1}^{M-\tau} \left( (f_i)_k - \overline{f}_i \right)\left( (f_i)_{k+\tau} - \overline{f}_i \right)}{\sigma_i^2}$$

13) obtaining a weighted average $\overline{A}$ of said autocorrelations $A_i$ of sequences of values of power absorbed by each user $U_1, U_2 ... U_N$:

$$\overline{A} = \sum_{i=1}^{N} \beta_i A_i = \sum_{i=1}^{N} \frac{\overline{f}_i}{\overline{s} - \overline{D}} A_i$$

where $\beta_i$ is a weight defined by the ratio between said average value $\overline{f}_i$ of each sequence of values of absorbed power and the difference between said average value $\overline{s}$ of the average values of power and said average value $\overline{D}$ of said sequence of difference values;

14) comparing the value of said autocorrelation $A_D$ with the value of said weighted average $\overline{A}$;

15) if the value of said autocorrelation $A_D$ is greater than the value of said weighted average $\overline{A}$, reporting at least one electrical loss to an entity responsible for the supply of electricity due to at least one illegal connection to said power line, otherwise if the autocorrelation $A_D$ has a value less or equal to the value of said weighted average $\overline{A}$ no electrical loss is reported;

L) if the average value of said efficiency $\overline{e}$ is less than said predetermined efficiency threshold, performing the following steps:

L1) calculating the statistical correlation coefficient $\rho_i$ associated with each user $U_1, U_2 ... U_N$ between each sequence of values of power absorbed $(f_i)_k$ by a respective user $U_1, U_2...U_N$, and said sequence of difference values $(D)_k$ in the predetermined time period, normalized with the product of the standard deviations of the respective sequences of values of power consumed and the standard deviation $\sigma_D$ of the sequence of difference values, with the following formula:

$$\rho_i = \frac{\sum_{k=1}^{M}\left((f_i)_k - \bar{f}_i\right)\left((D)_k - \bar{D}\right)}{\sigma_i \sigma_D}$$

L2) comparing the statistical correlation coefficient $\rho_i$ associated with each user $U_1, U_2...N_N$ with a predetermined second threshold or predetermined correlation threshold;

L3) if one or more statistical correlation coefficients $\rho_i$ associated to one or more respective users $U_1, U_2...U_N$ are greater or equal to said predetermined correlation threshold, reporting said users to an entity responsible for the supply of electricity with reference to electrical losses due to a malfunctioning or tampering of one or more electricity meters associated with said users, otherwise no electrical loss is reported;

M) determining the presence of at least one illegal connection to said power line by the following steps:

M1) defining a M-dimensional column vector y formed by a sequence of difference values $(D)_k$:

$$y = \begin{pmatrix} (D)_1 \\ (D)_2 \\ . \\ . \\ . \\ (D)_M \end{pmatrix}$$

M2) defining a matrix X with M rows and N+1 columns, where the first column is a column of constant values $\alpha$, equal to each other, and each of the remaining columns is composed of a sequence of values of power absorbed by a respective user $U_1, U_2...U_N$ in each predetermined time unit:

$$X = \begin{pmatrix} \alpha & (f_1)_1 & (f_2)_1 & . & . & . & (f_N)_1 \\ \alpha & (f_1)_2 & (f_2)_2 & . & . & . & (f_N)_2 \\ . & . & . & . & . & . & . \\ . & . & . & . & . & . & . \\ . & . & . & . & . & . & . \\ \alpha & (f_1)_M & (f_2)_M & . & . & . & (f_N)_M \end{pmatrix}$$

M3) defining a linear equation in matrix form with the following formula, according to the method of least squares:

$$\theta = \left(X^T X\right)^{-1} X^T y$$

where $\theta$ is a column vector so defined:

$$\theta = \begin{pmatrix} \theta_0 \\ \theta_1. \\ . \\ . \\ \theta_N \end{pmatrix}$$

and $\theta_0, \theta_1 ... \theta_N$ are the components of the column vector $\theta$ constituting the parameters that solve said linear equation in matrix form;
$X^T$ is the transposed matrix of the matrix X,
$(X^T X)^{-1}$ is the pseudo inverse matrix of Moore-Penrose of the matrix resulting from the multiplication of the transposed matrix $X^T$ and the matrix X,
y is the M-dimensional column vector defined at the step M1);

M4) comparing the first parameter $\theta_0$ of said column vector $\theta$ with a predetermined third threshold, where said predetermined third threshold is selected such that the result of the multiplication between the said predetermined third threshold and a constant value $\alpha$ is a predetermined average value of absorbed power for unit of time above which at least one illegal connection to said power line is to be found;
M5) if said first parameter $\theta_0$ is greater than or equal to said predetermined third threshold, reporting at least one electrical loss to an entity responsible for the supply of electricity due to at least one illegal connection to said power line.

With reference to the steps of the method above disclosed, in the example being described, the index k referred to the number of predetermined time units ranges from 1 to M and the index i referred to the number of users ranges from 1 to N. From a statistical point of view, it is preferable that M is greater than N+1.

In particular, in the embodiment being disclosed, M can be equal to 1344. This last number is obtained by the fact that a predetermined time unit of 15 minutes has been chosen. Consequently, in a day of 24 hours 96 predetermined time units are present and in a predetermined time period of 14 days 1344 predetermined time units are present (1344 = 96*14)
With reference to the steps A) and B), the power to which is made reference is the output power from the transformer room, measured by the power meter arranged between said transformer room and the users $U_1, U_2 ... U_N$ connected to said power line.

With reference to steps C) and D), the power to which is made reference is the power absorbed from a respective user, i.e. the power being measured by the electricity meter associated with the respective user, proportional, apart from a multiplying factor, to the energy consumed from the user itself that is indicated by said electricity meter. On the basis of the consumed energy the amount to be paid reported in the bill is established.

Also the power absorbed by each user $U_1, U_2 ... U_N$ is acquired in the same time units in which the power supplied from the transformer room to the power line is measured by the power meter.

With reference to the step E) a sequence of difference values is calculated, where each of said difference values is given by the difference between the power supplied from the transformer room to the power line and measured by the power meter and the sum of the powers absorbed by each user connected to the power line. Each difference value of said sequence of difference value is obtained in a respective predetermined time unit present in the predetermined time period.

In other words, with reference to the power line, such difference shows electrical losses due to a malfunctioning of an electricity meter and/or tampering of a electricity meter and/or an illegal connection to said power line, to which electrical losses due the Joule effect have been added, always present in a power line.

With reference to the step G), the average value of the efficiency associated with the power line is the first reference parameter for determining the presence of electrical losses on the power line due to a malfunctioning or tampering of an electricity meter.

With reference to step H) relative to the comparison of the average value of efficiency with a predetermined first threshold or predetermined efficiency threshold, it is preferable that said predetermined efficiency threshold is set equal to 0.9. It is taken into account that generally the electrical losses of a power line not due to a possible fraud, such as electrical losses due to the Joule effect, in percentage terms are equal to about 7% of the power output from the transformer room to the power line itself. In terms of efficiency, this means that the power line has an efficiency equal to about 93%. Therefore, choosing a predetermined efficiency threshold equal to 0,9 means analyzing electrical losses greater than 10%, i.e. electrical losses due to a possible fraud.

In a first case, if the average value $\bar{e}$ associated with said power line efficiency is greater than or equal to a predetermined efficiency threshold no electrical loss is reported to an entity responsible for the supply of electrical energy (step I)). This means that no electrical loss due to a malfunctioning or tampering of an electricity meter associated with a user is determined.

Although no electric loss due to a malfunctioning or tampering of an electricity meter has been determined, further steps 11), 12), 13), 14) and 15) are performed to determine the presence of at least one illegal connection to the power line.

However, said further steps are not necessary but it is preferable that they are provided.

In particular, with reference to the parameter $\tau$ mentioned in step 11), it is the ratio of a further predetermined time period, which is not necessarily equal to the predetermined time period of 14 days, and the predetermined time unit.

For example, said parameter $\tau$ can be equal to 96 as a result of the relationship between a further predetermined time period consisting of 1440 minutes (i.e. the minutes of which 1 day is composed = 24 hours) and the predetermined time unit consisting of 15 minutes.

From the comparison of the autocorrelation value $A_D$ of the sequence of difference values (referred to the step E)) with the value of the weighted average $\bar{A}$ of the autocorrelations $A_i$ of the sequences of values of power absorbed by each user it can be derived the presence of at least one illegal connection to said power line. In fact, if the autocorrelation value $A_D$ of the sequence of difference values is greater than the value of the weighted average $\bar{A}$ of the autocorrelations $A_i$ of the sequence of values of power absorbed by each user, at least one electrical loss is reported to the entity responsible for the supply of electrical energy.

In a second case, if the average value of efficiency $\bar{e}$ is less than a predetermined correlation threshold, a statistical correlation coefficient $\rho_i$ of each sequence of values of power absorbed $(f_i)_k$ by each user is calculated and compared with a predetermined second threshold or predetermined correlation threshold to determine electrical losses due to a malfunctioning or tampering with a electricity meter, so that each user who is associated the respective tampered or malfunctioning electricity meter is reported to the entity responsible for the supply of the electrical energy.

With particular reference to step L1), in some cases it is not possible to calculate the statistical correlation coefficient $\rho_i$. This occurs when the standard deviation $\sigma_i$ of a sequence of values of power absorbed $\{(f_1)_1,(f_1)_2...(f_1)_M; (f_2)_1,(f_2)_2...(f_2)_M; (f_N)_1,(f_N)_2...(f_N)_M\}$ referred to a respective user $U_1,U_2...U_N$ is zero, i.e. when the power absorbed by a user measured by an electricity meter associated to said user has a constant value in each predetermined time unit and as a result the standard deviation is zero. For example, this situation can happen when an electricity meter is switched off.

With particular reference to step L2), said predetermined correlation threshold can be chosen within a predetermined range of values.

For example, said predetermined correlation threshold can be chosen in:

- a first range of values that ranges from a value greater than or equal to 0,4 to a value equal to 1,
- a second range of values that ranges from a value greater than or equal to 0,2 to a value less than 0,4,
- or a third range of values that ranges from a value greater than or equal to 0.1 to a value less than 0.2.

With a predetermined correlation threshold chosen within the first range of values, out of a possible number of one hundred fraudsters, it is possible to identify ninety users making a fraud.

With a predetermined correlation threshold chosen within the second range of values, out of a possible number of one hundred fraudsters, it is possible to identify forty user making fraud.

With a predetermined correlation threshold chosen within the third range of values, out of a possible number of one hundred fraudsters, it is possible to identify eight users making a fraud.

It is therefore preferable to choose a predetermined correlation threshold within the first range of values.

Regardless of the value of the statistical correlation $\rho_i$ associated with a respective user the steps for determining the presence of at least one illegal connection to said power are performed.

With reference to a power line, the method is based on the possibility of associating to each user, connected to the power line, a respective statistical correlation coefficient to be compared with a predetermined correlation threshold for determining possible electrical losses due to a malfunctioning of the electricity meter and/or tampering of the electricity meter. In particular, each of the statistical correlation coefficient describes the correlation between the power absorbed by a respective user in each predetermined time unit and the electrical losses of the power line.

In the event that an electricity meter associated with a respective user is malfunctioning or tampered, the statistical correlation coefficient associated with said user is greater than the predetermined correlation threshold, since an increase of power absorbed by said user implies an increase of electrical losses of said power line and a reduction of power absorbed by said user means a reduction of electrical losses of said power line.

Consequently, the user whose the statistical correlation coefficient is greater than said predetermined correlation threshold are reported to the entity responsible for the supply of electrical energy in order to the electricity meter associated with them is controlled.

With particular reference to the step M1), a column vector M-dimensional y is created, whose components are the values of the sequence of difference values $(D)_k$.

With particular reference to step M2), a matrix with M rows and N + 1 columns is created, where the components of the first column are equal to each other and each of them is a constant value $\alpha$.

Each constant value $\alpha$ present in the first column of the matrix X is expressed in the same unit of measurement with which the powers absorbed by each user are expressed.

Furthermore, each constant value $\alpha$ is a value of power absorbed referred to at least one illegal connection to said power line.

With particular reference to step M3) a linear equation in matrix form is defined, where $(X^T X)^{-1}$ is the pseudo inverse matrix of Moore-Penrose resulting from the multiplication of the transposed matrix $X^T$ and the matrix X.

According to the invention, it has been chosen to use the pseudo inverse matrix of Moore-Penrose, rather than the inverse matrix generally used in the method of least squares, since the inverse matrix of the matrix resulting from the multiplication of the transposed matrix $X^T$ and the matrix X does not exist if sequences of values of power absorbed equal to zero are present (resulting from electricity meters switched off or malfunctioning or tampered electricity meter).

With reference to different users, if the values of the sequences of values of power absorbed by a respective users are different from zero and the columns of the matrix X referred to the sequences of values of power absorbed by a respective user are linearly independent, said pseudo inverse matrix of Moore-Penrose coincides with an inverse matrix since the matrix X is a full rank matrix.

With reference to the column vector $\theta$, said column vector is constituted by the parameters $\theta_0$, $\theta_1 ... \theta_N$ obtained according to the method of least squares, which solve said linear equation in matrix form.

Each parameter $\theta_0, \theta_1 ... \theta_N$ of said column vector is dimensionless.

With particular reference to step M4) said predetermined third threshold is chosen according to the unit of measurement that is used for the powers absorbed by each user and the sequences of values of power absorbed by each user.

For example, the absorbed powers can be expressed in KW and accordingly said predetermined third threshold is expressed in kW.

As said in step M4), said third threshold is selected such a way that if multiplied by a constant value $\alpha$ gives a predetermined average value of power absorbed per time unit above which at least one illegal connection to the power line is to be searched. Such a predetermined average value of absorbed power can be chosen by the entity responsible for the supply of electrical energy.

For example, with reference to a specific power line, the entity responsible for the supply of electrical energy may wish to search an average value of power absorbed per time unit equal to 300KW, index of an illegal connection to the power line itself. Consequently, the predetermined third constant multiplied by the constant value $\alpha$ must have as a result 300KW.

Finally, the method provides a comparison between the first parameter of said column vector $\theta$ and the third predetermined threshold, so that if said first parameter $\theta_0$ is greater than or equal to said third predetermined threshold the presence of at least one illegal connection to the power line is reported to an entity responsible for the supply of electricity.

In the method above described, the following values are values of derivatives of zero order:

- the values of the sequence of values of power absorbed $(f_i)_k$ by each user (step C),
- the mean value $\overline{f_i}$ and the standard deviation $\sigma_i$ of each sequence of values of power absorbed $(f_i)_k$ by each user (step D),
- the values of said sequence of difference values $(D)_k$ (step E),
- the mean value $\overline{D}$ and the standard deviation $\sigma_D$ of said sequence of difference values $(D)_k$ (step F).

Consequently, the statistical correlation coefficient $\rho_i$, mentioned in the step L1), is the result of the ratio between values of derivates of zero order.

However, although not described, in order to determine electrical losses due to a malfunctioning or tampering of an electricity meter, for example due to the positioning of a magnet on an electricity meter, the value quoted in the list mentioned above may be values of derivatives of higher order, without for this reason departing from the scope of protection of the invention.

In the case of derivatives of higher order it is preferable that said values are the values of derivatives of first order. In this way, with particular reference to the step L1) relating to the calculation of the statistical correlation coefficient, it is possible to obtain the correlation between the variation of electric losses, given by the derivative of first order of the sequence of difference values $(D)_k$, and the variations of power absorbed by the users $U_1, U_2 ... U_N$, given from the derivatives of first order of the sequences of absorbed power $(f_i)_k$.

Advantageously, the statistical correlation coefficient obtained using values of derivative of a first-order allows the electrical losses of a power line due to the Joule effect to be less important than the electrical losses of the same power line, when the statistical correlation coefficient is obtained using the values of derivates of zero order.

**Example of method**

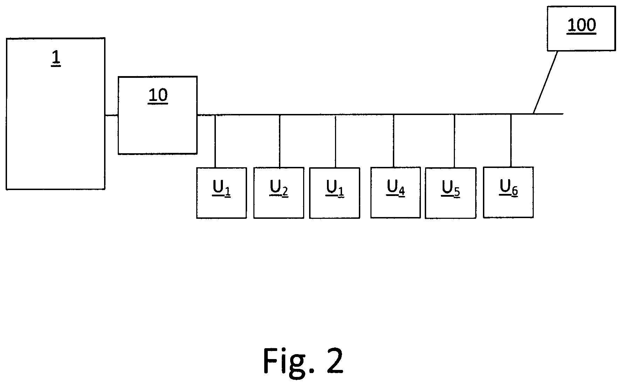

With reference to Figure 2, an example of application of the method above described is shown with reference to a power line 100 to which a number N of users equal to six, i.e. $U_1$, $U_2$, $U_3$, $U_4$, $U_5$, $U_6$, are connected.

A power meter 10 is positioned between a transformer room 1 that supplies electrical energy to said power line 100, to which said users are connected.

The predetermined time period is of 14 consecutive days and the predetermined time unit is of 15 minutes.

The power meter 10 acquires in said predetermined period time the average value of power supplied from said transformer room 1 in every predetermined time unit.

The average values can be stored on a database or recorded in a format that allows such data to be reused.

During the same days, in the same predetermined time units the average values of the power absorbed by each user are recorded, where such power is measured by the electricity meter associated with a respective user $U_1$, $U_2$, $U_3$, $U_4$, $U_5$, $U_6$.

The average values of power absorbed by each user are stored in a database or recorded in a format that allows such data to be reused.

As mentioned above, by selecting a predetermined time period of 14 consecutive days and a predetermined time unit of 15 minutes, the index k corresponding to the predetermined time unit ranges from 1 to 1344. This is due to the fact that 96 time units of 15-minute are present in a day and the result of the multiplication of 96 time units for 14 days is equal to 1344.

With reference to steps A), C) and E), in order not to complicate the reading, the table below contains all the data used to replicate the method described above.

## Table

1

| Power measured by power meter (s) | α | User 1 (f₁) | User 2 (f₂) | User 3 (f₃) | User 4 (f₄) | User 5 (f₅) | User 6 (f₆) | Difference (D) |
|---|---|---|---|---|---|---|---|---|
| 1898,23 | 1,00 | 134,40 | 308,00 | 228,00 | 275,20 | 144,00 | 0 | 808,63 |
| 2227,50 | 1,00 | 247,20 | 312,00 | 164,00 | 236,80 | 180,00 | 0 | 1087,50 |
| 2379,42 | 1,00 | 256,80 | 312,00 | 356,00 | 131,20 | 180,00 | 0 | 1143,42 |
| 1963,91 | 1,00 | 180,00 | 312,00 | 196,00 | 134,40 | 180,00 | 0 | 961,51 |
| 2078,60 | 1,00 | 205,20 | 312,00 | 228,00 | 163,20 | 136,00 | 0 | 1034,20 |
| 2150,05 | 1,00 | 214,80 | 316,00 | 248,00 | 214,40 | 132,00 | 0 | 1024,85 |
| 1895,52 | 1,00 | 144,00 | 312,00 | 268,00 | 208,00 | 128,00 | 0 | 835,52 |
| 1689,86 | 1,00 | 80,40 | 316,00 | 252,00 | 208,00 | 128,00 | 0 | 705,46 |
| 1334,73 | 1,00 | 44,40 | 324,00 | 120,00 | 172,80 | 92,00 | 0 | 581,53 |
| 1816,45 | 1,00 | 157,20 | 308,00 | 340,00 | 67,20 | 128,00 | 0 | 816,05 |
| 1541,69 | 1,00 | 141,60 | 312,00 | 216,00 | 51,20 | 124,00 | 0 | 696,89 |
| 1511,79 | 1,00 | 140,40 | 308,00 | 208,00 | 51,20 | 120,00 | 0 | 684,19 |
| 1726,36 | 1,00 | 142,80 | 308,00 | 220,00 | 137,60 | 96,00 | 0 | 821,96 |
| 1760,65 | 1,00 | 114,00 | 312,00 | 264,00 | 172,80 | 124,00 | 0 | 773,85 |
| 1474,42 | 1,00 | 62,40 | 308,00 | 256,00 | 166,40 | 128,00 | 0 | 553,62 |
| 1396,96 | 1,00 | 90,00 | 312,00 | 116,00 | 163,20 | 116,00 | 0 | 599,76 |
| 1537,75 | 1,00 | 68,40 | 308,00 | 328,00 | 147,20 | 96,00 | 0 | 590,15 |
| 1298,90 | 1,00 | 51,60 | 328,00 | 220,00 | 51,20 | 128,00 | 0 | 520,10 |
| 1629,48 | 1,00 | 142,80 | 352,00 | 212,00 | 51,20 | 124,00 | 0 | 747,48 |
| 1328,27 | 1,00 | 87,60 | 352,00 | 184,00 | 51,20 | 116,00 | 0 | 537,47 |
| 1688,41 | 1,00 | 88,80 | 388,00 | 372,00 | 144,00 | 104,00 | 0 | 591,61 |
| 1891,71 | 1,00 | 110,40 | 348,00 | 404,00 | 169,60 | 124,00 | 0 | 735,71 |
| 1618,67 | 1,00 | 105,60 | 308,00 | 200,00 | 163,20 | 128,00 | 0 | 713,87 |
| 1369,72 | 1,00 | 18,00 | 308,00 | 312,00 | 163,20 | 136,00 | 0 | 432,52 |
| 1198,82 | 1,00 | 52,80 | 172,00 | 256,00 | 70,40 | 176,00 | 0 | 471,62 |
| 1308,48 | 1,00 | 76,80 | 192,00 | 200,00 | 51,20 | 216,00 | 0 | 572,48 |
| 1568,98 | 1,00 | 93,60 | 172,00 | 376,00 | 48,00 | 224,00 | 0 | 655,38 |
| 1654,89 | 1,00 | 86,40 | 140,00 | 472,00 | 99,20 | 264,00 | 0 | 593,29 |
| 1687,47 | 1,00 | 151,20 | 124,00 | 316,00 | 169,60 | 168,00 | 0 | 758,67 |
| 1568,77 | 1,00 | 141,60 | 140,00 | 208,00 | 166,40 | 184,00 | 0 | 728,77 |
| 2112,94 | 1,00 | 181,20 | 300,00 | 392,00 | 163,20 | 176,00 | 0 | 900,54 |
| 1777,84 | 1,00 | 147,60 | 276,00 | 340,00 | 112,00 | 148,00 | 0 | 754,24 |
| 1473,29 | 1,00 | 39,60 | 232,00 | 332,00 | 172,80 | 272,00 | 0 | 424,89 |
| 1210,39 | 1,00 | 33,60 | 236,00 | 400,00 | 96,00 | 164,00 | 0 | 280,79 |
| 1697,12 | 1,00 | 92,40 | 220,00 | 472,00 | 176,00 | 168,00 | 0 | 568,72 |
| 1475,09 | 1,00 | 112,80 | 208,00 | 284,00 | 163,20 | 124,00 | 0 | 583,09 |
| 1259,37 | 1,00 | 66,00 | 212,00 | 304,00 | 163,20 | 136,00 | 0 | 378,17 |

| | | | | | | | | |
|---|---|---|---|---|---|---|---|---|
| 1145,78 | 1,00 | 52,80 | 196,00 | 304,00 | 115,20 | 160,00 | 0 | 317,78 |
| 1363,44 | 1,00 | 126,00 | 192,00 | 280,00 | 51,20 | 168,00 | 0 | 546,24 |
| 1386,57 | 1,00 | 105,60 | 240,00 | 324,00 | 51,20 | 136,00 | 0 | 529,77 |
| 1124,65 | 1,00 | 40,80 | 272,00 | 296,00 | 51,20 | 164,00 | 0 | 300,65 |
| 1220,74 | 1,00 | 64,80 | 228,00 | 228,00 | 169,60 | 164,00 | 0 | 366,34 |
| 1314,47 | 1,00 | 48,00 | 128,00 | 400,00 | 169,60 | 168,00 | 0 | 400,87 |
| 1461,67 | 1,00 | 123,60 | 188,00 | 232,00 | 166,40 | 140,00 | 0 | 611,67 |
| 2433,22 | 1,00 | 122,40 | 152,00 | 1196,00 | 156,80 | 156,00 | 0 | 650,02 |
| 3217,63 | 1,00 | 88,80 | 200,00 | 2120,00 | 51,20 | 164,00 | 0 | 593,63 |
| 1228,61 | 1,00 | 52,80 | 268,00 | 236,00 | 51,20 | 144,00 | 0 | 476,61 |
| 1254,68 | 1,00 | 106,80 | 244,00 | 264,00 | 51,20 | 104,00 | 0 | 484,68 |
| 1630,05 | 1,00 | 202,80 | 240,00 | 224,00 | 124,80 | 96,00 | 0 | 742,45 |
| 2045,59 | 1,00 | 194,40 | 236,00 | 384,00 | 169,60 | 116,00 | 0 | 945,59 |
| 1905,21 | 1,00 | 147,60 | 164,00 | 316,00 | 166,40 | 120,00 | 0 | 991,21 |
| 2574,25 | 1,00 | 165,60 | 4,00 | 184,00 | 163,20 | 112,00 | 0 | 1945,45 |
| 2145,74 | 1,00 | 152,40 | 8,00 | 384,00 | 89,60 | 88,00 | 0 | 1423,74 |
| 1678,57 | 1,00 | 198,00 | 100,00 | 380,00 | 51,20 | 116,00 | 0 | 833,37 |
| 1468,15 | 1,00 | 163,20 | 96,00 | 308,00 | 51,20 | 116,00 | 0 | 733,75 |
| 1707,12 | 1,00 | 141,60 | 204,00 | 364,00 | 70,40 | 116,00 | 0 | 811,12 |
| 1723,92 | 1,00 | 100,80 | 292,00 | 252,00 | 179,20 | 100,00 | 0 | 799,92 |
| 1825,78 | 1,00 | 117,60 | 280,00 | 328,00 | 166,40 | 100,00 | 0 | 833,78 |
| 1950,98 | 1,00 | 184,80 | 280,00 | 176,00 | 166,40 | 120,00 | 0 | 1023,78 |
| 1766,17 | 1,00 | 175,20 | 276,00 | 200,00 | 140,80 | 116,00 | 0 | 858,17 |
| 1749,63 | 1,00 | 172,80 | 312,00 | 332,00 | 54,40 | 108,00 | 0 | 770,43 |
| 1889,22 | 1,00 | 255,60 | 272,00 | 228,00 | 51,20 | 96,00 | 0 | 986,42 |
| 2055,69 | 1,00 | 216,00 | 300,00 | 380,00 | 51,20 | 120,00 | 0 | 988,49 |
| 1970,16 | 1,00 | 196,80 | 300,00 | 276,00 | 134,40 | 120,00 | 0 | 942,96 |
| 1977,70 | 1,00 | 195,60 | 268,00 | 260,00 | 172,80 | 116,00 | 0 | 965,30 |
| 1808,32 | 1,00 | 190,80 | 264,00 | 260,00 | 163,20 | 92,00 | 0 | 838,32 |
| 1750,33 | 1,00 | 206,40 | 236,00 | 120,00 | 163,20 | 144,00 | 0 | 880,73 |
| 2050,83 | 1,00 | 225,60 | 232,00 | 324,00 | 112,00 | 164,00 | 0 | 993,23 |
| 2084,66 | 1,00 | 278,40 | 244,00 | 236,00 | 51,20 | 160,00 | 0 | 1115,06 |
| 1576,78 | 1,00 | 156,00 | 288,00 | 192,00 | 51,20 | 156,00 | 0 | 733,58 |
| 1349,63 | 1,00 | 126,00 | 168,00 | 220,00 | 51,20 | 148,00 | 0 | 636,43 |
| 1536,26 | 1,00 | 91,20 | 244,00 | 248,00 | 166,40 | 164,00 | 0 | 622,66 |
| 1706,51 | 1,00 | 121,20 | 256,00 | 284,00 | 169,60 | 160,00 | 0 | 715,71 |
| 2020,97 | 1,00 | 243,60 | 252,00 | 112,00 | 163,20 | 164,00 | 0 | 1086,17 |
| 2636,77 | 1,00 | 177,60 | 256,00 | 300,00 | 172,80 | 140,00 | 0 | 1590,37 |
| 2923,76 | 1,00 | 217,20 | 252,00 | 360,00 | 179,20 | 184,00 | 0 | 1731,36 |
| 3069,85 | 1,00 | 301,20 | 252,00 | 276,00 | 115,20 | 216,00 | 0 | 1909,45 |
| 4549,12 | 1,00 | 758,40 | 264,00 | 392,00 | 121,60 | 160,00 | 0 | 2853,12 |
| 4627,39 | 1,00 | 900,00 | 292,00 | 500,00 | 102,40 | 140,00 | 0 | 2692,99 |
| 4826,17 | 1,00 | 682,80 | 324,00 | 464,00 | 230,40 | 152,00 | 0 | 2972,97 |
| 5053,53 | 1,00 | 691,20 | 304,00 | 500,00 | 275,20 | 168,00 | 0 | 3115,13 |

| | | | | | | | | |
|---|---|---|---|---|---|---|---|---|
| 4119,97 | 1,00 | 345,60 | 292,00 | 472,00 | 419,20 | 164,00 | 0 | 2427,17 |
| 4842,86 | 1,00 | 345,60 | 292,00 | 416,00 | 438,40 | 140,00 | 0 | 3210,86 |
| 4091,31 | 1,00 | 716,00 | 316,00 | 328,00 | 544,00 | 152,00 | 0 | 2035,31 |
| 4509,84 | 1,00 | 764,00 | 380,00 | 616,00 | 1296,00 | 160,00 | 0 | 1293,84 |
| 2997,71 | 1,00 | 556,00 | 460,00 | 684,00 | 596,00 | 124,00 | 0 | 577,71 |
| 2936,59 | 1,00 | 808,00 | 520,00 | 664,00 | 252,00 | 96,00 | 0 | 596,59 |
| 3259,98 | 1,00 | 1220,00 | 532,00 | 636,00 | 200,00 | 120,00 | 0 | 551,98 |
| 3567,90 | 1,00 | 1464,00 | 496,00 | 632,00 | 316,00 | 124,00 | 0 | 535,90 |
| 3692,52 | 1,00 | 1468,00 | 472,00 | 624,00 | 388,00 | 124,00 | 0 | 616,52 |
| 3619,99 | 1,00 | 1444,00 | 472,00 | 624,00 | 392,00 | 96,00 | 0 | 591,99 |
| 3270,18 | 1,00 | 1168,00 | 464,00 | 524,00 | 396,00 | 168,00 | 0 | 550,18 |
| 3105,23 | 1,00 | 1128,00 | 444,00 | 512,00 | 372,00 | 172,00 | 0 | 477,23 |
| 4542,54 | 1,00 | 956,00 | 384,00 | 2112,00 | 320,00 | 148,00 | 0 | 622,54 |
| 2578,60 | 1,00 | 452,00 | 336,00 | 956,00 | 228,00 | 104,00 | 0 | 502,60 |
| 4389,80 | 1,00 | 508,00 | 328,00 | 2560,00 | 232,00 | 132,00 | 0 | 629,80 |
| 1899,23 | 1,00 | 448,00 | 308,00 | 228,00 | 344,00 | 144,00 | 0 | 427,23 |
| 2222,30 | 1,00 | 824,00 | 312,00 | 164,00 | 294,00 | 180,00 | 0 | 448,30 |
| 2378,42 | 1,00 | 856,00 | 312,00 | 356,00 | 164,00 | 180,00 | 0 | 510,42 |
| 1963,91 | 1,00 | 600,00 | 312,00 | 196,00 | 168,00 | 180,00 | 0 | 507,91 |
| 2080,79 | 1,00 | 684,00 | 314,00 | 228,00 | 204,00 | 136,00 | 0 | 514,79 |
| 2161,99 | 1,00 | 716,00 | 316,00 | 258,00 | 268,00 | 132,00 | 0 | 471,99 |
| 1895,52 | 1,00 | 480,00 | 312,00 | 268,00 | 260,00 | 128,00 | 0 | 447,52 |
| 1690,86 | 1,00 | 268,00 | 316,00 | 252,00 | 260,00 | 128,00 | 0 | 466,86 |
| 1335,73 | 1,00 | 148,00 | 324,00 | 120,00 | 216,00 | 92,00 | 0 | 435,73 |
| 1816,45 | 1,00 | 524,00 | 308,00 | 340,00 | 84,00 | 128,00 | 0 | 432,45 |
| 1540,31 | 1,00 | 472,00 | 308,00 | 216,00 | 64,00 | 124,00 | 0 | 356,31 |
| 1510,79 | 1,00 | 468,00 | 308,00 | 208,00 | 64,00 | 120,00 | 0 | 342,79 |
| 1726,36 | 1,00 | 476,00 | 308,00 | 220,00 | 172,00 | 96,00 | 0 | 454,36 |
| 1864,94 | 1,00 | 476,00 | 312,00 | 264,00 | 216,00 | 124,00 | 0 | 472,94 |
| 1473,42 | 1,00 | 208,00 | 308,00 | 256,00 | 208,00 | 128,00 | 0 | 365,42 |
| 1393,77 | 1,00 | 300,00 | 312,00 | 114,00 | 204,00 | 116,00 | 0 | 347,77 |
| 1560,62 | 1,00 | 228,00 | 308,00 | 328,00 | 184,00 | 116,00 | 0 | 396,62 |
| 1633,34 | 1,00 | 476,00 | 328,00 | 220,00 | 64,00 | 128,00 | 0 | 417,34 |
| 1618,74 | 1,00 | 476,00 | 352,00 | 212,00 | 64,00 | 116,00 | 0 | 398,74 |
| 1329,27 | 1,00 | 292,00 | 352,00 | 184,00 | 64,00 | 116,00 | 0 | 321,27 |
| 1689,41 | 1,00 | 296,00 | 388,00 | 372,00 | 180,00 | 104,00 | 0 | 349,41 |
| 1818,11 | 1,00 | 296,00 | 348,00 | 404,00 | 212,00 | 128,00 | 0 | 430,11 |
| 1613,30 | 1,00 | 352,00 | 308,00 | 200,00 | 204,00 | 124,00 | 0 | 425,30 |
| 1373,72 | 1,00 | 60,00 | 308,00 | 312,00 | 204,00 | 136,00 | 0 | 353,72 |
| 1242,55 | 1,00 | 176,00 | 172,00 | 257,00 | 88,00 | 215,00 | 0 | 334,55 |
| 1308,48 | 1,00 | 256,00 | 192,00 | 200,00 | 64,00 | 216,00 | 0 | 380,48 |
| 1569,98 | 1,00 | 312,00 | 172,00 | 376,00 | 60,00 | 224,00 | 0 | 425,98 |
| 1656,89 | 1,00 | 288,00 | 140,00 | 472,00 | 124,00 | 264,00 | 0 | 368,89 |
| 1707,99 | 1,00 | 504,00 | 140,00 | 316,00 | 212,00 | 168,00 | 0 | 367,99 |

| | | | | | | | | |
|---|---|---|---|---|---|---|---|---|
| 1565,77 | 1,00 | 472,00 | 140,00 | 208,00 | 208,00 | 184,00 | 0 | 353,77 |
| 2115,94 | 1,00 | 604,00 | 300,00 | 392,00 | 204,00 | 176,00 | 0 | 439,94 |
| 1911,41 | 1,00 | 492,00 | 276,00 | 340,00 | 140,00 | 272,00 | 0 | 391,41 |
| 1477,39 | 1,00 | 133,00 | 232,00 | 332,00 | 216,00 | 272,00 | 0 | 292,39 |
| 1219,39 | 1,00 | 112,00 | 236,00 | 400,00 | 120,00 | 164,00 | 0 | 187,39 |
| 1647,01 | 1,00 | 308,00 | 220,00 | 472,00 | 220,00 | 124,00 | 0 | 303,01 |
| 1479,09 | 1,00 | 376,00 | 208,00 | 284,00 | 204,00 | 124,00 | 0 | 283,09 |
| 1262,37 | 1,00 | 220,00 | 212,00 | 304,00 | 204,00 | 136,00 | 0 | 186,37 |
| 1076,71 | 1,00 | 176,00 | 196,00 | 304,00 | 64,00 | 160,00 | 0 | 176,71 |
| 1355,44 | 1,00 | 420,00 | 192,00 | 280,00 | 64,00 | 168,00 | 0 | 231,44 |
| 1393,57 | 1,00 | 351,00 | 240,00 | 324,00 | 65,00 | 136,00 | 0 | 277,57 |
| 1125,65 | 1,00 | 136,00 | 272,00 | 296,00 | 64,00 | 164,00 | 0 | 193,65 |
| 1221,74 | 1,00 | 216,00 | 228,00 | 228,00 | 212,00 | 164,00 | 0 | 173,74 |
| 1316,38 | 1,00 | 160,00 | 128,00 | 400,00 | 212,00 | 167,00 | 0 | 249,38 |
| 1467,05 | 1,00 | 412,00 | 192,00 | 232,00 | 208,00 | 140,00 | 0 | 283,05 |
| 2422,72 | 1,00 | 408,00 | 152,00 | 1196,00 | 196,00 | 140,00 | 0 | 330,72 |
| 3219,63 | 1,00 | 296,00 | 200,00 | 2120,00 | 64,00 | 164,00 | 0 | 375,63 |
| 1246,48 | 1,00 | 176,00 | 268,00 | 236,00 | 64,00 | 164,00 | 0 | 338,48 |
| 1250,68 | 1,00 | 356,00 | 244,00 | 264,00 | 64,00 | 104,00 | 0 | 218,68 |
| 1639,05 | 1,00 | 676,00 | 240,00 | 224,00 | 156,00 | 96,00 | 0 | 247,05 |
| 1972,17 | 1,00 | 648,00 | 236,00 | 316,00 | 212,00 | 116,00 | 0 | 444,17 |
| 1903,21 | 1,00 | 492,00 | 164,00 | 316,00 | 208,00 | 120,00 | 0 | 603,21 |
| 2587,25 | 1,00 | 552,00 | 4,00 | 184,00 | 204,00 | 112,00 | 0 | 1531,25 |
| 2162,74 | 1,00 | 508,00 | 8,00 | 384,00 | 112,00 | 88,00 | 0 | 1062,74 |
| 1675,57 | 1,00 | 660,00 | 100,00 | 380,00 | 64,00 | 116,00 | 0 | 355,57 |
| 1470,15 | 1,00 | 544,00 | 96,00 | 308,00 | 64,00 | 116,00 | 0 | 342,15 |
| 1707,12 | 1,00 | 472,00 | 204,00 | 364,00 | 88,00 | 116,00 | 0 | 463,12 |
| 1723,92 | 1,00 | 336,00 | 292,00 | 252,00 | 224,00 | 100,00 | 0 | 519,92 |
| 1825,78 | 1,00 | 392,00 | 280,00 | 328,00 | 208,00 | 100,00 | 0 | 517,78 |
| 1951,98 | 1,00 | 616,00 | 280,00 | 176,00 | 208,00 | 120,00 | 0 | 551,98 |
| 1765,07 | 1,00 | 584,00 | 276,00 | 199,00 | 176,00 | 116,00 | 0 | 414,07 |
| 1745,63 | 1,00 | 576,00 | 312,00 | 332,00 | 68,00 | 108,00 | 0 | 349,63 |
| 1885,22 | 1,00 | 852,00 | 272,00 | 228,00 | 64,00 | 96,00 | 0 | 373,22 |
| 2056,69 | 1,00 | 720,00 | 300,00 | 380,00 | 64,00 | 120,00 | 0 | 472,69 |
| 1972,16 | 1,00 | 656,00 | 300,00 | 276,00 | 168,00 | 120,00 | 0 | 452,16 |
| 1976,70 | 1,00 | 652,00 | 268,00 | 260,00 | 216,00 | 116,00 | 0 | 464,70 |
| 1807,32 | 1,00 | 636,00 | 264,00 | 260,00 | 204,00 | 92,00 | 0 | 351,32 |
| 1777,89 | 1,00 | 688,00 | 264,00 | 120,00 | 204,00 | 143,00 | 0 | 358,89 |
| 2065,97 | 1,00 | 752,00 | 244,00 | 324,00 | 140,00 | 164,00 | 0 | 441,97 |
| 2035,50 | 1,00 | 928,00 | 244,00 | 192,00 | 64,00 | 160,00 | 0 | 447,50 |
| 1579,78 | 1,00 | 520,00 | 288,00 | 192,00 | 64,00 | 156,00 | 0 | 359,78 |
| 1345,63 | 1,00 | 420,00 | 168,00 | 220,00 | 64,00 | 148,00 | 0 | 325,63 |
| 1540,26 | 1,00 | 304,00 | 244,00 | 248,00 | 208,00 | 164,00 | 0 | 372,26 |
| 1710,51 | 1,00 | 404,00 | 256,00 | 284,00 | 212,00 | 160,00 | 0 | 394,51 |

| | | | | | | | | |
|---|---|---|---|---|---|---|---|---|
| 2021,97 | 1,00 | 812,00 | 252,00 | 112,00 | 204,00 | 164,00 | 0 | 477,97 |
| 2628,77 | 1,00 | 592,00 | 256,00 | 300,00 | 216,00 | 140,00 | 0 | 1124,77 |
| 2910,76 | 1,00 | 724,00 | 252,00 | 360,00 | 224,00 | 184,00 | 0 | 1166,76 |
| 3031,87 | 1,00 | 1004,00 | 252,00 | 276,00 | 144,00 | 184,00 | 0 | 1171,87 |
| 4557,12 | 1,00 | 2528,00 | 264,00 | 392,00 | 152,00 | 160,00 | 0 | 1061,12 |
| 4634,51 | 1,00 | 3000,00 | 292,00 | 500,00 | 128,00 | 152,00 | 0 | 562,51 |
| 4828,17 | 1,00 | 2276,00 | 324,00 | 464,00 | 288,00 | 152,00 | 0 | 1324,17 |
| 5064,53 | 1,00 | 2304,00 | 304,00 | 500,00 | 344,00 | 168,00 | 0 | 1444,53 |
| 4089,07 | 1,00 | 1152,00 | 292,00 | 472,00 | 525,00 | 164,00 | 0 | 1484,07 |
| 4790,86 | 1,00 | 1152,00 | 292,00 | 416,00 | 548,00 | 140,00 | 0 | 2242,86 |
| 4047,31 | 1,00 | 716,00 | 316,00 | 328,00 | 544,00 | 152,00 | 0 | 1991,31 |
| 4518,84 | 1,00 | 764,00 | 380,00 | 616,00 | 1296,00 | 160,00 | 0 | 1302,84 |
| 2997,71 | 1,00 | 556,00 | 460,00 | 684,00 | 596,00 | 124,00 | 0 | 577,71 |
| 2936,59 | 1,00 | 808,00 | 520,00 | 664,00 | 252,00 | 96,00 | 0 | 596,59 |
| 3258,98 | 1,00 | 1220,00 | 532,00 | 636,00 | 200,00 | 120,00 | 0 | 550,98 |
| 3567,90 | 1,00 | 1464,00 | 496,00 | 632,00 | 316,00 | 124,00 | 0 | 535,90 |
| 3690,13 | 1,00 | 1464,00 | 472,00 | 624,00 | 388,00 | 124,00 | 0 | 618,13 |
| 3618,89 | 1,00 | 1443,00 | 472,00 | 624,00 | 392,00 | 96,00 | 0 | 591,89 |
| 3265,78 | 1,00 | 1168,00 | 464,00 | 524,00 | 392,00 | 168,00 | 0 | 549,78 |
| 3108,13 | 1,00 | 1127,00 | 444,00 | 512,00 | 372,00 | 172,00 | 0 | 481,13 |
| 2790,50 | 1,00 | 956,00 | 384,00 | 513,00 | 320,00 | 148,00 | 0 | 469,50 |
| 2726,68 | 1,00 | 587,00 | 336,00 | 956,00 | 228,00 | 104,00 | 0 | 515,68 |
| 4268,32 | 1,00 | 508,00 | 328,00 | 2449,00 | 232,00 | 132,00 | 0 | 619,32 |
| 1899,23 | 1,00 | 448,00 | 308,00 | 228,00 | 344,00 | 144,00 | 0 | 427,23 |
| 2221,30 | 1,00 | 824,00 | 312,00 | 164,00 | 294,00 | 180,00 | 0 | 447,30 |
| 2390,47 | 1,00 | 856,00 | 312,00 | 356,00 | 168,00 | 187,00 | 0 | 511,47 |
| 1963,91 | 1,00 | 600,00 | 312,00 | 196,00 | 168,00 | 180,00 | 0 | 507,91 |
| 2080,79 | 1,00 | 684,00 | 314,00 | 228,00 | 204,00 | 136,00 | 0 | 514,79 |
| 2161,99 | 1,00 | 716,00 | 316,00 | 258,00 | 268,00 | 132,00 | 0 | 471,99 |
| 1894,52 | 1,00 | 480,00 | 312,00 | 268,00 | 260,00 | 128,00 | 0 | 446,52 |
| 1689,86 | 1,00 | 268,00 | 316,00 | 252,00 | 260,00 | 128,00 | 0 | 465,86 |
| 1337,82 | 1,00 | 148,00 | 324,00 | 121,00 | 216,00 | 92,00 | 0 | 436,82 |
| 1816,45 | 1,00 | 524,00 | 308,00 | 340,00 | 84,00 | 128,00 | 0 | 432,45 |
| 1535,94 | 1,00 | 472,00 | 308,00 | 216,00 | 64,00 | 120,00 | 0 | 355,94 |
| 1505,49 | 1,00 | 468,00 | 308,00 | 208,00 | 61,00 | 120,00 | 0 | 340,49 |
| 1727,36 | 1,00 | 476,00 | 308,00 | 220,00 | 172,00 | 96,00 | 0 | 455,36 |
| 1852,56 | 1,00 | 476,00 | 308,00 | 264,00 | 216,00 | 124,00 | 0 | 464,56 |
| 1472,42 | 1,00 | 208,00 | 308,00 | 256,00 | 208,00 | 128,00 | 0 | 364,42 |
| 1395,18 | 1,00 | 300,00 | 312,00 | 114,00 | 208,00 | 116,00 | 0 | 345,18 |
| 1521,62 | 1,00 | 228,00 | 308,00 | 328,00 | 184,00 | 116,00 | 0 | 357,62 |
| 1752,54 | 1,00 | 476,00 | 328,00 | 328,00 | 64,00 | 128,00 | 0 | 428,54 |
| 1415,92 | 1,00 | 292,00 | 352,00 | 212,00 | 64,00 | 116,00 | 0 | 379,92 |
| 1331,37 | 1,00 | 292,00 | 352,00 | 184,00 | 65,00 | 116,00 | 0 | 322,37 |
| 1693,41 | 1,00 | 296,00 | 388,00 | 372,00 | 180,00 | 104,00 | 0 | 353,41 |

| | | | | | | | | |
|---|---|---|---|---|---|---|---|---|
| 1818,11 | 1,00 | 296,00 | 348,00 | 404,00 | 212,00 | 128,00 | 0 | 430,11 |
| 1614,30 | 1,00 | 352,00 | 308,00 | 200,00 | 204,00 | 124,00 | 0 | 426,30 |
| 1374,72 | 1,00 | 60,00 | 308,00 | 312,00 | 204,00 | 136,00 | 0 | 354,72 |
| 1238,93 | 1,00 | 256,00 | 172,00 | 257,00 | 88,00 | 136,00 | 0 | 329,93 |
| 1306,29 | 1,00 | 256,00 | 190,00 | 200,00 | 64,00 | 216,00 | 0 | 380,29 |
| 1568,88 | 1,00 | 311,00 | 172,00 | 376,00 | 60,00 | 224,00 | 0 | 425,88 |
| 1659,18 | 1,00 | 290,00 | 140,00 | 472,00 | 125,00 | 264,00 | 0 | 368,18 |
| 1705,99 | 1,00 | 504,00 | 140,00 | 316,00 | 212,00 | 168,00 | 0 | 365,99 |
| 1565,77 | 1,00 | 472,00 | 140,00 | 208,00 | 208,00 | 184,00 | 0 | 353,77 |
| 2115,94 | 1,00 | 604,00 | 300,00 | 392,00 | 204,00 | 176,00 | 0 | 439,94 |
| 1915,50 | 1,00 | 492,00 | 276,00 | 340,00 | 140,00 | 273,00 | 0 | 394,50 |
| 1480,39 | 1,00 | 133,00 | 232,00 | 332,00 | 216,00 | 272,00 | 0 | 295,39 |
| 1223,39 | 1,00 | 112,00 | 236,00 | 400,00 | 120,00 | 164,00 | 0 | 191,39 |
| 1650,11 | 1,00 | 308,00 | 221,00 | 472,00 | 220,00 | 124,00 | 0 | 305,11 |
| 1491,13 | 1,00 | 376,00 | 208,00 | 295,00 | 204,00 | 124,00 | 0 | 284,13 |
| 1252,37 | 1,00 | 220,00 | 212,00 | 304,00 | 204,00 | 136,00 | 0 | 176,37 |
| 1086,71 | 1,00 | 176,00 | 196,00 | 304,00 | 64,00 | 160,00 | 0 | 186,71 |
| 1384,71 | 1,00 | 420,00 | 192,00 | 304,00 | 64,00 | 168,00 | 0 | 236,71 |
| 1389,57 | 1,00 | 351,00 | 240,00 | 324,00 | 65,00 | 136,00 | 0 | 273,57 |
| 1127,65 | 1,00 | 136,00 | 272,00 | 296,00 | 64,00 | 164,00 | 0 | 195,65 |
| 1212,65 | 1,00 | 216,00 | 228,00 | 228,00 | 212,00 | 163,00 | 0 | 165,65 |
| 1319,38 | 1,00 | 160,00 | 128,00 | 400,00 | 212,00 | 167,00 | 0 | 252,38 |
| 1467,05 | 1,00 | 412,00 | 192,00 | 232,00 | 208,00 | 140,00 | 0 | 283,05 |
| 2344,33 | 1,00 | 341,00 | 152,00 | 1197,00 | 196,00 | 140,00 | 0 | 318,33 |
| 3218,53 | 1,00 | 296,00 | 200,00 | 2119,00 | 64,00 | 164,00 | 0 | 375,53 |
| 1374,10 | 1,00 | 296,00 | 268,00 | 236,00 | 64,00 | 164,00 | 0 | 346,10 |
| 1259,68 | 1,00 | 356,00 | 244,00 | 264,00 | 64,00 | 104,00 | 0 | 227,68 |
| 1642,52 | 1,00 | 676,00 | 240,00 | 229,00 | 156,00 | 96,00 | 0 | 245,52 |
| 1974,17 | 1,00 | 648,00 | 236,00 | 316,00 | 212,00 | 116,00 | 0 | 446,17 |
| 1900,81 | 1,00 | 492,00 | 164,00 | 316,00 | 204,00 | 120,00 | 0 | 604,81 |
| 2563,25 | 1,00 | 552,00 | 4,00 | 184,00 | 204,00 | 112,00 | 0 | 1507,25 |
| 2148,74 | 1,00 | 508,00 | 8,00 | 384,00 | 112,00 | 88,00 | 0 | 1048,74 |
| 1641,95 | 1,00 | 660,00 | 100,00 | 380,00 | 64,00 | 88,00 | 0 | 349,95 |
| 1468,15 | 1,00 | 544,00 | 96,00 | 308,00 | 64,00 | 116,00 | 0 | 340,15 |
| 1708,12 | 1,00 | 472,00 | 204,00 | 364,00 | 88,00 | 116,00 | 0 | 464,12 |
| 1722,92 | 1,00 | 336,00 | 292,00 | 252,00 | 224,00 | 100,00 | 0 | 518,92 |
| 1764,35 | 1,00 | 336,00 | 280,00 | 328,00 | 208,00 | 100,00 | 0 | 512,35 |
| 1953,98 | 1,00 | 616,00 | 280,00 | 176,00 | 208,00 | 120,00 | 0 | 553,98 |
| 1767,07 | 1,00 | 584,00 | 276,00 | 199,00 | 176,00 | 116,00 | 0 | 416,07 |
| 1740,63 | 1,00 | 576,00 | 312,00 | 332,00 | 68,00 | 108,00 | 0 | 344,63 |
| 1888,42 | 1,00 | 852,00 | 272,00 | 228,00 | 66,00 | 96,00 | 0 | 374,42 |
| 2058,69 | 1,00 | 720,00 | 300,00 | 380,00 | 64,00 | 120,00 | 0 | 474,69 |
| 1952,65 | 1,00 | 656,00 | 300,00 | 260,00 | 168,00 | 120,00 | 0 | 448,65 |
| 1973,32 | 1,00 | 652,00 | 264,00 | 260,00 | 216,00 | 116,00 | 0 | 465,32 |

| | | | | | | | |
|---|---|---|---|---|---|---|---|
| 1826,87 | 1,00 | 652,00 | 264,00 | 260,00 | 204,00 | 92,00 | 0 | 354,87 |
| 1773,89 | 1,00 | 688,00 | 264,00 | 120,00 | 204,00 | 143,00 | 0 | 354,89 |
| 2280,91 | 1,00 | 928,00 | 264,00 | 324,00 | 140,00 | 164,00 | 0 | 460,91 |
| 2037,50 | 1,00 | 928,00 | 244,00 | 192,00 | 64,00 | 160,00 | 0 | 449,50 |
| 1471,47 | 1,00 | 420,00 | 288,00 | 192,00 | 64,00 | 160,00 | 0 | 347,47 |
| 1341,63 | 1,00 | 420,00 | 168,00 | 220,00 | 64,00 | 148,00 | 0 | 321,63 |
| 1577,66 | 1,00 | 304,00 | 244,00 | 284,00 | 208,00 | 164,00 | 0 | 373,66 |
| 1522,27 | 1,00 | 404,00 | 256,00 | 112,00 | 212,00 | 160,00 | 0 | 378,27 |
| 2227,73 | 1,00 | 812,00 | 252,00 | 300,00 | 204,00 | 164,00 | 0 | 495,73 |
| 2629,77 | 1,00 | 592,00 | 256,00 | 300,00 | 216,00 | 140,00 | 0 | 1125,77 |
| 2894,76 | 1,00 | 724,00 | 252,00 | 360,00 | 224,00 | 184,00 | 0 | 1150,76 |
| 3040,87 | 1,00 | 1004,00 | 252,00 | 276,00 | 144,00 | 184,00 | 0 | 1180,87 |
| 4558,38 | 1,00 | 2541,00 | 264,00 | 392,00 | 152,00 | 160,00 | 0 | 1049,38 |
| 4628,32 | 1,00 | 2998,00 | 292,00 | 500,00 | 128,00 | 152,00 | 0 | 558,32 |
| 4883,57 | 1,00 | 2276,00 | 324,00 | 500,00 | 288,00 | 152,00 | 0 | 1343,57 |
| 5040,53 | 1,00 | 2304,00 | 304,00 | 500,00 | 344,00 | 168,00 | 0 | 1420,53 |
| 4123,45 | 1,00 | 1152,00 | 292,00 | 472,00 | 526,00 | 167,00 | 0 | 1514,45 |
| 4815,86 | 1,00 | 1152,00 | 292,00 | 416,00 | 548,00 | 140,00 | 0 | 2267,86 |
| 4131,63 | 1,00 | 716,00 | 316,00 | 416,00 | 544,00 | 152,00 | 0 | 1987,63 |
| 4201,64 | 1,00 | 764,00 | 380,00 | 328,00 | 1296,00 | 160,00 | 0 | 1273,64 |
| 2998,71 | 1,00 | 556,00 | 460,00 | 684,00 | 596,00 | 124,00 | 0 | 578,71 |
| 2936,59 | 1,00 | 808,00 | 520,00 | 664,00 | 252,00 | 96,00 | 0 | 596,59 |
| 3248,32 | 1,00 | 1220,00 | 525,00 | 636,00 | 200,00 | 120,00 | 0 | 547,32 |
| 3568,90 | 1,00 | 1464,00 | 496,00 | 632,00 | 316,00 | 124,00 | 0 | 536,90 |
| 3690,13 | 1,00 | 1464,00 | 472,00 | 624,00 | 388,00 | 124,00 | 0 | 618,13 |
| 3618,80 | 1,00 | 1443,00 | 471,00 | 624,00 | 392,00 | 96,00 | 0 | 592,80 |
| 3244,98 | 1,00 | 1168,00 | 445,00 | 524,00 | 392,00 | 168,00 | 0 | 547,98 |
| 3105,04 | 1,00 | 1127,00 | 444,00 | 512,00 | 372,00 | 171,00 | 0 | 479,04 |
| 2977,06 | 1,00 | 1127,00 | 384,00 | 513,00 | 320,00 | 148,00 | 0 | 485,06 |
| 2733,38 | 1,00 | 587,00 | 336,00 | 956,00 | 235,00 | 104,00 | 0 | 515,38 |
| 4263,13 | 1,00 | 508,00 | 328,00 | 2447,00 | 232,00 | 132,00 | 0 | 616,13 |
| 1892,49 | 1,00 | 448,00 | 312,00 | 228,00 | 344,00 | 132,00 | 0 | 428,49 |
| 2218,30 | 1,00 | 824,00 | 312,00 | 164,00 | 294,00 | 180,00 | 0 | 444,30 |
| 2388,47 | 1,00 | 856,00 | 312,00 | 356,00 | 168,00 | 187,00 | 0 | 509,47 |
| 1963,91 | 1,00 | 600,00 | 312,00 | 196,00 | 168,00 | 180,00 | 0 | 507,91 |
| 2080,79 | 1,00 | 684,00 | 314,00 | 228,00 | 204,00 | 136,00 | 0 | 514,79 |
| 2163,99 | 1,00 | 716,00 | 316,00 | 258,00 | 268,00 | 132,00 | 0 | 473,99 |
| 1889,23 | 1,00 | 477,00 | 312,00 | 268,00 | 260,00 | 128,00 | 0 | 444,23 |
| 1693,05 | 1,00 | 268,00 | 316,00 | 254,00 | 260,00 | 128,00 | 0 | 467,05 |
| 1469,44 | 1,00 | 268,00 | 324,00 | 121,00 | 216,00 | 92,00 | 0 | 448,44 |
| 1813,45 | 1,00 | 524,00 | 308,00 | 340,00 | 84,00 | 128,00 | 0 | 429,45 |
| 1549,68 | 1,00 | 472,00 | 308,00 | 216,00 | 64,00 | 128,00 | 0 | 361,68 |
| 1504,79 | 1,00 | 468,00 | 308,00 | 208,00 | 64,00 | 120,00 | 0 | 336,79 |
| 1728,36 | 1,00 | 476,00 | 308,00 | 220,00 | 172,00 | 96,00 | 0 | 456,36 |

| | | | | | | | | |
|---|---|---|---|---|---|---|---|---|
| 1850,56 | 1,00 | 476,00 | 308,00 | 264,00 | 216,00 | 124,00 | 0 | 462,56 |
| 1469,52 | 1,00 | 208,00 | 308,00 | 257,00 | 208,00 | 128,00 | 0 | 360,52 |
| 1391,80 | 1,00 | 300,00 | 308,00 | 114,00 | 208,00 | 116,00 | 0 | 345,80 |
| 1518,62 | 1,00 | 228,00 | 308,00 | 328,00 | 184,00 | 116,00 | 0 | 354,62 |
| 1750,54 | 1,00 | 476,00 | 328,00 | 328,00 | 64,00 | 128,00 | 0 | 426,54 |
| 1415,92 | 1,00 | 292,00 | 352,00 | 212,00 | 64,00 | 116,00 | 0 | 379,92 |
| 1372,78 | 1,00 | 292,00 | 388,00 | 184,00 | 65,00 | 116,00 | 0 | 327,78 |
| 1694,51 | 1,00 | 297,00 | 388,00 | 372,00 | 180,00 | 104,00 | 0 | 353,51 |
| 1834,11 | 1,00 | 296,00 | 348,00 | 404,00 | 212,00 | 128,00 | 0 | 446,11 |
| 1614,30 | 1,00 | 352,00 | 308,00 | 200,00 | 204,00 | 124,00 | 0 | 426,30 |
| 1377,72 | 1,00 | 60,00 | 308,00 | 312,00 | 204,00 | 136,00 | 0 | 357,72 |
| 1236,83 | 1,00 | 256,00 | 171,00 | 257,00 | 88,00 | 136,00 | 0 | 328,83 |
| 1304,39 | 1,00 | 257,00 | 190,00 | 200,00 | 64,00 | 216,00 | 0 | 377,39 |
| 1574,16 | 1,00 | 311,00 | 172,00 | 376,00 | 60,00 | 227,00 | 0 | 428,16 |
| 1663,09 | 1,00 | 290,00 | 139,00 | 472,00 | 125,00 | 264,00 | 0 | 373,09 |
| 1469,17 | 1,00 | 290,00 | 139,00 | 316,00 | 212,00 | 168,00 | 0 | 344,17 |
| 1566,77 | 1,00 | 472,00 | 140,00 | 208,00 | 208,00 | 184,00 | 0 | 354,77 |
| 2059,03 | 1,00 | 604,00 | 300,00 | 340,00 | 204,00 | 176,00 | 0 | 435,03 |
| 1922,01 | 1,00 | 492,00 | 276,00 | 340,00 | 145,00 | 273,00 | 0 | 396,01 |
| 1392,39 | 1,00 | 133,00 | 232,00 | 332,00 | 216,00 | 272,00 | 0 | 207,39 |
| 1227,39 | 1,00 | 112,00 | 236,00 | 400,00 | 120,00 | 164,00 | 0 | 195,39 |
| 1439,13 | 1,00 | 112,00 | 221,00 | 472,00 | 220,00 | 124,00 | 0 | 290,13 |
| 1491,13 | 1,00 | 376,00 | 208,00 | 295,00 | 204,00 | 124,00 | 0 | 284,13 |
| 1249,37 | 1,00 | 220,00 | 212,00 | 304,00 | 204,00 | 136,00 | 0 | 173,37 |
| 1117,71 | 1,00 | 176,00 | 196,00 | 304,00 | 64,00 | 160,00 | 0 | 217,71 |
| 1392,71 | 1,00 | 420,00 | 192,00 | 304,00 | 64,00 | 168,00 | 0 | 244,71 |
| 1359,93 | 1,00 | 351,00 | 240,00 | 296,00 | 65,00 | 136,00 | 0 | 271,93 |
| 1132,65 | 1,00 | 136,00 | 272,00 | 296,00 | 64,00 | 164,00 | 0 | 200,65 |
| 1205,65 | 1,00 | 216,00 | 228,00 | 228,00 | 212,00 | 163,00 | 0 | 158,65 |
| 1386,80 | 1,00 | 216,00 | 128,00 | 400,00 | 212,00 | 167,00 | 0 | 263,80 |
| 1462,05 | 1,00 | 412,00 | 192,00 | 232,00 | 208,00 | 140,00 | 0 | 278,05 |
| 3361,51 | 1,00 | 341,00 | 152,00 | 2120,00 | 196,00 | 140,00 | 0 | 412,51 |
| 3212,63 | 1,00 | 296,00 | 200,00 | 2119,00 | 65,00 | 164,00 | 0 | 368,63 |
| 1376,10 | 1,00 | 296,00 | 268,00 | 236,00 | 64,00 | 164,00 | 0 | 348,10 |
| 1233,68 | 1,00 | 356,00 | 244,00 | 264,00 | 64,00 | 104,00 | 0 | 201,68 |
| 1728,04 | 1,00 | 676,00 | 240,00 | 229,00 | 212,00 | 116,00 | 0 | 255,04 |
| 1976,17 | 1,00 | 648,00 | 236,00 | 316,00 | 212,00 | 116,00 | 0 | 448,17 |
| 1977,62 | 1,00 | 492,00 | 236,00 | 316,00 | 204,00 | 120,00 | 0 | 609,62 |
| 2485,99 | 1,00 | 508,00 | 4,00 | 184,00 | 204,00 | 112,00 | 0 | 1473,99 |
| 2157,65 | 1,00 | 508,00 | 8,00 | 384,00 | 112,00 | 87,00 | 0 | 1058,65 |
| 1638,95 | 1,00 | 660,00 | 100,00 | 380,00 | 64,00 | 88,00 | 0 | 346,95 |
| 1468,15 | 1,00 | 544,00 | 96,00 | 308,00 | 64,00 | 116,00 | 0 | 340,15 |
| 1558,95 | 1,00 | 336,00 | 204,00 | 364,00 | 88,00 | 116,00 | 0 | 450,95 |
| 1722,92 | 1,00 | 336,00 | 292,00 | 252,00 | 224,00 | 100,00 | 0 | 518,92 |

| | | | | | | | | |
|---|---|---|---|---|---|---|---|---|
| 1764,26 | 1,00 | 336,00 | 280,00 | 326,00 | 208,00 | 101,00 | 0 | 513,26 |
| 1953,98 | 1,00 | 616,00 | 280,00 | 176,00 | 208,00 | 120,00 | 0 | 553,98 |
| 1899,07 | 1,00 | 584,00 | 276,00 | 199,00 | 176,00 | 116,00 | 0 | 548,07 |
| 1746,37 | 1,00 | 576,00 | 312,00 | 332,00 | 68,00 | 116,00 | 0 | 342,37 |
| 1893,42 | 1,00 | 852,00 | 272,00 | 228,00 | 66,00 | 96,00 | 0 | 379,42 |
| 2056,69 | 1,00 | 720,00 | 300,00 | 380,00 | 64,00 | 120,00 | 0 | 472,69 |
| 1951,65 | 1,00 | 656,00 | 300,00 | 260,00 | 168,00 | 120,00 | 0 | 447,65 |
| 1974,32 | 1,00 | 652,00 | 264,00 | 260,00 | 216,00 | 116,00 | 0 | 466,32 |
| 1853,11 | 1,00 | 652,00 | 264,00 | 260,00 | 204,00 | 116,00 | 0 | 357,11 |
| 1769,89 | 1,00 | 688,00 | 264,00 | 120,00 | 204,00 | 143,00 | 0 | 350,89 |
| 2282,91 | 1,00 | 928,00 | 264,00 | 324,00 | 140,00 | 164,00 | 0 | 462,91 |
| 2033,40 | 1,00 | 928,00 | 244,00 | 192,00 | 63,00 | 160,00 | 0 | 446,40 |
| 1467,47 | 1,00 | 420,00 | 288,00 | 192,00 | 64,00 | 160,00 | 0 | 343,47 |
| 1346,63 | 1,00 | 420,00 | 168,00 | 220,00 | 64,00 | 148,00 | 0 | 326,63 |
| 1578,66 | 1,00 | 304,00 | 244,00 | 284,00 | 208,00 | 164,00 | 0 | 374,66 |
| 1525,27 | 1,00 | 404,00 | 256,00 | 112,00 | 212,00 | 160,00 | 0 | 381,27 |
| 2227,73 | 1,00 | 812,00 | 252,00 | 300,00 | 204,00 | 164,00 | 0 | 495,73 |
| 2609,77 | 1,00 | 592,00 | 256,00 | 300,00 | 216,00 | 140,00 | 0 | 1105,77 |
| 2893,76 | 1,00 | 724,00 | 252,00 | 360,00 | 224,00 | 184,00 | 0 | 1149,76 |
| 3058,77 | 1,00 | 1004,00 | 252,00 | 276,00 | 143,00 | 184,00 | 0 | 1199,77 |
| 4554,24 | 1,00 | 2541,00 | 252,00 | 392,00 | 152,00 | 160,00 | 0 | 1057,24 |
| 3843,40 | 1,00 | 2276,00 | 292,00 | 500,00 | 128,00 | 152,00 | 0 | 495,40 |
| 4899,57 | 1,00 | 2276,00 | 324,00 | 500,00 | 288,00 | 152,00 | 0 | 1359,57 |
| 5020,82 | 1,00 | 2307,00 | 304,00 | 500,00 | 344,00 | 168,00 | 0 | 1397,82 |
| 4076,16 | 1,00 | 1152,00 | 292,00 | 416,00 | 526,00 | 167,00 | 0 | 1523,16 |
| 4858,86 | 1,00 | 1152,00 | 292,00 | 416,00 | 548,00 | 140,00 | 0 | 2310,86 |
| 4073,51 | 1,00 | 716,00 | 316,00 | 416,00 | 544,00 | 140,00 | 0 | 1941,51 |
| 4300,45 | 1,00 | 764,00 | 380,00 | 416,00 | 1301,00 | 160,00 | 0 | 1279,45 |
| 3228,95 | 1,00 | 764,00 | 461,00 | 684,00 | 596,00 | 124,00 | 0 | 599,95 |
| 2954,89 | 1,00 | 556,00 | 520,00 | 664,00 | 596,00 | 96,00 | 0 | 522,89 |
| 3247,32 | 1,00 | 1220,00 | 525,00 | 636,00 | 200,00 | 120,00 | 0 | 546,32 |
| 3564,90 | 1,00 | 1464,00 | 496,00 | 632,00 | 316,00 | 124,00 | 0 | 532,90 |
| 3687,03 | 1,00 | 1464,00 | 472,00 | 624,00 | 387,00 | 124,00 | 0 | 616,03 |
| 3619,80 | 1,00 | 1443,00 | 471,00 | 624,00 | 392,00 | 96,00 | 0 | 593,80 |
| 3246,08 | 1,00 | 1169,00 | 444,00 | 524,00 | 393,00 | 168,00 | 0 | 548,08 |
| 3101,04 | 1,00 | 1127,00 | 444,00 | 512,00 | 372,00 | 171,00 | 0 | 475,04 |
| 2977,06 | 1,00 | 1127,00 | 384,00 | 513,00 | 320,00 | 148,00 | 0 | 485,06 |
| 2733,29 | 1,00 | 587,00 | 336,00 | 955,00 | 235,00 | 104,00 | 0 | 516,29 |
| 4263,13 | 1,00 | 508,00 | 328,00 | 2447,00 | 232,00 | 132,00 | 0 | 616,13 |
| 1821,45 | 1,00 | 448,00 | 312,00 | 164,00 | 344,00 | 132,00 | 0 | 421,45 |
| 2220,39 | 1,00 | 824,00 | 312,00 | 164,00 | 294,00 | 181,00 | 0 | 445,39 |
| 2389,47 | 1,00 | 856,00 | 312,00 | 356,00 | 168,00 | 187,00 | 0 | 510,47 |
| 1963,91 | 1,00 | 600,00 | 312,00 | 196,00 | 168,00 | 180,00 | 0 | 507,91 |
| 2080,79 | 1,00 | 684,00 | 314,00 | 228,00 | 204,00 | 136,00 | 0 | 514,79 |

| | | | | | | | | |
|---|---|---|---|---|---|---|---|---|
| 2165,99 | 1,00 | 716,00 | 316,00 | 258,00 | 268,00 | 132,00 | 0 | 475,99 |
| 1881,76 | 1,00 | 477,00 | 312,00 | 268,00 | 260,00 | 123,00 | 0 | 441,76 |
| 1921,29 | 1,00 | 477,00 | 316,00 | 254,00 | 260,00 | 128,00 | 0 | 486,29 |
| 1324,12 | 1,00 | 268,00 | 324,00 | 121,00 | 84,00 | 92,00 | 0 | 435,12 |
| 1789,43 | 1,00 | 524,00 | 308,00 | 340,00 | 64,00 | 128,00 | 0 | 425,43 |
| 1552,68 | 1,00 | 472,00 | 308,00 | 216,00 | 64,00 | 128,00 | 0 | 364,68 |
| 1504,08 | 1,00 | 468,00 | 311,00 | 208,00 | 64,00 | 120,00 | 0 | 333,08 |
| 1729,45 | 1,00 | 476,00 | 308,00 | 220,00 | 172,00 | 97,00 | 0 | 456,45 |
| 1850,56 | 1,00 | 476,00 | 308,00 | 264,00 | 216,00 | 124,00 | 0 | 462,56 |
| 1767,57 | 1,00 | 477,00 | 308,00 | 257,00 | 208,00 | 128,00 | 0 | 389,57 |
| 1393,80 | 1,00 | 300,00 | 308,00 | 114,00 | 208,00 | 116,00 | 0 | 347,80 |
| 1522,62 | 1,00 | 228,00 | 308,00 | 328,00 | 184,00 | 116,00 | 0 | 358,62 |
| 1744,98 | 1,00 | 476,00 | 328,00 | 322,00 | 64,00 | 128,00 | 0 | 426,98 |
| 1420,42 | 1,00 | 292,00 | 352,00 | 212,00 | 69,00 | 116,00 | 0 | 379,42 |
| 1359,66 | 1,00 | 292,00 | 388,00 | 184,00 | 65,00 | 104,00 | 0 | 326,66 |
| 1705,63 | 1,00 | 297,00 | 388,00 | 372,00 | 180,00 | 116,00 | 0 | 352,63 |
| 1835,21 | 1,00 | 297,00 | 348,00 | 404,00 | 212,00 | 128,00 | 0 | 446,21 |
| 1615,30 | 1,00 | 352,00 | 308,00 | 200,00 | 204,00 | 124,00 | 0 | 427,30 |
| 1378,72 | 1,00 | 60,00 | 308,00 | 312,00 | 204,00 | 136,00 | 0 | 358,72 |
| 1231,83 | 1,00 | 256,00 | 171,00 | 257,00 | 88,00 | 136,00 | 0 | 323,83 |
| 1307,39 | 1,00 | 257,00 | 190,00 | 200,00 | 64,00 | 216,00 | 0 | 380,39 |
| 1558,94 | 1,00 | 311,00 | 172,00 | 376,00 | 58,00 | 216,00 | 0 | 425,94 |
| 1667,18 | 1,00 | 290,00 | 139,00 | 472,00 | 125,00 | 265,00 | 0 | 376,18 |
| 1483,17 | 1,00 | 290,00 | 139,00 | 316,00 | 212,00 | 168,00 | 0 | 358,17 |
| 1569,77 | 1,00 | 472,00 | 140,00 | 208,00 | 208,00 | 184,00 | 0 | 357,77 |
| 2061,03 | 1,00 | 604,00 | 300,00 | 340,00 | 204,00 | 176,00 | 0 | 437,03 |
| 1926,01 | 1,00 | 492,00 | 276,00 | 340,00 | 145,00 | 273,00 | 0 | 400,01 |
| 1387,39 | 1,00 | 133,00 | 232,00 | 332,00 | 216,00 | 272,00 | 0 | 202,39 |
| 1236,39 | 1,00 | 112,00 | 236,00 | 400,00 | 120,00 | 164,00 | 0 | 204,39 |
| 1442,13 | 1,00 | 112,00 | 221,00 | 472,00 | 220,00 | 124,00 | 0 | 293,13 |
| 1489,13 | 1,00 | 376,00 | 208,00 | 295,00 | 204,00 | 124,00 | 0 | 282,13 |
| 1241,37 | 1,00 | 220,00 | 212,00 | 304,00 | 204,00 | 136,00 | 0 | 165,37 |
| 1116,71 | 1,00 | 176,00 | 196,00 | 304,00 | 64,00 | 160,00 | 0 | 216,71 |
| 1390,71 | 1,00 | 420,00 | 192,00 | 304,00 | 64,00 | 168,00 | 0 | 242,71 |
| 1358,93 | 1,00 | 351,00 | 240,00 | 296,00 | 65,00 | 136,00 | 0 | 270,93 |
| 1132,65 | 1,00 | 136,00 | 272,00 | 296,00 | 64,00 | 164,00 | 0 | 200,65 |
| 1197,65 | 1,00 | 216,00 | 228,00 | 228,00 | 212,00 | 163,00 | 0 | 150,65 |
| 1385,61 | 1,00 | 214,00 | 128,00 | 400,00 | 212,00 | 167,00 | 0 | 264,61 |
| 1461,05 | 1,00 | 412,00 | 192,00 | 232,00 | 208,00 | 140,00 | 0 | 277,05 |
| 1199,41 | 1,00 | 341,00 | 200,00 | 231,00 | 65,00 | 140,00 | 0 | 222,41 |
| 3220,54 | 1,00 | 296,00 | 200,00 | 2118,00 | 65,00 | 164,00 | 0 | 377,54 |
| 1380,10 | 1,00 | 296,00 | 268,00 | 236,00 | 64,00 | 164,00 | 0 | 352,10 |
| 1241,68 | 1,00 | 356,00 | 244,00 | 264,00 | 64,00 | 104,00 | 0 | 209,68 |
| 1824,26 | 1,00 | 676,00 | 240,00 | 316,00 | 212,00 | 116,00 | 0 | 264,26 |

| | | | | | | | | |
|---|---|---|---|---|---|---|---|---|
| 1977,17 | 1,00 | 648,00 | 236,00 | 316,00 | 212,00 | 116,00 | 0 | 449,17 |
| 1979,62 | 1,00 | 492,00 | 236,00 | 316,00 | 204,00 | 120,00 | 0 | 611,62 |
| 2496,99 | 1,00 | 508,00 | 4,00 | 184,00 | 204,00 | 112,00 | 0 | 1484,99 |
| 2139,65 | 1,00 | 508,00 | 8,00 | 384,00 | 112,00 | 87,00 | 0 | 1040,65 |
| 1642,95 | 1,00 | 660,00 | 100,00 | 380,00 | 64,00 | 88,00 | 0 | 350,95 |
| 1445,21 | 1,00 | 524,00 | 96,00 | 308,00 | 64,00 | 116,00 | 0 | 337,21 |
| 1558,95 | 1,00 | 336,00 | 204,00 | 364,00 | 88,00 | 116,00 | 0 | 450,95 |
| 1723,92 | 1,00 | 336,00 | 292,00 | 252,00 | 224,00 | 100,00 | 0 | 519,92 |
| 1765,26 | 1,00 | 336,00 | 280,00 | 326,00 | 208,00 | 101,00 | 0 | 514,26 |
| 1953,98 | 1,00 | 616,00 | 280,00 | 176,00 | 208,00 | 120,00 | 0 | 553,98 |
| 1891,30 | 1,00 | 576,00 | 276,00 | 199,00 | 176,00 | 116,00 | 0 | 548,30 |
| 1760,15 | 1,00 | 584,00 | 312,00 | 332,00 | 68,00 | 116,00 | 0 | 348,15 |
| 1893,42 | 1,00 | 852,00 | 272,00 | 228,00 | 66,00 | 96,00 | 0 | 379,42 |
| 1968,69 | 1,00 | 720,00 | 300,00 | 380,00 | 64,00 | 120,00 | 0 | 384,69 |
| 1949,65 | 1,00 | 656,00 | 300,00 | 260,00 | 168,00 | 120,00 | 0 | 445,65 |
| 1974,32 | 1,00 | 652,00 | 264,00 | 260,00 | 216,00 | 116,00 | 0 | 466,32 |
| 1850,11 | 1,00 | 652,00 | 264,00 | 260,00 | 204,00 | 116,00 | 0 | 354,11 |
| 1773,89 | 1,00 | 688,00 | 264,00 | 120,00 | 204,00 | 143,00 | 0 | 354,89 |
| 2290,91 | 1,00 | 928,00 | 264,00 | 324,00 | 140,00 | 164,00 | 0 | 470,91 |
| 1974,40 | 1,00 | 928,00 | 244,00 | 192,00 | 63,00 | 160,00 | 0 | 387,40 |
| 1463,47 | 1,00 | 420,00 | 288,00 | 192,00 | 64,00 | 160,00 | 0 | 339,47 |
| 1344,63 | 1,00 | 420,00 | 168,00 | 220,00 | 64,00 | 148,00 | 0 | 324,63 |
| 1578,66 | 1,00 | 304,00 | 244,00 | 284,00 | 208,00 | 164,00 | 0 | 374,66 |
| 1511,27 | 1,00 | 404,00 | 256,00 | 112,00 | 212,00 | 160,00 | 0 | 367,27 |
| 2228,73 | 1,00 | 812,00 | 252,00 | 300,00 | 204,00 | 164,00 | 0 | 496,73 |
| 2593,77 | 1,00 | 592,00 | 256,00 | 300,00 | 216,00 | 140,00 | 0 | 1089,77 |
| 2910,76 | 1,00 | 724,00 | 252,00 | 360,00 | 224,00 | 184,00 | 0 | 1166,76 |
| 3051,77 | 1,00 | 1004,00 | 252,00 | 276,00 | 143,00 | 184,00 | 0 | 1192,77 |
| 4544,24 | 1,00 | 2541,00 | 252,00 | 392,00 | 152,00 | 160,00 | 0 | 1047,24 |
| 4699,85 | 1,00 | 2273,00 | 292,00 | 500,00 | 128,00 | 160,00 | 0 | 1346,85 |
| 4893,47 | 1,00 | 2275,00 | 324,00 | 500,00 | 288,00 | 152,00 | 0 | 1354,47 |
| 5004,82 | 1,00 | 2307,00 | 304,00 | 500,00 | 344,00 | 168,00 | 0 | 1381,82 |
| 4110,48 | 1,00 | 1152,00 | 292,00 | 416,00 | 549,00 | 167,00 | 0 | 1534,48 |
| 4872,86 | 1,00 | 1152,00 | 292,00 | 416,00 | 548,00 | 140,00 | 0 | 2324,86 |
| 4042,51 | 1,00 | 716,00 | 316,00 | 416,00 | 544,00 | 140,00 | 0 | 1910,51 |
| 4306,55 | 1,00 | 764,00 | 380,00 | 416,00 | 1302,00 | 160,00 | 0 | 1284,55 |
| 3228,95 | 1,00 | 764,00 | 461,00 | 684,00 | 596,00 | 124,00 | 0 | 599,95 |
| 2952,89 | 1,00 | 556,00 | 520,00 | 664,00 | 596,00 | 96,00 | 0 | 520,89 |
| 3201,41 | 1,00 | 1221,00 | 525,00 | 636,00 | 200,00 | 120,00 | 0 | 499,41 |
| 3566,80 | 1,00 | 1463,00 | 496,00 | 632,00 | 316,00 | 124,00 | 0 | 535,80 |
| 3686,03 | 1,00 | 1464,00 | 472,00 | 624,00 | 387,00 | 124,00 | 0 | 615,03 |
| 3618,51 | 1,00 | 1443,00 | 464,00 | 624,00 | 392,00 | 100,00 | 0 | 595,51 |
| 3248,08 | 1,00 | 1169,00 | 444,00 | 524,00 | 393,00 | 168,00 | 0 | 550,08 |
| 3025,89 | 1,00 | 1127,00 | 379,00 | 512,00 | 372,00 | 171,00 | 0 | 464,89 |

| | | | | | | | | |
|---|---|---|---|---|---|---|---|---|
| 2980,06 | 1,00 | 1127,00 | 384,00 | 513,00 | 320,00 | 148,00 | 0 | 488,06 |
| 3327,68 | 1,00 | 1127,00 | 336,00 | 956,00 | 235,00 | 104,00 | 0 | 569,68 |
| 4262,13 | 1,00 | 508,00 | 328,00 | 2447,00 | 232,00 | 132,00 | 0 | 615,13 |
| 1823,64 | 1,00 | 449,00 | 312,00 | 164,00 | 345,00 | 132,00 | 0 | 421,64 |
| 2217,39 | 1,00 | 824,00 | 312,00 | 164,00 | 294,00 | 181,00 | 0 | 442,39 |
| 2390,47 | 1,00 | 856,00 | 312,00 | 356,00 | 168,00 | 187,00 | 0 | 511,47 |
| 1965,01 | 1,00 | 601,00 | 312,00 | 196,00 | 168,00 | 180,00 | 0 | 508,01 |
| 2080,79 | 1,00 | 684,00 | 314,00 | 228,00 | 204,00 | 136,00 | 0 | 514,79 |
| 2163,99 | 1,00 | 716,00 | 316,00 | 258,00 | 268,00 | 132,00 | 0 | 473,99 |
| 1879,76 | 1,00 | 477,00 | 312,00 | 268,00 | 260,00 | 123,00 | 0 | 439,76 |
| 1728,53 | 1,00 | 477,00 | 316,00 | 254,00 | 84,00 | 128,00 | 0 | 469,53 |
| 1316,37 | 1,00 | 268,00 | 316,00 | 121,00 | 84,00 | 92,00 | 0 | 435,37 |
| 1791,43 | 1,00 | 524,00 | 308,00 | 340,00 | 64,00 | 128,00 | 0 | 427,43 |
| 1553,68 | 1,00 | 472,00 | 308,00 | 216,00 | 64,00 | 128,00 | 0 | 365,68 |
| 1502,08 | 1,00 | 468,00 | 311,00 | 208,00 | 64,00 | 120,00 | 0 | 331,08 |
| 1608,46 | 1,00 | 476,00 | 308,00 | 220,00 | 64,00 | 96,00 | 0 | 444,46 |
| 1855,56 | 1,00 | 476,00 | 308,00 | 264,00 | 216,00 | 124,00 | 0 | 467,56 |
| 1758,45 | 1,00 | 477,00 | 308,00 | 257,00 | 208,00 | 116,00 | 0 | 392,45 |
| 1315,82 | 1,00 | 228,00 | 308,00 | 114,00 | 208,00 | 116,00 | 0 | 341,82 |
| 1526,62 | 1,00 | 228,00 | 308,00 | 328,00 | 184,00 | 116,00 | 0 | 362,62 |
| 1743,98 | 1,00 | 476,00 | 328,00 | 322,00 | 64,00 | 128,00 | 0 | 425,98 |
| 1418,42 | 1,00 | 292,00 | 352,00 | 212,00 | 69,00 | 116,00 | 0 | 377,42 |
| 1392,31 | 1,00 | 292,00 | 388,00 | 212,00 | 65,00 | 104,00 | 0 | 331,31 |
| 1698,25 | 1,00 | 297,00 | 384,00 | 372,00 | 180,00 | 116,00 | 0 | 349,25 |
| 1747,21 | 1,00 | 297,00 | 348,00 | 404,00 | 212,00 | 128,00 | 0 | 358,21 |
| 1614,30 | 1,00 | 352,00 | 308,00 | 200,00 | 204,00 | 124,00 | 0 | 426,30 |
| 1260,14 | 1,00 | 60,00 | 308,00 | 200,00 | 204,00 | 136,00 | 0 | 352,14 |
| 1230,83 | 1,00 | 256,00 | 171,00 | 257,00 | 88,00 | 136,00 | 0 | 322,83 |
| 1307,29 | 1,00 | 257,00 | 190,00 | 200,00 | 63,00 | 216,00 | 0 | 381,29 |
| 1558,94 | 1,00 | 311,00 | 172,00 | 376,00 | 58,00 | 216,00 | 0 | 425,94 |
| 1667,18 | 1,00 | 290,00 | 139,00 | 472,00 | 125,00 | 265,00 | 0 | 376,18 |
| 1483,17 | 1,00 | 290,00 | 139,00 | 316,00 | 212,00 | 168,00 | 0 | 358,17 |
| 1566,77 | 1,00 | 472,00 | 140,00 | 208,00 | 208,00 | 184,00 | 0 | 354,77 |
| 2060,03 | 1,00 | 604,00 | 300,00 | 340,00 | 204,00 | 176,00 | 0 | 436,03 |
| 1955,92 | 1,00 | 492,00 | 276,00 | 340,00 | 145,00 | 272,00 | 0 | 430,92 |
| 1393,39 | 1,00 | 133,00 | 232,00 | 332,00 | 216,00 | 272,00 | 0 | 208,39 |
| 1235,39 | 1,00 | 112,00 | 236,00 | 400,00 | 120,00 | 164,00 | 0 | 203,39 |
| 1362,13 | 1,00 | 112,00 | 221,00 | 472,00 | 220,00 | 124,00 | 0 | 213,13 |
| 1486,13 | 1,00 | 376,00 | 208,00 | 295,00 | 204,00 | 124,00 | 0 | 279,13 |
| 1223,25 | 1,00 | 220,00 | 212,00 | 304,00 | 204,00 | 124,00 | 0 | 159,25 |
| 1112,91 | 1,00 | 176,00 | 197,00 | 304,00 | 65,00 | 160,00 | 0 | 210,91 |
| 1398,71 | 1,00 | 420,00 | 192,00 | 304,00 | 64,00 | 168,00 | 0 | 250,71 |
| 1360,93 | 1,00 | 351,00 | 240,00 | 296,00 | 65,00 | 136,00 | 0 | 272,93 |
| 1124,65 | 1,00 | 136,00 | 272,00 | 296,00 | 64,00 | 164,00 | 0 | 192,65 |

| | | | | | | | | |
|---|---|---|---|---|---|---|---|---|
| 1202,65 | 1,00 | 216,00 | 228,00 | 228,00 | 212,00 | 163,00 | 0 | 155,65 |
| 1393,61 | 1,00 | 214,00 | 128,00 | 400,00 | 212,00 | 167,00 | 0 | 272,61 |
| 1462,05 | 1,00 | 412,00 | 192,00 | 232,00 | 208,00 | 140,00 | 0 | 278,05 |
| 1202,41 | 1,00 | 341,00 | 200,00 | 231,00 | 65,00 | 140,00 | 0 | 225,41 |
| 3227,63 | 1,00 | 296,00 | 200,00 | 2119,00 | 65,00 | 164,00 | 0 | 383,63 |
| 1354,83 | 1,00 | 296,00 | 244,00 | 236,00 | 64,00 | 164,00 | 0 | 350,83 |
| 1261,95 | 1,00 | 356,00 | 268,00 | 264,00 | 64,00 | 104,00 | 0 | 205,95 |
| 1833,26 | 1,00 | 676,00 | 240,00 | 316,00 | 212,00 | 116,00 | 0 | 273,26 |
| 1978,17 | 1,00 | 648,00 | 236,00 | 316,00 | 212,00 | 116,00 | 0 | 450,17 |
| 1976,62 | 1,00 | 492,00 | 236,00 | 316,00 | 204,00 | 120,00 | 0 | 608,62 |
| 2430,71 | 1,00 | 508,00 | 4,00 | 184,00 | 112,00 | 112,00 | 0 | 1510,71 |
| 2154,65 | 1,00 | 508,00 | 8,00 | 384,00 | 112,00 | 87,00 | 0 | 1055,65 |
| 1642,15 | 1,00 | 660,00 | 100,00 | 380,00 | 66,00 | 88,00 | 0 | 348,15 |
| 1445,21 | 1,00 | 524,00 | 96,00 | 308,00 | 64,00 | 116,00 | 0 | 337,21 |
| 1327,72 | 1,00 | 336,00 | 96,00 | 364,00 | 88,00 | 116,00 | 0 | 327,72 |
| 1723,92 | 1,00 | 336,00 | 292,00 | 252,00 | 224,00 | 100,00 | 0 | 519,92 |
| 1765,26 | 1,00 | 336,00 | 280,00 | 326,00 | 208,00 | 101,00 | 0 | 514,26 |
| 1911,11 | 1,00 | 576,00 | 280,00 | 176,00 | 208,00 | 120,00 | 0 | 551,11 |
| 1892,30 | 1,00 | 576,00 | 276,00 | 199,00 | 176,00 | 116,00 | 0 | 549,30 |
| 2056,10 | 1,00 | 852,00 | 312,00 | 332,00 | 68,00 | 116,00 | 0 | 376,10 |
| 1892,42 | 1,00 | 852,00 | 272,00 | 228,00 | 66,00 | 96,00 | 0 | 378,42 |
| 1894,59 | 1,00 | 656,00 | 300,00 | 380,00 | 65,00 | 120,00 | 0 | 373,59 |
| 1947,65 | 1,00 | 656,00 | 300,00 | 260,00 | 168,00 | 120,00 | 0 | 443,65 |
| 1974,32 | 1,00 | 652,00 | 264,00 | 260,00 | 216,00 | 116,00 | 0 | 466,32 |
| 1894,59 | 1,00 | 688,00 | 264,00 | 260,00 | 204,00 | 116,00 | 0 | 362,59 |
| 1850,89 | 1,00 | 688,00 | 264,00 | 120,00 | 204,00 | 143,00 | 0 | 431,89 |
| 2284,53 | 1,00 | 928,00 | 264,00 | 324,00 | 140,00 | 160,00 | 0 | 468,53 |
| 1973,40 | 1,00 | 928,00 | 244,00 | 192,00 | 63,00 | 160,00 | 0 | 386,40 |
| 1465,47 | 1,00 | 420,00 | 288,00 | 192,00 | 64,00 | 160,00 | 0 | 341,47 |
| 1340,63 | 1,00 | 420,00 | 168,00 | 220,00 | 64,00 | 148,00 | 0 | 320,63 |
| 1576,66 | 1,00 | 304,00 | 244,00 | 284,00 | 208,00 | 164,00 | 0 | 372,66 |
| 1507,27 | 1,00 | 404,00 | 256,00 | 112,00 | 212,00 | 160,00 | 0 | 363,27 |
| 2228,73 | 1,00 | 812,00 | 252,00 | 300,00 | 204,00 | 164,00 | 0 | 496,73 |
| 2590,77 | 1,00 | 592,00 | 256,00 | 300,00 | 216,00 | 140,00 | 0 | 1086,77 |
| 2905,76 | 1,00 | 724,00 | 252,00 | 360,00 | 224,00 | 184,00 | 0 | 1161,76 |
| 3044,87 | 1,00 | 1004,00 | 252,00 | 276,00 | 144,00 | 184,00 | 0 | 1184,87 |
| 4587,64 | 1,00 | 2553,00 | 252,00 | 392,00 | 152,00 | 184,00 | 0 | 1054,64 |
| 4708,05 | 1,00 | 2275,00 | 292,00 | 500,00 | 128,00 | 160,00 | 0 | 1353,05 |
| 4916,47 | 1,00 | 2275,00 | 324,00 | 500,00 | 288,00 | 152,00 | 0 | 1377,47 |
| 4987,37 | 1,00 | 2292,00 | 304,00 | 500,00 | 344,00 | 168,00 | 0 | 1379,37 |
| 4101,58 | 1,00 | 1152,00 | 292,00 | 416,00 | 550,00 | 167,00 | 0 | 1524,58 |
| 4823,96 | 1,00 | 1152,00 | 292,00 | 416,00 | 549,00 | 140,00 | 0 | 2274,96 |
| 4069,51 | 1,00 | 716,00 | 316,00 | 416,00 | 544,00 | 140,00 | 0 | 1937,51 |
| 4326,55 | 1,00 | 764,00 | 380,00 | 416,00 | 1302,00 | 160,00 | 0 | 1304,55 |

| | | | | | | | | |
|---|---|---|---|---|---|---|---|---|
| 3000,81 | 1,00 | 556,00 | 461,00 | 684,00 | 596,00 | 124,00 | 0 | 579,81 |
| 2956,99 | 1,00 | 556,00 | 520,00 | 664,00 | 596,00 | 97,00 | 0 | 523,99 |
| 3204,41 | 1,00 | 1221,00 | 525,00 | 636,00 | 200,00 | 120,00 | 0 | 502,41 |
| 3554,40 | 1,00 | 1463,00 | 496,00 | 632,00 | 312,00 | 124,00 | 0 | 527,40 |
| 3685,13 | 1,00 | 1464,00 | 472,00 | 624,00 | 388,00 | 124,00 | 0 | 613,13 |
| 3617,51 | 1,00 | 1443,00 | 464,00 | 624,00 | 392,00 | 100,00 | 0 | 594,51 |
| 3199,01 | 1,00 | 1127,00 | 444,00 | 524,00 | 393,00 | 168,00 | 0 | 543,01 |
| 3066,95 | 1,00 | 1169,00 | 379,00 | 512,00 | 372,00 | 171,00 | 0 | 463,95 |
| 2976,06 | 1,00 | 1127,00 | 384,00 | 513,00 | 320,00 | 148,00 | 0 | 484,06 |
| 3326,68 | 1,00 | 1127,00 | 336,00 | 956,00 | 235,00 | 104,00 | 0 | 568,68 |
| 4262,13 | 1,00 | 508,00 | 328,00 | 2447,00 | 232,00 | 132,00 | 0 | 615,13 |
| 1824,64 | 1,00 | 449,00 | 312,00 | 164,00 | 345,00 | 132,00 | 0 | 422,64 |
| 2215,39 | 1,00 | 824,00 | 312,00 | 164,00 | 294,00 | 181,00 | 0 | 440,39 |
| 2389,47 | 1,00 | 856,00 | 312,00 | 356,00 | 168,00 | 187,00 | 0 | 510,47 |
| 1928,01 | 1,00 | 601,00 | 312,00 | 196,00 | 168,00 | 180,00 | 0 | 471,01 |
| 2080,79 | 1,00 | 684,00 | 314,00 | 228,00 | 204,00 | 136,00 | 0 | 514,79 |
| 2163,99 | 1,00 | 716,00 | 316,00 | 258,00 | 268,00 | 132,00 | 0 | 473,99 |
| 1879,76 | 1,00 | 477,00 | 312,00 | 268,00 | 260,00 | 123,00 | 0 | 439,76 |
| 1923,29 | 1,00 | 477,00 | 316,00 | 254,00 | 260,00 | 128,00 | 0 | 488,29 |
| 1316,37 | 1,00 | 268,00 | 316,00 | 121,00 | 84,00 | 92,00 | 0 | 435,37 |
| 1746,43 | 1,00 | 524,00 | 308,00 | 340,00 | 64,00 | 128,00 | 0 | 382,43 |
| 1614,72 | 1,00 | 524,00 | 308,00 | 216,00 | 64,00 | 128,00 | 0 | 374,72 |
| 1507,08 | 1,00 | 468,00 | 311,00 | 208,00 | 64,00 | 120,00 | 0 | 336,08 |
| 1609,46 | 1,00 | 476,00 | 308,00 | 220,00 | 64,00 | 96,00 | 0 | 445,46 |
| 1854,56 | 1,00 | 476,00 | 308,00 | 264,00 | 216,00 | 124,00 | 0 | 466,56 |
| 1756,45 | 1,00 | 477,00 | 308,00 | 257,00 | 208,00 | 116,00 | 0 | 390,45 |
| 1319,82 | 1,00 | 228,00 | 308,00 | 114,00 | 208,00 | 116,00 | 0 | 345,82 |
| 1525,52 | 1,00 | 227,00 | 308,00 | 328,00 | 184,00 | 116,00 | 0 | 362,52 |
| 1743,98 | 1,00 | 476,00 | 328,00 | 322,00 | 64,00 | 128,00 | 0 | 425,98 |
| 1403,12 | 1,00 | 292,00 | 352,00 | 212,00 | 69,00 | 102,00 | 0 | 376,12 |
| 1444,31 | 1,00 | 292,00 | 388,00 | 212,00 | 65,00 | 104,00 | 0 | 383,31 |
| 1701,25 | 1,00 | 297,00 | 384,00 | 372,00 | 180,00 | 116,00 | 0 | 352,25 |
| 1747,21 | 1,00 | 297,00 | 348,00 | 404,00 | 212,00 | 128,00 | 0 | 358,21 |
| 1612,30 | 1,00 | 352,00 | 308,00 | 200,00 | 204,00 | 124,00 | 0 | 424,30 |
| 1262,24 | 1,00 | 60,00 | 308,00 | 201,00 | 204,00 | 136,00 | 0 | 353,24 |
| 1379,80 | 1,00 | 256,00 | 308,00 | 257,00 | 88,00 | 136,00 | 0 | 334,80 |
| 1306,29 | 1,00 | 257,00 | 190,00 | 200,00 | 63,00 | 216,00 | 0 | 380,29 |
| 1542,54 | 1,00 | 311,00 | 172,00 | 376,00 | 64,00 | 216,00 | 0 | 403,54 |
| 1666,18 | 1,00 | 290,00 | 139,00 | 472,00 | 125,00 | 265,00 | 0 | 375,18 |
| 1479,78 | 1,00 | 286,00 | 139,00 | 316,00 | 212,00 | 168,00 | 0 | 358,78 |
| 1567,77 | 1,00 | 472,00 | 140,00 | 208,00 | 208,00 | 184,00 | 0 | 355,77 |
| 1817,92 | 1,00 | 604,00 | 140,00 | 340,00 | 145,00 | 176,00 | 0 | 412,92 |
| 1958,92 | 1,00 | 492,00 | 276,00 | 340,00 | 145,00 | 272,00 | 0 | 433,92 |
| 1394,48 | 1,00 | 133,00 | 233,00 | 332,00 | 216,00 | 272,00 | 0 | 208,48 |

| | | | | | | | | |
|---|---|---|---|---|---|---|---|---|
| 1225,39 | 1,00 | 112,00 | 236,00 | 400,00 | 120,00 | 164,00 | 0 | 193,39 |
| 1364,13 | 1,00 | 112,00 | 221,00 | 472,00 | 220,00 | 124,00 | 0 | 215,13 |
| 1490,13 | 1,00 | 376,00 | 208,00 | 295,00 | 204,00 | 124,00 | 0 | 283,13 |
| 1232,25 | 1,00 | 220,00 | 212,00 | 304,00 | 204,00 | 124,00 | 0 | 168,25 |
| 1112,91 | 1,00 | 176,00 | 197,00 | 304,00 | 65,00 | 160,00 | 0 | 210,91 |
| 1390,71 | 1,00 | 420,00 | 192,00 | 304,00 | 64,00 | 168,00 | 0 | 242,71 |
| 1332,93 | 1,00 | 351,00 | 240,00 | 296,00 | 65,00 | 136,00 | 0 | 244,93 |
| 1120,65 | 1,00 | 136,00 | 272,00 | 296,00 | 64,00 | 164,00 | 0 | 188,65 |
| 1194,65 | 1,00 | 216,00 | 228,00 | 228,00 | 212,00 | 163,00 | 0 | 147,65 |
| 1291,61 | 1,00 | 214,00 | 128,00 | 400,00 | 212,00 | 167,00 | 0 | 170,61 |
| 1387,18 | 1,00 | 412,00 | 130,00 | 232,00 | 208,00 | 140,00 | 0 | 265,18 |
| 1211,41 | 1,00 | 341,00 | 200,00 | 231,00 | 65,00 | 140,00 | 0 | 234,41 |
| 1173,04 | 1,00 | 295,00 | 200,00 | 240,00 | 65,00 | 164,00 | 0 | 209,04 |
| 1355,83 | 1,00 | 296,00 | 244,00 | 236,00 | 64,00 | 164,00 | 0 | 351,83 |
| 1634,06 | 1,00 | 676,00 | 268,00 | 264,00 | 64,00 | 116,00 | 0 | 246,06 |
| 1841,26 | 1,00 | 676,00 | 240,00 | 316,00 | 212,00 | 116,00 | 0 | 281,26 |
| 1979,17 | 1,00 | 648,00 | 236,00 | 316,00 | 212,00 | 116,00 | 0 | 451,17 |
| 1973,62 | 1,00 | 492,00 | 236,00 | 316,00 | 204,00 | 120,00 | 0 | 605,62 |
| 2442,14 | 1,00 | 506,00 | 4,00 | 180,00 | 112,00 | 112,00 | 0 | 1528,14 |
| 2148,65 | 1,00 | 508,00 | 8,00 | 384,00 | 112,00 | 87,00 | 0 | 1049,65 |
| 1637,15 | 1,00 | 660,00 | 100,00 | 380,00 | 66,00 | 88,00 | 0 | 343,15 |
| 1441,21 | 1,00 | 524,00 | 96,00 | 308,00 | 64,00 | 116,00 | 0 | 333,21 |
| 1330,72 | 1,00 | 336,00 | 96,00 | 364,00 | 88,00 | 116,00 | 0 | 330,72 |
| 1722,92 | 1,00 | 336,00 | 292,00 | 252,00 | 224,00 | 100,00 | 0 | 518,92 |
| 1766,35 | 1,00 | 337,00 | 280,00 | 326,00 | 208,00 | 101,00 | 0 | 514,35 |
| 1910,11 | 1,00 | 576,00 | 280,00 | 176,00 | 208,00 | 120,00 | 0 | 550,11 |
| 1893,30 | 1,00 | 576,00 | 276,00 | 199,00 | 176,00 | 116,00 | 0 | 550,30 |
| 2054,10 | 1,00 | 852,00 | 312,00 | 332,00 | 68,00 | 116,00 | 0 | 374,10 |
| 1896,52 | 1,00 | 852,00 | 272,00 | 228,00 | 67,00 | 96,00 | 0 | 381,52 |
| 1893,59 | 1,00 | 656,00 | 300,00 | 380,00 | 65,00 | 120,00 | 0 | 372,59 |
| 1948,65 | 1,00 | 656,00 | 300,00 | 260,00 | 168,00 | 120,00 | 0 | 444,65 |
| 1975,32 | 1,00 | 652,00 | 264,00 | 260,00 | 216,00 | 116,00 | 0 | 467,32 |
| 2017,81 | 1,00 | 688,00 | 264,00 | 260,00 | 216,00 | 116,00 | 0 | 473,81 |
| 1847,89 | 1,00 | 688,00 | 264,00 | 120,00 | 204,00 | 143,00 | 0 | 428,89 |
| 2281,53 | 1,00 | 928,00 | 264,00 | 324,00 | 140,00 | 160,00 | 0 | 465,53 |
| 1974,40 | 1,00 | 928,00 | 244,00 | 192,00 | 63,00 | 160,00 | 0 | 387,40 |
| 1468,47 | 1,00 | 420,00 | 288,00 | 192,00 | 64,00 | 160,00 | 0 | 344,47 |
| 1349,63 | 1,00 | 420,00 | 168,00 | 220,00 | 64,00 | 148,00 | 0 | 329,63 |
| 1574,66 | 1,00 | 304,00 | 244,00 | 284,00 | 208,00 | 164,00 | 0 | 370,66 |
| 1703,36 | 1,00 | 404,00 | 256,00 | 293,00 | 212,00 | 160,00 | 0 | 378,36 |
| 1988,42 | 1,00 | 592,00 | 252,00 | 300,00 | 204,00 | 164,00 | 0 | 476,42 |
| 2731,55 | 1,00 | 724,00 | 256,00 | 300,00 | 216,00 | 140,00 | 0 | 1095,55 |
| 3226,87 | 1,00 | 1004,00 | 252,00 | 360,00 | 224,00 | 184,00 | 0 | 1202,87 |
| 3049,87 | 1,00 | 1004,00 | 252,00 | 276,00 | 144,00 | 184,00 | 0 | 1189,87 |

| | | | | | | | | |
|---|---|---|---|---|---|---|---|---|
| 4580,45 | 1,00 | 2551,00 | 252,00 | 392,00 | 152,00 | 184,00 | 0 | 1049,45 |
| 4702,05 | 1,00 | 2275,00 | 292,00 | 500,00 | 128,00 | 160,00 | 0 | 1347,05 |
| 4899,47 | 1,00 | 2275,00 | 324,00 | 500,00 | 288,00 | 152,00 | 0 | 1360,47 |
| 4904,33 | 1,00 | 2292,00 | 304,00 | 416,00 | 343,00 | 168,00 | 0 | 1381,33 |
| 4168,42 | 1,00 | 1151,00 | 292,00 | 500,00 | 550,00 | 167,00 | 0 | 1508,42 |
| 4822,97 | 1,00 | 1151,00 | 292,00 | 416,00 | 550,00 | 140,00 | 0 | 2273,97 |
| 4086,51 | 1,00 | 716,00 | 316,00 | 416,00 | 544,00 | 140,00 | 0 | 1954,51 |
| 4251,49 | 1,00 | 764,00 | 316,00 | 416,00 | 1302,00 | 160,00 | 0 | 1293,49 |
| 3047,78 | 1,00 | 556,00 | 461,00 | 683,00 | 603,00 | 160,00 | 0 | 584,78 |
| 2957,89 | 1,00 | 556,00 | 520,00 | 664,00 | 595,00 | 97,00 | 0 | 525,89 |
| 3202,32 | 1,00 | 1221,00 | 525,00 | 635,00 | 200,00 | 120,00 | 0 | 501,32 |
| 3284,96 | 1,00 | 1221,00 | 496,00 | 632,00 | 312,00 | 124,00 | 0 | 499,96 |
| 3677,38 | 1,00 | 1464,00 | 464,00 | 624,00 | 388,00 | 124,00 | 0 | 613,38 |
| 3616,51 | 1,00 | 1443,00 | 464,00 | 624,00 | 392,00 | 100,00 | 0 | 593,51 |
| 3197,92 | 1,00 | 1127,00 | 444,00 | 523,00 | 393,00 | 168,00 | 0 | 542,92 |
| 3023,89 | 1,00 | 1127,00 | 379,00 | 512,00 | 372,00 | 171,00 | 0 | 462,89 |
| 2972,06 | 1,00 | 1127,00 | 384,00 | 513,00 | 320,00 | 148,00 | 0 | 480,06 |
| 3326,68 | 1,00 | 1127,00 | 336,00 | 956,00 | 235,00 | 104,00 | 0 | 568,68 |
| 4231,51 | 1,00 | 508,00 | 328,00 | 2447,00 | 232,00 | 104,00 | 0 | 612,51 |
| 1703,24 | 1,00 | 449,00 | 312,00 | 164,00 | 232,00 | 132,00 | 0 | 414,24 |
| 2218,39 | 1,00 | 824,00 | 312,00 | 164,00 | 294,00 | 181,00 | 0 | 443,39 |
| 2215,36 | 1,00 | 856,00 | 312,00 | 196,00 | 168,00 | 187,00 | 0 | 496,36 |
| 1929,01 | 1,00 | 601,00 | 312,00 | 196,00 | 168,00 | 180,00 | 0 | 472,01 |
| 2080,79 | 1,00 | 684,00 | 314,00 | 228,00 | 204,00 | 136,00 | 0 | 514,79 |
| 2163,99 | 1,00 | 716,00 | 316,00 | 258,00 | 268,00 | 132,00 | 0 | 473,99 |
| 1881,76 | 1,00 | 477,00 | 312,00 | 268,00 | 260,00 | 123,00 | 0 | 441,76 |
| 1923,29 | 1,00 | 477,00 | 316,00 | 254,00 | 260,00 | 128,00 | 0 | 488,29 |
| 1316,37 | 1,00 | 268,00 | 316,00 | 121,00 | 84,00 | 92,00 | 0 | 435,37 |
| 1711,07 | 1,00 | 524,00 | 308,00 | 340,00 | 64,00 | 92,00 | 0 | 383,07 |
| 1612,72 | 1,00 | 524,00 | 308,00 | 216,00 | 64,00 | 128,00 | 0 | 372,72 |
| 1489,56 | 1,00 | 468,00 | 311,00 | 192,00 | 64,00 | 120,00 | 0 | 334,56 |
| 1610,46 | 1,00 | 476,00 | 308,00 | 220,00 | 64,00 | 96,00 | 0 | 446,46 |
| 1853,56 | 1,00 | 476,00 | 308,00 | 264,00 | 216,00 | 124,00 | 0 | 465,56 |
| 1767,11 | 1,00 | 477,00 | 308,00 | 264,00 | 208,00 | 116,00 | 0 | 394,11 |
| 1323,82 | 1,00 | 228,00 | 308,00 | 114,00 | 208,00 | 116,00 | 0 | 349,82 |
| 1527,52 | 1,00 | 227,00 | 308,00 | 328,00 | 184,00 | 116,00 | 0 | 364,52 |
| 1741,88 | 1,00 | 476,00 | 327,00 | 322,00 | 64,00 | 128,00 | 0 | 424,88 |
| 1404,12 | 1,00 | 292,00 | 352,00 | 212,00 | 69,00 | 102,00 | 0 | 377,12 |
| 1443,40 | 1,00 | 292,00 | 388,00 | 213,00 | 65,00 | 104,00 | 0 | 381,40 |
| 1697,25 | 1,00 | 297,00 | 384,00 | 372,00 | 180,00 | 116,00 | 0 | 348,25 |
| 1750,21 | 1,00 | 297,00 | 348,00 | 404,00 | 212,00 | 128,00 | 0 | 361,21 |
| 1611,30 | 1,00 | 352,00 | 308,00 | 200,00 | 204,00 | 124,00 | 0 | 423,30 |
| 1265,24 | 1,00 | 60,00 | 308,00 | 201,00 | 204,00 | 136,00 | 0 | 356,24 |
| 1406,80 | 1,00 | 256,00 | 308,00 | 257,00 | 88,00 | 136,00 | 0 | 361,80 |

| | | | | | | | | |
|---|---|---|---|---|---|---|---|---|
| 1306,29 | 1,00 | 257,00 | 190,00 | 200,00 | 63,00 | 216,00 | 0 | 380,29 |
| 1540,44 | 1,00 | 310,00 | 172,00 | 376,00 | 64,00 | 216,00 | 0 | 402,44 |
| 1704,30 | 1,00 | 290,00 | 172,00 | 472,00 | 125,00 | 265,00 | 0 | 380,30 |
| 1478,77 | 1,00 | 283,00 | 139,00 | 319,00 | 212,00 | 168,00 | 0 | 357,77 |
| 1567,77 | 1,00 | 472,00 | 140,00 | 208,00 | 208,00 | 184,00 | 0 | 355,77 |
| 1815,83 | 1,00 | 604,00 | 140,00 | 340,00 | 145,00 | 175,00 | 0 | 411,83 |
| 1957,92 | 1,00 | 492,00 | 276,00 | 340,00 | 145,00 | 272,00 | 0 | 432,92 |
| 1394,48 | 1,00 | 133,00 | 233,00 | 332,00 | 216,00 | 272,00 | 0 | 208,48 |
| 1359,47 | 1,00 | 112,00 | 236,00 | 400,00 | 120,00 | 272,00 | 0 | 219,47 |
| 1363,13 | 1,00 | 112,00 | 221,00 | 472,00 | 220,00 | 124,00 | 0 | 214,13 |
| 1482,94 | 1,00 | 376,00 | 208,00 | 293,00 | 204,00 | 124,00 | 0 | 277,94 |
| 1226,16 | 1,00 | 220,00 | 211,00 | 304,00 | 204,00 | 124,00 | 0 | 163,16 |
| 1116,91 | 1,00 | 176,00 | 197,00 | 304,00 | 65,00 | 160,00 | 0 | 214,91 |
| 1397,71 | 1,00 | 420,00 | 192,00 | 304,00 | 64,00 | 168,00 | 0 | 249,71 |
| 1411,90 | 1,00 | 423,00 | 240,00 | 296,00 | 65,00 | 136,00 | 0 | 251,90 |
| 1092,62 | 1,00 | 136,00 | 240,00 | 296,00 | 64,00 | 164,00 | 0 | 192,62 |
| 1195,12 | 1,00 | 217,00 | 228,00 | 228,00 | 212,00 | 167,00 | 0 | 143,12 |
| 1300,61 | 1,00 | 214,00 | 128,00 | 400,00 | 212,00 | 167,00 | 0 | 179,61 |
| 1574,05 | 1,00 | 412,00 | 130,00 | 400,00 | 208,00 | 140,00 | 0 | 284,05 |
| 1214,41 | 1,00 | 341,00 | 200,00 | 231,00 | 65,00 | 140,00 | 0 | 237,41 |
| 1173,04 | 1,00 | 295,00 | 200,00 | 240,00 | 65,00 | 164,00 | 0 | 209,04 |
| 1352,83 | 1,00 | 296,00 | 244,00 | 236,00 | 64,00 | 164,00 | 0 | 348,83 |
| 1633,97 | 1,00 | 676,00 | 268,00 | 263,00 | 64,00 | 116,00 | 0 | 246,97 |
| 2009,16 | 1,00 | 676,00 | 240,00 | 316,00 | 212,00 | 115,00 | 0 | 450,16 |
| 1981,55 | 1,00 | 648,00 | 240,00 | 316,00 | 212,00 | 116,00 | 0 | 449,55 |
| 1973,72 | 1,00 | 493,00 | 236,00 | 316,00 | 204,00 | 120,00 | 0 | 604,72 |
| 2442,14 | 1,00 | 506,00 | 4,00 | 180,00 | 112,00 | 112,00 | 0 | 1528,14 |
| 1438,03 | 1,00 | 508,00 | 11,00 | 384,00 | 112,00 | 88,00 | 0 | 335,03 |
| 1637,06 | 1,00 | 660,00 | 100,00 | 380,00 | 66,00 | 87,00 | 0 | 344,06 |
| 1445,21 | 1,00 | 524,00 | 96,00 | 308,00 | 64,00 | 116,00 | 0 | 337,21 |
| 1334,11 | 1,00 | 340,00 | 96,00 | 364,00 | 88,00 | 116,00 | 0 | 330,11 |
| 1739,42 | 1,00 | 336,00 | 292,00 | 252,00 | 224,00 | 116,00 | 0 | 519,42 |
| 1765,35 | 1,00 | 337,00 | 280,00 | 326,00 | 208,00 | 101,00 | 0 | 513,35 |
| 1909,11 | 1,00 | 576,00 | 280,00 | 176,00 | 208,00 | 120,00 | 0 | 549,11 |
| 1895,30 | 1,00 | 576,00 | 276,00 | 199,00 | 176,00 | 116,00 | 0 | 552,30 |
| 2055,10 | 1,00 | 852,00 | 312,00 | 332,00 | 68,00 | 116,00 | 0 | 375,10 |
| 1678,54 | 1,00 | 656,00 | 272,00 | 228,00 | 67,00 | 96,00 | 0 | 359,54 |
| 2006,98 | 1,00 | 656,00 | 300,00 | 380,00 | 168,00 | 120,00 | 0 | 382,98 |
| 1947,65 | 1,00 | 656,00 | 300,00 | 260,00 | 168,00 | 120,00 | 0 | 443,65 |
| 1975,32 | 1,00 | 652,00 | 264,00 | 260,00 | 216,00 | 116,00 | 0 | 467,32 |
| 2017,81 | 1,00 | 688,00 | 264,00 | 260,00 | 216,00 | 116,00 | 0 | 473,81 |
| 1850,89 | 1,00 | 688,00 | 264,00 | 120,00 | 204,00 | 143,00 | 0 | 431,89 |
| 2281,53 | 1,00 | 928,00 | 264,00 | 324,00 | 140,00 | 160,00 | 0 | 465,53 |
| 1978,40 | 1,00 | 928,00 | 244,00 | 192,00 | 63,00 | 160,00 | 0 | 391,40 |

| | | | | | | | | |
|---|---|---|---|---|---|---|---|---|
| 1472,47 | 1,00 | 420,00 | 288,00 | 192,00 | 64,00 | 160,00 | 0 | 348,47 |
| 1368,53 | 1,00 | 420,00 | 168,00 | 220,00 | 63,00 | 148,00 | 0 | 349,53 |
| 1572,66 | 1,00 | 304,00 | 244,00 | 284,00 | 208,00 | 164,00 | 0 | 368,66 |
| 1699,36 | 1,00 | 404,00 | 256,00 | 293,00 | 212,00 | 160,00 | 0 | 374,36 |
| 1908,51 | 1,00 | 592,00 | 252,00 | 301,00 | 204,00 | 164,00 | 0 | 395,51 |
| 2140,17 | 1,00 | 724,00 | 252,00 | 300,00 | 216,00 | 140,00 | 0 | 508,17 |
| 3215,78 | 1,00 | 1003,00 | 252,00 | 360,00 | 224,00 | 184,00 | 0 | 1192,78 |
| 3036,87 | 1,00 | 1004,00 | 252,00 | 276,00 | 144,00 | 184,00 | 0 | 1176,87 |
| 4587,35 | 1,00 | 2550,00 | 252,00 | 392,00 | 152,00 | 184,00 | 0 | 1057,35 |
| 4688,05 | 1,00 | 2275,00 | 292,00 | 500,00 | 128,00 | 160,00 | 0 | 1333,05 |
| 4899,28 | 1,00 | 2273,00 | 324,00 | 500,00 | 288,00 | 152,00 | 0 | 1362,28 |
| 4861,78 | 1,00 | 2292,00 | 304,00 | 416,00 | 288,00 | 168,00 | 0 | 1393,78 |
| 4140,42 | 1,00 | 1151,00 | 292,00 | 500,00 | 550,00 | 167,00 | 0 | 1480,42 |
| 4833,06 | 1,00 | 1152,00 | 292,00 | 416,00 | 550,00 | 140,00 | 0 | 2283,06 |
| 4072,51 | 1,00 | 716,00 | 316,00 | 416,00 | 544,00 | 140,00 | 0 | 1940,51 |
| 4270,90 | 1,00 | 764,00 | 316,00 | 416,00 | 1306,00 | 160,00 | 0 | 1308,90 |
| 3046,68 | 1,00 | 556,00 | 461,00 | 683,00 | 602,00 | 160,00 | 0 | 584,68 |
| 2907,89 | 1,00 | 556,00 | 520,00 | 664,00 | 595,00 | 97,00 | 0 | 475,89 |
| 3290,87 | 1,00 | 1221,00 | 496,00 | 635,00 | 312,00 | 120,00 | 0 | 506,87 |
| 3286,34 | 1,00 | 1221,00 | 497,00 | 635,00 | 312,00 | 124,00 | 0 | 497,34 |
| 3591,38 | 1,00 | 1464,00 | 464,00 | 624,00 | 388,00 | 124,00 | 0 | 527,38 |
| 3614,51 | 1,00 | 1443,00 | 464,00 | 624,00 | 392,00 | 100,00 | 0 | 591,51 |
| 3196,02 | 1,00 | 1127,00 | 444,00 | 523,00 | 394,00 | 168,00 | 0 | 540,02 |
| 3022,79 | 1,00 | 1127,00 | 379,00 | 511,00 | 372,00 | 171,00 | 0 | 462,79 |
| 2971,06 | 1,00 | 1127,00 | 384,00 | 513,00 | 320,00 | 148,00 | 0 | 479,06 |
| 3327,68 | 1,00 | 1127,00 | 336,00 | 956,00 | 235,00 | 104,00 | 0 | 569,68 |
| 4256,51 | 1,00 | 508,00 | 328,00 | 2446,00 | 232,00 | 105,00 | 0 | 637,51 |
| 1701,24 | 1,00 | 449,00 | 312,00 | 164,00 | 232,00 | 132,00 | 0 | 412,24 |
| 2215,39 | 1,00 | 824,00 | 312,00 | 164,00 | 294,00 | 181,00 | 0 | 440,39 |
| 2214,36 | 1,00 | 856,00 | 312,00 | 196,00 | 168,00 | 187,00 | 0 | 495,36 |
| 1930,01 | 1,00 | 601,00 | 312,00 | 196,00 | 168,00 | 180,00 | 0 | 473,01 |
| 2080,79 | 1,00 | 684,00 | 314,00 | 228,00 | 204,00 | 136,00 | 0 | 514,79 |
| 2172,94 | 1,00 | 716,00 | 316,00 | 268,00 | 268,00 | 132,00 | 0 | 472,94 |
| 1880,76 | 1,00 | 477,00 | 312,00 | 268,00 | 260,00 | 123,00 | 0 | 440,76 |
| 1916,82 | 1,00 | 477,00 | 316,00 | 254,00 | 260,00 | 123,00 | 0 | 486,82 |
| 1317,37 | 1,00 | 268,00 | 316,00 | 121,00 | 84,00 | 92,00 | 0 | 436,37 |
| 1478,14 | 1,00 | 524,00 | 316,00 | 121,00 | 64,00 | 92,00 | 0 | 361,14 |
| 1748,43 | 1,00 | 524,00 | 308,00 | 340,00 | 64,00 | 128,00 | 0 | 384,43 |
| 1493,56 | 1,00 | 468,00 | 311,00 | 192,00 | 64,00 | 120,00 | 0 | 338,56 |
| 1608,36 | 1,00 | 476,00 | 308,00 | 220,00 | 63,00 | 96,00 | 0 | 445,36 |
| 1852,47 | 1,00 | 476,00 | 308,00 | 263,00 | 216,00 | 124,00 | 0 | 465,47 |
| 1763,11 | 1,00 | 477,00 | 308,00 | 264,00 | 208,00 | 116,00 | 0 | 390,11 |
| 1324,82 | 1,00 | 228,00 | 308,00 | 114,00 | 208,00 | 116,00 | 0 | 350,82 |
| 1526,52 | 1,00 | 227,00 | 308,00 | 328,00 | 184,00 | 116,00 | 0 | 363,52 |

| | | | | | | | | |
|---|---|---|---|---|---|---|---|---|
| 1739,88 | 1,00 | 476,00 | 327,00 | 322,00 | 64,00 | 128,00 | 0 | 422,88 |
| 1407,12 | 1,00 | 292,00 | 352,00 | 212,00 | 69,00 | 102,00 | 0 | 380,12 |
| 1443,40 | 1,00 | 292,00 | 388,00 | 213,00 | 65,00 | 104,00 | 0 | 381,40 |
| 1699,25 | 1,00 | 297,00 | 384,00 | 372,00 | 180,00 | 116,00 | 0 | 350,25 |
| 1749,21 | 1,00 | 297,00 | 348,00 | 404,00 | 212,00 | 128,00 | 0 | 360,21 |
| 1612,39 | 1,00 | 352,00 | 308,00 | 201,00 | 204,00 | 124,00 | 0 | 423,39 |
| 1263,24 | 1,00 | 60,00 | 308,00 | 201,00 | 204,00 | 136,00 | 0 | 354,24 |
| 1407,80 | 1,00 | 256,00 | 308,00 | 257,00 | 88,00 | 136,00 | 0 | 362,80 |
| 1305,10 | 1,00 | 257,00 | 190,00 | 198,00 | 63,00 | 216,00 | 0 | 381,10 |
| 1542,65 | 1,00 | 310,00 | 172,00 | 376,00 | 66,00 | 216,00 | 0 | 402,65 |
| 1707,30 | 1,00 | 290,00 | 172,00 | 472,00 | 125,00 | 265,00 | 0 | 383,30 |
| 1649,22 | 1,00 | 283,00 | 139,00 | 472,00 | 212,00 | 168,00 | 0 | 375,22 |
| 1565,77 | 1,00 | 472,00 | 140,00 | 208,00 | 208,00 | 184,00 | 0 | 353,77 |
| 1814,83 | 1,00 | 604,00 | 140,00 | 340,00 | 145,00 | 175,00 | 0 | 410,83 |
| 1955,92 | 1,00 | 492,00 | 276,00 | 340,00 | 145,00 | 272,00 | 0 | 430,92 |
| 1402,58 | 1,00 | 134,00 | 233,00 | 332,00 | 216,00 | 272,00 | 0 | 215,58 |
| 1364,47 | 1,00 | 112,00 | 236,00 | 400,00 | 120,00 | 272,00 | 0 | 224,47 |
| 1363,13 | 1,00 | 112,00 | 221,00 | 472,00 | 220,00 | 124,00 | 0 | 214,13 |
| 1478,94 | 1,00 | 376,00 | 208,00 | 293,00 | 204,00 | 124,00 | 0 | 273,94 |
| 1217,16 | 1,00 | 220,00 | 211,00 | 304,00 | 204,00 | 124,00 | 0 | 154,16 |
| 1111,00 | 1,00 | 177,00 | 197,00 | 304,00 | 65,00 | 160,00 | 0 | 208,00 |
| 1398,31 | 1,00 | 420,00 | 192,00 | 304,00 | 60,00 | 168,00 | 0 | 254,31 |
| 1406,90 | 1,00 | 423,00 | 240,00 | 296,00 | 65,00 | 136,00 | 0 | 246,90 |
| 1098,62 | 1,00 | 136,00 | 240,00 | 296,00 | 64,00 | 164,00 | 0 | 198,62 |
| 1188,12 | 1,00 | 217,00 | 228,00 | 228,00 | 212,00 | 167,00 | 0 | 136,12 |
| 1291,61 | 1,00 | 214,00 | 128,00 | 400,00 | 212,00 | 167,00 | 0 | 170,61 |
| 1577,05 | 1,00 | 412,00 | 130,00 | 400,00 | 208,00 | 140,00 | 0 | 287,05 |
| 1208,41 | 1,00 | 341,00 | 200,00 | 231,00 | 65,00 | 140,00 | 0 | 231,41 |
| 1164,04 | 1,00 | 295,00 | 200,00 | 240,00 | 65,00 | 164,00 | 0 | 200,04 |
| 1353,83 | 1,00 | 296,00 | 244,00 | 236,00 | 64,00 | 164,00 | 0 | 349,83 |
| 1644,27 | 1,00 | 676,00 | 268,00 | 263,00 | 67,00 | 116,00 | 0 | 254,27 |
| 2009,16 | 1,00 | 676,00 | 240,00 | 316,00 | 212,00 | 115,00 | 0 | 450,16 |
| 1980,55 | 1,00 | 648,00 | 240,00 | 316,00 | 212,00 | 116,00 | 0 | 448,55 |
| 1972,72 | 1,00 | 493,00 | 236,00 | 316,00 | 204,00 | 120,00 | 0 | 603,72 |
| 2425,30 | 1,00 | 493,00 | 11,00 | 180,00 | 112,00 | 88,00 | 0 | 1541,30 |
| 1437,03 | 1,00 | 508,00 | 11,00 | 384,00 | 112,00 | 88,00 | 0 | 334,03 |
| 1635,15 | 1,00 | 660,00 | 100,00 | 380,00 | 66,00 | 88,00 | 0 | 341,15 |
| 1446,21 | 1,00 | 524,00 | 96,00 | 308,00 | 64,00 | 116,00 | 0 | 338,21 |
| 1331,11 | 1,00 | 340,00 | 96,00 | 364,00 | 88,00 | 116,00 | 0 | 327,11 |
| 1739,42 | 1,00 | 336,00 | 292,00 | 252,00 | 224,00 | 116,00 | 0 | 519,42 |
| 1765,35 | 1,00 | 337,00 | 280,00 | 326,00 | 208,00 | 101,00 | 0 | 513,35 |
| 1915,11 | 1,00 | 576,00 | 280,00 | 176,00 | 208,00 | 120,00 | 0 | 555,11 |
| 1896,30 | 1,00 | 576,00 | 276,00 | 199,00 | 176,00 | 116,00 | 0 | 553,30 |
| 2062,20 | 1,00 | 852,00 | 313,00 | 332,00 | 68,00 | 116,00 | 0 | 381,20 |

| | | | | | | | | |
|---|---|---|---|---|---|---|---|---|
| 1676,54 | 1,00 | 656,00 | 272,00 | 228,00 | 67,00 | 96,00 | 0 | 357,54 |
| 2010,98 | 1,00 | 656,00 | 300,00 | 380,00 | 168,00 | 120,00 | 0 | 386,98 |
| 1944,36 | 1,00 | 656,00 | 300,00 | 257,00 | 168,00 | 120,00 | 0 | 443,36 |
| 1975,32 | 1,00 | 652,00 | 264,00 | 260,00 | 216,00 | 116,00 | 0 | 467,32 |
| 1979,32 | 1,00 | 652,00 | 264,00 | 260,00 | 216,00 | 116,00 | 0 | 471,32 |
| 1851,89 | 1,00 | 688,00 | 264,00 | 120,00 | 204,00 | 143,00 | 0 | 432,89 |
| 2279,34 | 1,00 | 926,00 | 264,00 | 324,00 | 140,00 | 160,00 | 0 | 465,34 |
| 1977,40 | 1,00 | 928,00 | 244,00 | 192,00 | 63,00 | 160,00 | 0 | 390,40 |
| 1468,47 | 1,00 | 420,00 | 288,00 | 192,00 | 64,00 | 160,00 | 0 | 344,47 |
| 1439,58 | 1,00 | 420,00 | 168,00 | 284,00 | 63,00 | 148,00 | 0 | 356,58 |
| 1574,66 | 1,00 | 304,00 | 244,00 | 284,00 | 208,00 | 164,00 | 0 | 370,66 |
| 1703,27 | 1,00 | 403,00 | 256,00 | 293,00 | 212,00 | 160,00 | 0 | 379,27 |
| 1904,51 | 1,00 | 592,00 | 252,00 | 301,00 | 204,00 | 164,00 | 0 | 391,51 |
| 2141,17 | 1,00 | 724,00 | 252,00 | 300,00 | 216,00 | 140,00 | 0 | 509,17 |
| 3220,78 | 1,00 | 1003,00 | 252,00 | 360,00 | 224,00 | 184,00 | 0 | 1197,78 |
| 3024,05 | 1,00 | 1004,00 | 252,00 | 276,00 | 144,00 | 186,00 | 0 | 1162,05 |
| 4592,35 | 1,00 | 2550,00 | 252,00 | 392,00 | 152,00 | 184,00 | 0 | 1062,35 |
| 4688,05 | 1,00 | 2275,00 | 292,00 | 500,00 | 128,00 | 160,00 | 0 | 1333,05 |
| 4922,28 | 1,00 | 2273,00 | 324,00 | 500,00 | 288,00 | 152,00 | 0 | 1385,28 |
| 5122,54 | 1,00 | 2284,00 | 304,00 | 416,00 | 551,00 | 168,00 | 0 | 1399,54 |
| 4136,42 | 1,00 | 1151,00 | 292,00 | 500,00 | 550,00 | 167,00 | 0 | 1476,42 |
| 4855,86 | 1,00 | 1152,00 | 292,00 | 416,00 | 548,00 | 140,00 | 0 | 2307,86 |
| 4091,51 | 1,00 | 716,00 | 316,00 | 416,00 | 544,00 | 140,00 | 0 | 1959,51 |
| 4278,90 | 1,00 | 764,00 | 316,00 | 416,00 | 1306,00 | 160,00 | 0 | 1316,90 |
| 3047,68 | 1,00 | 556,00 | 461,00 | 683,00 | 602,00 | 160,00 | 0 | 585,68 |
| 2903,89 | 1,00 | 556,00 | 520,00 | 664,00 | 595,00 | 97,00 | 0 | 471,89 |
| 3285,87 | 1,00 | 1221,00 | 496,00 | 635,00 | 312,00 | 120,00 | 0 | 501,87 |
| 3287,34 | 1,00 | 1221,00 | 497,00 | 635,00 | 312,00 | 124,00 | 0 | 498,34 |
| 3595,38 | 1,00 | 1464,00 | 464,00 | 624,00 | 388,00 | 124,00 | 0 | 531,38 |
| 3503,87 | 1,00 | 1442,00 | 464,00 | 523,00 | 392,00 | 100,00 | 0 | 582,87 |
| 3215,91 | 1,00 | 1127,00 | 464,00 | 523,00 | 394,00 | 168,00 | 0 | 539,91 |
| 3022,79 | 1,00 | 1127,00 | 379,00 | 511,00 | 372,00 | 171,00 | 0 | 462,79 |
| 2973,25 | 1,00 | 1127,00 | 384,00 | 515,00 | 320,00 | 148,00 | 0 | 479,25 |
| 3328,78 | 1,00 | 1128,00 | 336,00 | 956,00 | 235,00 | 104,00 | 0 | 569,78 |
| 4256,51 | 1,00 | 508,00 | 328,00 | 2446,00 | 232,00 | 105,00 | 0 | 637,51 |
| 1701,24 | 1,00 | 449,00 | 312,00 | 164,00 | 232,00 | 132,00 | 0 | 412,24 |
| 2253,49 | 1,00 | 856,00 | 312,00 | 164,00 | 294,00 | 181,00 | 0 | 446,49 |
| 2215,46 | 1,00 | 856,00 | 312,00 | 196,00 | 169,00 | 187,00 | 0 | 495,46 |
| 1929,01 | 1,00 | 601,00 | 312,00 | 196,00 | 168,00 | 180,00 | 0 | 472,01 |
| 2080,79 | 1,00 | 684,00 | 314,00 | 228,00 | 204,00 | 136,00 | 0 | 514,79 |
| 2174,94 | 1,00 | 716,00 | 316,00 | 268,00 | 268,00 | 132,00 | 0 | 474,94 |
| 1878,76 | 1,00 | 477,00 | 312,00 | 268,00 | 260,00 | 123,00 | 0 | 438,76 |
| 1917,82 | 1,00 | 477,00 | 316,00 | 254,00 | 260,00 | 123,00 | 0 | 487,82 |
| 1510,12 | 1,00 | 268,00 | 316,00 | 121,00 | 260,00 | 92,00 | 0 | 453,12 |

| | | | | | | | | |
|---|---|---|---|---|---|---|---|---|
| 1482,14 | 1,00 | 524,00 | 316,00 | 121,00 | 64,00 | 92,00 | 0 | 365,14 |
| 1748,43 | 1,00 | 524,00 | 308,00 | 340,00 | 64,00 | 128,00 | 0 | 384,43 |
| 1569,84 | 1,00 | 524,00 | 311,00 | 201,00 | 64,00 | 120,00 | 0 | 349,84 |
| 1609,36 | 1,00 | 476,00 | 308,00 | 220,00 | 63,00 | 96,00 | 0 | 446,36 |
| 1854,57 | 1,00 | 477,00 | 308,00 | 263,00 | 216,00 | 124,00 | 0 | 466,57 |
| 1762,20 | 1,00 | 477,00 | 308,00 | 265,00 | 208,00 | 116,00 | 0 | 388,20 |
| 1325,82 | 1,00 | 228,00 | 308,00 | 114,00 | 208,00 | 116,00 | 0 | 351,82 |
| 1525,52 | 1,00 | 227,00 | 308,00 | 328,00 | 184,00 | 116,00 | 0 | 362,52 |
| 1722,88 | 1,00 | 476,00 | 327,00 | 322,00 | 64,00 | 128,00 | 0 | 405,88 |
| 1404,12 | 1,00 | 292,00 | 352,00 | 212,00 | 69,00 | 102,00 | 0 | 377,12 |
| 1618,42 | 1,00 | 292,00 | 388,00 | 372,00 | 65,00 | 104,00 | 0 | 397,42 |
| 1697,25 | 1,00 | 297,00 | 384,00 | 372,00 | 180,00 | 116,00 | 0 | 348,25 |
| 1753,21 | 1,00 | 297,00 | 348,00 | 404,00 | 212,00 | 128,00 | 0 | 364,21 |
| 1291,12 | 1,00 | 60,00 | 308,00 | 201,00 | 204,00 | 124,00 | 0 | 394,12 |
| 1265,24 | 1,00 | 60,00 | 308,00 | 201,00 | 204,00 | 136,00 | 0 | 356,24 |
| 1404,80 | 1,00 | 256,00 | 308,00 | 257,00 | 88,00 | 136,00 | 0 | 359,80 |
| 1307,10 | 1,00 | 257,00 | 190,00 | 198,00 | 63,00 | 216,00 | 0 | 383,10 |
| 1540,65 | 1,00 | 310,00 | 172,00 | 376,00 | 66,00 | 216,00 | 0 | 400,65 |
| 1706,30 | 1,00 | 290,00 | 172,00 | 472,00 | 125,00 | 265,00 | 0 | 382,30 |
| 1651,22 | 1,00 | 283,00 | 139,00 | 472,00 | 212,00 | 168,00 | 0 | 377,22 |
| 1709,56 | 1,00 | 604,00 | 140,00 | 208,00 | 208,00 | 184,00 | 0 | 365,56 |
| 1813,83 | 1,00 | 604,00 | 140,00 | 340,00 | 145,00 | 175,00 | 0 | 409,83 |
| 1805,04 | 1,00 | 492,00 | 140,00 | 340,00 | 145,00 | 272,00 | 0 | 416,04 |
| 1393,58 | 1,00 | 134,00 | 233,00 | 332,00 | 216,00 | 272,00 | 0 | 206,58 |
| 1366,38 | 1,00 | 112,00 | 236,00 | 400,00 | 120,00 | 271,00 | 0 | 227,38 |
| 1360,13 | 1,00 | 112,00 | 221,00 | 472,00 | 220,00 | 124,00 | 0 | 211,13 |
| 1484,94 | 1,00 | 376,00 | 208,00 | 293,00 | 204,00 | 124,00 | 0 | 279,94 |
| 1225,16 | 1,00 | 220,00 | 211,00 | 304,00 | 204,00 | 124,00 | 0 | 162,16 |
| 1112,00 | 1,00 | 177,00 | 197,00 | 304,00 | 65,00 | 160,00 | 0 | 209,00 |
| 1405,31 | 1,00 | 420,00 | 192,00 | 304,00 | 60,00 | 168,00 | 0 | 261,31 |
| 1415,06 | 1,00 | 435,00 | 240,00 | 296,00 | 65,00 | 136,00 | 0 | 243,06 |
| 1023,72 | 1,00 | 136,00 | 240,00 | 296,00 | 65,00 | 164,00 | 0 | 122,72 |
| 1268,25 | 1,00 | 214,00 | 228,00 | 296,00 | 212,00 | 167,00 | 0 | 151,25 |
| 1510,88 | 1,00 | 413,00 | 128,00 | 400,00 | 212,00 | 167,00 | 0 | 190,88 |
| 1576,45 | 1,00 | 412,00 | 130,00 | 400,00 | 212,00 | 140,00 | 0 | 282,45 |
| 1200,41 | 1,00 | 341,00 | 200,00 | 231,00 | 65,00 | 140,00 | 0 | 223,41 |
| 1163,04 | 1,00 | 295,00 | 200,00 | 240,00 | 65,00 | 164,00 | 0 | 199,04 |
| 1771,63 | 1,00 | 676,00 | 244,00 | 236,00 | 64,00 | 164,00 | 0 | 387,63 |
| 1640,27 | 1,00 | 676,00 | 268,00 | 263,00 | 67,00 | 116,00 | 0 | 250,27 |
| 2010,26 | 1,00 | 676,00 | 240,00 | 316,00 | 212,00 | 116,00 | 0 | 450,26 |
| 1979,55 | 1,00 | 648,00 | 240,00 | 316,00 | 212,00 | 116,00 | 0 | 447,55 |
| 1728,32 | 1,00 | 492,00 | 11,00 | 316,00 | 204,00 | 120,00 | 0 | 585,32 |
| 2455,30 | 1,00 | 493,00 | 11,00 | 180,00 | 112,00 | 88,00 | 0 | 1571,30 |
| 1430,93 | 1,00 | 507,00 | 11,00 | 384,00 | 112,00 | 88,00 | 0 | 328,93 |

| | | | | | | | | |
|---|---|---|---|---|---|---|---|---|
| 1636,34 | 1,00 | 660,00 | 100,00 | 380,00 | 66,00 | 90,00 | 0 | 340,34 |
| 1451,59 | 1,00 | 524,00 | 100,00 | 308,00 | 64,00 | 116,00 | 0 | 339,59 |
| 1331,11 | 1,00 | 340,00 | 96,00 | 364,00 | 88,00 | 116,00 | 0 | 327,11 |
| 1739,42 | 1,00 | 336,00 | 292,00 | 252,00 | 224,00 | 116,00 | 0 | 519,42 |
| 1765,35 | 1,00 | 337,00 | 280,00 | 326,00 | 208,00 | 101,00 | 0 | 513,35 |
| 1915,11 | 1,00 | 576,00 | 280,00 | 176,00 | 208,00 | 120,00 | 0 | 555,11 |
| 1897,20 | 1,00 | 576,00 | 276,00 | 199,00 | 176,00 | 115,00 | 0 | 555,20 |
| 2056,20 | 1,00 | 852,00 | 313,00 | 332,00 | 68,00 | 116,00 | 0 | 375,20 |
| 2238,81 | 1,00 | 656,00 | 272,00 | 740,00 | 67,00 | 95,00 | 0 | 408,81 |
| 1896,79 | 1,00 | 656,00 | 300,00 | 380,00 | 67,00 | 120,00 | 0 | 373,79 |
| 1941,36 | 1,00 | 656,00 | 300,00 | 257,00 | 168,00 | 120,00 | 0 | 440,36 |
| 1978,71 | 1,00 | 656,00 | 264,00 | 260,00 | 216,00 | 116,00 | 0 | 466,71 |
| 1978,32 | 1,00 | 652,00 | 264,00 | 260,00 | 216,00 | 116,00 | 0 | 470,32 |
| 1853,89 | 1,00 | 688,00 | 264,00 | 120,00 | 204,00 | 143,00 | 0 | 434,89 |
| 2281,34 | 1,00 | 926,00 | 264,00 | 324,00 | 140,00 | 160,00 | 0 | 467,34 |
| 1979,40 | 1,00 | 928,00 | 244,00 | 192,00 | 63,00 | 160,00 | 0 | 392,40 |
| 1470,47 | 1,00 | 420,00 | 288,00 | 192,00 | 64,00 | 160,00 | 0 | 346,47 |
| 1442,58 | 1,00 | 420,00 | 168,00 | 284,00 | 63,00 | 148,00 | 0 | 359,58 |
| 1574,66 | 1,00 | 304,00 | 244,00 | 284,00 | 208,00 | 164,00 | 0 | 370,66 |
| 1699,27 | 1,00 | 403,00 | 256,00 | 293,00 | 212,00 | 160,00 | 0 | 375,27 |
| 1874,27 | 1,00 | 592,00 | 252,00 | 301,00 | 204,00 | 140,00 | 0 | 385,27 |
| 2141,17 | 1,00 | 724,00 | 252,00 | 300,00 | 216,00 | 140,00 | 0 | 509,17 |
| 2927,76 | 1,00 | 724,00 | 252,00 | 360,00 | 224,00 | 184,00 | 0 | 1183,76 |
| 3016,96 | 1,00 | 1003,00 | 252,00 | 276,00 | 144,00 | 186,00 | 0 | 1155,96 |
| 4584,35 | 1,00 | 2550,00 | 252,00 | 392,00 | 152,00 | 184,00 | 0 | 1054,35 |
| 4673,05 | 1,00 | 2275,00 | 292,00 | 500,00 | 128,00 | 160,00 | 0 | 1318,05 |
| 4928,28 | 1,00 | 2273,00 | 324,00 | 500,00 | 288,00 | 152,00 | 0 | 1391,28 |
| 5121,54 | 1,00 | 2284,00 | 304,00 | 416,00 | 551,00 | 168,00 | 0 | 1398,54 |
| 4106,42 | 1,00 | 1151,00 | 292,00 | 500,00 | 550,00 | 167,00 | 0 | 1446,42 |
| 4865,14 | 1,00 | 1152,00 | 316,00 | 416,00 | 548,00 | 140,00 | 0 | 2293,14 |
| 3360,38 | 1,00 | 725,00 | 316,00 | 416,00 | 544,00 | 140,00 | 0 | 1219,38 |
| 4282,80 | 1,00 | 764,00 | 316,00 | 416,00 | 1305,00 | 160,00 | 0 | 1321,80 |
| 3048,78 | 1,00 | 556,00 | 461,00 | 684,00 | 602,00 | 160,00 | 0 | 585,78 |
| 2906,89 | 1,00 | 556,00 | 520,00 | 664,00 | 595,00 | 97,00 | 0 | 474,89 |
| 3281,87 | 1,00 | 1221,00 | 496,00 | 635,00 | 312,00 | 120,00 | 0 | 497,87 |
| 3284,34 | 1,00 | 1221,00 | 497,00 | 635,00 | 312,00 | 124,00 | 0 | 495,34 |
| 3603,42 | 1,00 | 1464,00 | 464,00 | 635,00 | 388,00 | 124,00 | 0 | 528,42 |
| 3503,87 | 1,00 | 1442,00 | 464,00 | 523,00 | 392,00 | 100,00 | 0 | 582,87 |
| 3149,81 | 1,00 | 1127,00 | 464,00 | 523,00 | 393,00 | 168,00 | 0 | 474,81 |
| 3025,79 | 1,00 | 1127,00 | 379,00 | 511,00 | 372,00 | 171,00 | 0 | 465,79 |
| 2972,25 | 1,00 | 1127,00 | 384,00 | 515,00 | 320,00 | 148,00 | 0 | 478,25 |
| 3328,58 | 1,00 | 1127,00 | 336,00 | 955,00 | 235,00 | 104,00 | 0 | 571,58 |
| 4253,42 | 1,00 | 508,00 | 328,00 | 2445,00 | 232,00 | 105,00 | 0 | 635,42 |
| 1699,24 | 1,00 | 449,00 | 312,00 | 164,00 | 232,00 | 132,00 | 0 | 410,24 |

| | | | | | | | | |
|---|---|---|---|---|---|---|---|---|
| 2250,39 | 1,00 | 856,00 | 312,00 | 163,00 | 294,00 | 181,00 | 0 | 444,39 |
| 2214,46 | 1,00 | 856,00 | 312,00 | 196,00 | 169,00 | 187,00 | 0 | 494,46 |
| 1928,01 | 1,00 | 601,00 | 312,00 | 196,00 | 168,00 | 180,00 | 0 | 471,01 |
| 2080,79 | 1,00 | 684,00 | 314,00 | 228,00 | 204,00 | 136,00 | 0 | 514,79 |
| 2139,93 | 1,00 | 684,00 | 316,00 | 269,00 | 268,00 | 132,00 | 0 | 470,93 |
| 1878,76 | 1,00 | 477,00 | 312,00 | 268,00 | 260,00 | 123,00 | 0 | 438,76 |
| 1920,01 | 1,00 | 477,00 | 316,00 | 254,00 | 260,00 | 125,00 | 0 | 488,01 |
| 1510,12 | 1,00 | 268,00 | 316,00 | 121,00 | 260,00 | 92,00 | 0 | 453,12 |
| 1484,52 | 1,00 | 524,00 | 316,00 | 125,00 | 64,00 | 92,00 | 0 | 363,52 |
| 1749,43 | 1,00 | 524,00 | 308,00 | 340,00 | 64,00 | 128,00 | 0 | 385,43 |
| 1564,84 | 1,00 | 524,00 | 311,00 | 201,00 | 64,00 | 120,00 | 0 | 344,84 |
| 1608,36 | 1,00 | 476,00 | 308,00 | 220,00 | 63,00 | 96,00 | 0 | 445,36 |
| 1854,57 | 1,00 | 477,00 | 308,00 | 263,00 | 216,00 | 124,00 | 0 | 466,57 |
| 1761,20 | 1,00 | 477,00 | 308,00 | 265,00 | 208,00 | 116,00 | 0 | 387,20 |
| 1325,73 | 1,00 | 228,00 | 308,00 | 113,00 | 208,00 | 116,00 | 0 | 352,73 |
| 1524,52 | 1,00 | 227,00 | 308,00 | 328,00 | 184,00 | 116,00 | 0 | 361,52 |
| 1719,88 | 1,00 | 476,00 | 327,00 | 322,00 | 64,00 | 128,00 | 0 | 402,88 |
| 1405,12 | 1,00 | 292,00 | 352,00 | 212,00 | 69,00 | 102,00 | 0 | 378,12 |
| 1622,91 | 1,00 | 297,00 | 388,00 | 372,00 | 65,00 | 104,00 | 0 | 396,91 |
| 1714,25 | 1,00 | 297,00 | 384,00 | 372,00 | 180,00 | 116,00 | 0 | 365,25 |
| 1748,21 | 1,00 | 297,00 | 348,00 | 404,00 | 212,00 | 128,00 | 0 | 359,21 |
| 1290,12 | 1,00 | 60,00 | 308,00 | 201,00 | 204,00 | 124,00 | 0 | 393,12 |
| 1265,24 | 1,00 | 60,00 | 308,00 | 201,00 | 204,00 | 136,00 | 0 | 356,24 |
| 1403,80 | 1,00 | 256,00 | 308,00 | 257,00 | 88,00 | 136,00 | 0 | 358,80 |
| 1306,01 | 1,00 | 257,00 | 190,00 | 197,00 | 63,00 | 216,00 | 0 | 383,01 |
| 1540,65 | 1,00 | 310,00 | 172,00 | 376,00 | 66,00 | 216,00 | 0 | 400,65 |
| 1637,35 | 1,00 | 290,00 | 172,00 | 472,00 | 66,00 | 265,00 | 0 | 372,35 |
| 1654,22 | 1,00 | 283,00 | 139,00 | 472,00 | 212,00 | 168,00 | 0 | 380,22 |
| 1708,56 | 1,00 | 604,00 | 140,00 | 208,00 | 208,00 | 184,00 | 0 | 364,56 |
| 1812,83 | 1,00 | 604,00 | 140,00 | 340,00 | 145,00 | 175,00 | 0 | 408,83 |
| 1806,23 | 1,00 | 492,00 | 140,00 | 340,00 | 145,00 | 274,00 | 0 | 415,23 |
| 1412,58 | 1,00 | 134,00 | 233,00 | 332,00 | 216,00 | 272,00 | 0 | 225,58 |
| 1449,18 | 1,00 | 112,00 | 236,00 | 472,00 | 120,00 | 271,00 | 0 | 238,18 |
| 1352,13 | 1,00 | 112,00 | 221,00 | 472,00 | 220,00 | 124,00 | 0 | 203,13 |
| 1488,94 | 1,00 | 376,00 | 208,00 | 293,00 | 204,00 | 124,00 | 0 | 283,94 |
| 1219,16 | 1,00 | 220,00 | 211,00 | 304,00 | 204,00 | 124,00 | 0 | 156,16 |
| 1108,00 | 1,00 | 177,00 | 197,00 | 304,00 | 65,00 | 160,00 | 0 | 205,00 |
| 1400,31 | 1,00 | 420,00 | 192,00 | 304,00 | 60,00 | 168,00 | 0 | 256,31 |
| 1410,06 | 1,00 | 435,00 | 240,00 | 296,00 | 65,00 | 136,00 | 0 | 238,06 |
| 1000,81 | 1,00 | 129,00 | 228,00 | 295,00 | 65,00 | 164,00 | 0 | 119,81 |
| 1266,15 | 1,00 | 213,00 | 228,00 | 296,00 | 212,00 | 167,00 | 0 | 150,15 |
| 1509,97 | 1,00 | 413,00 | 128,00 | 400,00 | 212,00 | 168,00 | 0 | 188,97 |
| 1655,08 | 1,00 | 412,00 | 200,00 | 400,00 | 212,00 | 140,00 | 0 | 291,08 |
| 1270,28 | 1,00 | 412,00 | 200,00 | 231,00 | 65,00 | 140,00 | 0 | 222,28 |

| | | | | | | | | |
|---|---|---|---|---|---|---|---|---|
| 1160,94 | 1,00 | 295,00 | 200,00 | 240,00 | 64,00 | 164,00 | 0 | 197,94 |
| 1774,63 | 1,00 | 676,00 | 244,00 | 236,00 | 64,00 | 164,00 | 0 | 390,63 |
| 1690,75 | 1,00 | 676,00 | 268,00 | 263,00 | 67,00 | 164,00 | 0 | 252,75 |
| 2008,26 | 1,00 | 676,00 | 240,00 | 316,00 | 212,00 | 116,00 | 0 | 448,26 |
| 1978,45 | 1,00 | 648,00 | 239,00 | 316,00 | 212,00 | 116,00 | 0 | 447,45 |
| 1725,32 | 1,00 | 492,00 | 11,00 | 316,00 | 204,00 | 120,00 | 0 | 582,32 |
| 2448,30 | 1,00 | 493,00 | 11,00 | 180,00 | 112,00 | 88,00 | 0 | 1564,30 |
| 1435,93 | 1,00 | 507,00 | 11,00 | 384,00 | 112,00 | 88,00 | 0 | 333,93 |
| 1633,34 | 1,00 | 660,00 | 100,00 | 380,00 | 66,00 | 90,00 | 0 | 337,34 |
| 1455,59 | 1,00 | 524,00 | 100,00 | 308,00 | 64,00 | 116,00 | 0 | 343,59 |
| 1332,92 | 1,00 | 340,00 | 96,00 | 362,00 | 88,00 | 116,00 | 0 | 330,92 |
| 1739,42 | 1,00 | 336,00 | 292,00 | 252,00 | 224,00 | 116,00 | 0 | 519,42 |
| 1765,35 | 1,00 | 337,00 | 280,00 | 326,00 | 208,00 | 101,00 | 0 | 513,35 |
| 1916,11 | 1,00 | 576,00 | 280,00 | 176,00 | 208,00 | 120,00 | 0 | 556,11 |
| 1897,20 | 1,00 | 576,00 | 276,00 | 199,00 | 176,00 | 115,00 | 0 | 555,20 |
| 2055,22 | 1,00 | 656,00 | 313,00 | 332,00 | 68,00 | 116,00 | 0 | 570,22 |
| 2234,81 | 1,00 | 656,00 | 272,00 | 740,00 | 67,00 | 95,00 | 0 | 404,81 |
| 1907,80 | 1,00 | 656,00 | 300,00 | 380,00 | 77,00 | 120,00 | 0 | 374,80 |
| 1999,49 | 1,00 | 656,00 | 300,00 | 260,00 | 216,00 | 120,00 | 0 | 447,49 |
| 1980,71 | 1,00 | 656,00 | 264,00 | 260,00 | 216,00 | 116,00 | 0 | 468,71 |
| 1979,32 | 1,00 | 652,00 | 264,00 | 260,00 | 216,00 | 116,00 | 0 | 471,32 |
| 1855,89 | 1,00 | 688,00 | 264,00 | 120,00 | 204,00 | 143,00 | 0 | 436,89 |
| 2281,34 | 1,00 | 926,00 | 264,00 | 324,00 | 140,00 | 160,00 | 0 | 467,34 |
| 2027,57 | 1,00 | 928,00 | 288,00 | 192,00 | 63,00 | 160,00 | 0 | 396,57 |
| 1474,37 | 1,00 | 420,00 | 288,00 | 192,00 | 63,00 | 160,00 | 0 | 351,37 |
| 1440,38 | 1,00 | 420,00 | 168,00 | 284,00 | 61,00 | 148,00 | 0 | 359,38 |
| 1560,17 | 1,00 | 304,00 | 244,00 | 284,00 | 208,00 | 148,00 | 0 | 372,17 |
| 1697,79 | 1,00 | 403,00 | 256,00 | 284,00 | 212,00 | 164,00 | 0 | 378,79 |
| 1868,90 | 1,00 | 592,00 | 256,00 | 293,00 | 204,00 | 140,00 | 0 | 383,90 |
| 2141,17 | 1,00 | 724,00 | 252,00 | 300,00 | 216,00 | 140,00 | 0 | 509,17 |
| 2914,95 | 1,00 | 724,00 | 252,00 | 360,00 | 216,00 | 184,00 | 0 | 1178,95 |
| 3019,96 | 1,00 | 1003,00 | 252,00 | 276,00 | 144,00 | 186,00 | 0 | 1158,96 |
| 4573,35 | 1,00 | 2550,00 | 252,00 | 392,00 | 152,00 | 184,00 | 0 | 1043,35 |
| 4677,24 | 1,00 | 2277,00 | 292,00 | 500,00 | 128,00 | 160,00 | 0 | 1320,24 |
| 4909,38 | 1,00 | 2274,00 | 324,00 | 500,00 | 288,00 | 152,00 | 0 | 1371,38 |
| 5134,54 | 1,00 | 2284,00 | 304,00 | 416,00 | 551,00 | 168,00 | 0 | 1411,54 |
| 4120,42 | 1,00 | 1151,00 | 292,00 | 500,00 | 550,00 | 167,00 | 0 | 1460,42 |
| 4890,14 | 1,00 | 1152,00 | 316,00 | 416,00 | 548,00 | 140,00 | 0 | 2318,14 |
| 3378,28 | 1,00 | 725,00 | 316,00 | 416,00 | 543,00 | 140,00 | 0 | 1238,28 |
| 4293,90 | 1,00 | 764,00 | 316,00 | 416,00 | 1306,00 | 160,00 | 0 | 1331,90 |
| 3050,96 | 1,00 | 556,00 | 463,00 | 684,00 | 602,00 | 160,00 | 0 | 585,96 |
| 2919,73 | 1,00 | 556,00 | 520,00 | 664,00 | 595,00 | 106,00 | 0 | 478,73 |
| 3308,14 | 1,00 | 1221,00 | 520,00 | 635,00 | 312,00 | 120,00 | 0 | 500,14 |
| 3290,44 | 1,00 | 1221,00 | 497,00 | 635,00 | 313,00 | 124,00 | 0 | 500,44 |

| | | | | | | | | |
|---|---|---|---|---|---|---|---|---|
| 3601,32 | 1,00 | 1464,00 | 464,00 | 634,00 | 388,00 | 124,00 | 0 | 527,32 |
| 3508,26 | 1,00 | 1446,00 | 464,00 | 523,00 | 392,00 | 100,00 | 0 | 583,26 |
| 3154,81 | 1,00 | 1127,00 | 464,00 | 523,00 | 393,00 | 168,00 | 0 | 479,81 |
| 3024,79 | 1,00 | 1127,00 | 379,00 | 511,00 | 372,00 | 171,00 | 0 | 464,79 |
| 2971,25 | 1,00 | 1127,00 | 384,00 | 515,00 | 320,00 | 148,00 | 0 | 477,25 |
| 3329,58 | 1,00 | 1127,00 | 336,00 | 955,00 | 235,00 | 104,00 | 0 | 572,58 |
| 4250,23 | 1,00 | 508,00 | 328,00 | 2443,00 | 232,00 | 105,00 | 0 | 634,23 |
| 1700,24 | 1,00 | 449,00 | 312,00 | 164,00 | 232,00 | 132,00 | 0 | 411,24 |
| 2252,39 | 1,00 | 856,00 | 312,00 | 163,00 | 294,00 | 181,00 | 0 | 446,39 |
| 2213,27 | 1,00 | 856,00 | 312,00 | 194,00 | 169,00 | 187,00 | 0 | 495,27 |
| 1929,20 | 1,00 | 601,00 | 312,00 | 198,00 | 168,00 | 180,00 | 0 | 470,20 |
| 2008,15 | 1,00 | 684,00 | 314,00 | 228,00 | 168,00 | 136,00 | 0 | 478,15 |
| 2138,93 | 1,00 | 684,00 | 316,00 | 269,00 | 268,00 | 132,00 | 0 | 469,93 |
| 1878,76 | 1,00 | 477,00 | 312,00 | 268,00 | 260,00 | 123,00 | 0 | 438,76 |
| 1886,13 | 1,00 | 477,00 | 316,00 | 254,00 | 262,00 | 92,00 | 0 | 485,13 |
| 1510,12 | 1,00 | 268,00 | 316,00 | 121,00 | 260,00 | 92,00 | 0 | 453,12 |
| 1487,52 | 1,00 | 524,00 | 316,00 | 125,00 | 64,00 | 92,00 | 0 | 366,52 |
| 1751,43 | 1,00 | 524,00 | 308,00 | 340,00 | 64,00 | 128,00 | 0 | 387,43 |
| 1575,59 | 1,00 | 524,00 | 311,00 | 201,00 | 64,00 | 128,00 | 0 | 347,59 |
| 1608,36 | 1,00 | 476,00 | 308,00 | 220,00 | 63,00 | 96,00 | 0 | 445,36 |
| 1853,57 | 1,00 | 477,00 | 308,00 | 263,00 | 216,00 | 124,00 | 0 | 465,57 |
| 1764,20 | 1,00 | 477,00 | 308,00 | 265,00 | 208,00 | 116,00 | 0 | 390,20 |
| 1321,73 | 1,00 | 228,00 | 308,00 | 113,00 | 208,00 | 116,00 | 0 | 348,73 |
| 1521,52 | 1,00 | 227,00 | 308,00 | 328,00 | 184,00 | 116,00 | 0 | 358,52 |
| 1728,07 | 1,00 | 476,00 | 327,00 | 322,00 | 64,00 | 130,00 | 0 | 409,07 |
| 1404,12 | 1,00 | 292,00 | 352,00 | 212,00 | 69,00 | 102,00 | 0 | 377,12 |
| 1621,62 | 1,00 | 298,00 | 384,00 | 372,00 | 65,00 | 104,00 | 0 | 398,62 |
| 1713,25 | 1,00 | 297,00 | 384,00 | 372,00 | 180,00 | 116,00 | 0 | 364,25 |
| 1751,21 | 1,00 | 297,00 | 348,00 | 404,00 | 212,00 | 128,00 | 0 | 362,21 |
| 1289,12 | 1,00 | 60,00 | 308,00 | 201,00 | 204,00 | 124,00 | 0 | 392,12 |
| 1264,24 | 1,00 | 60,00 | 308,00 | 201,00 | 204,00 | 136,00 | 0 | 355,24 |
| 1399,80 | 1,00 | 256,00 | 308,00 | 257,00 | 88,00 | 136,00 | 0 | 354,80 |
| 1309,01 | 1,00 | 257,00 | 190,00 | 197,00 | 63,00 | 216,00 | 0 | 386,01 |
| 1554,95 | 1,00 | 310,00 | 189,00 | 376,00 | 63,00 | 216,00 | 0 | 400,95 |
| 1641,35 | 1,00 | 290,00 | 172,00 | 472,00 | 66,00 | 265,00 | 0 | 376,35 |
| 1654,22 | 1,00 | 283,00 | 139,00 | 472,00 | 212,00 | 168,00 | 0 | 380,22 |
| 1706,56 | 1,00 | 604,00 | 140,00 | 208,00 | 208,00 | 184,00 | 0 | 362,56 |
| 1809,83 | 1,00 | 604,00 | 140,00 | 340,00 | 145,00 | 175,00 | 0 | 405,83 |
| 1808,23 | 1,00 | 492,00 | 140,00 | 340,00 | 145,00 | 274,00 | 0 | 417,23 |
| 1406,10 | 1,00 | 129,00 | 233,00 | 332,00 | 216,00 | 272,00 | 0 | 224,10 |
| 1450,90 | 1,00 | 112,00 | 233,00 | 472,00 | 120,00 | 271,00 | 0 | 242,90 |
| 1358,13 | 1,00 | 112,00 | 221,00 | 472,00 | 220,00 | 124,00 | 0 | 209,13 |
| 1491,94 | 1,00 | 376,00 | 208,00 | 293,00 | 204,00 | 124,00 | 0 | 286,94 |
| 1230,16 | 1,00 | 220,00 | 211,00 | 304,00 | 204,00 | 124,00 | 0 | 167,16 |

| | | | | | | | | |
|---|---|---|---|---|---|---|---|---|
| 1114,00 | 1,00 | 177,00 | 197,00 | 304,00 | 65,00 | 160,00 | 0 | 211,00 |
| 1394,31 | 1,00 | 420,00 | 192,00 | 304,00 | 60,00 | 168,00 | 0 | 250,31 |
| 1406,06 | 1,00 | 435,00 | 240,00 | 296,00 | 65,00 | 136,00 | 0 | 234,06 |
| 1006,91 | 1,00 | 130,00 | 228,00 | 295,00 | 65,00 | 164,00 | 0 | 124,91 |
| 1274,15 | 1,00 | 213,00 | 228,00 | 296,00 | 212,00 | 167,00 | 0 | 158,15 |
| 1519,07 | 1,00 | 413,00 | 129,00 | 400,00 | 212,00 | 168,00 | 0 | 197,07 |
| 1651,08 | 1,00 | 412,00 | 200,00 | 400,00 | 212,00 | 140,00 | 0 | 287,08 |
| 1300,62 | 1,00 | 412,00 | 200,00 | 232,00 | 65,00 | 164,00 | 0 | 227,62 |
| 1563,69 | 1,00 | 676,00 | 200,00 | 241,00 | 64,00 | 140,00 | 0 | 242,69 |
| 1775,63 | 1,00 | 676,00 | 244,00 | 236,00 | 64,00 | 164,00 | 0 | 391,63 |
| 1690,75 | 1,00 | 676,00 | 268,00 | 263,00 | 67,00 | 164,00 | 0 | 252,75 |
| 2008,06 | 1,00 | 674,00 | 240,00 | 316,00 | 212,00 | 116,00 | 0 | 450,06 |
| 1806,34 | 1,00 | 492,00 | 239,00 | 316,00 | 212,00 | 116,00 | 0 | 431,34 |
| 1627,04 | 1,00 | 492,00 | 11,00 | 316,00 | 112,00 | 120,00 | 0 | 576,04 |
| 1187,30 | 1,00 | 493,00 | 11,00 | 180,00 | 112,00 | 88,00 | 0 | 303,30 |
| 1433,02 | 1,00 | 507,00 | 11,00 | 384,00 | 112,00 | 89,00 | 0 | 330,02 |
| 1628,34 | 1,00 | 660,00 | 100,00 | 380,00 | 66,00 | 90,00 | 0 | 332,34 |
| 1460,59 | 1,00 | 524,00 | 100,00 | 308,00 | 64,00 | 116,00 | 0 | 348,59 |
| 1334,01 | 1,00 | 341,00 | 96,00 | 362,00 | 88,00 | 116,00 | 0 | 331,01 |
| 1738,42 | 1,00 | 336,00 | 292,00 | 252,00 | 224,00 | 116,00 | 0 | 518,42 |
| 1765,35 | 1,00 | 337,00 | 280,00 | 326,00 | 208,00 | 101,00 | 0 | 513,35 |
| 1916,11 | 1,00 | 576,00 | 280,00 | 176,00 | 208,00 | 120,00 | 0 | 556,11 |
| 1896,20 | 1,00 | 576,00 | 276,00 | 199,00 | 176,00 | 115,00 | 0 | 554,20 |
| 2053,22 | 1,00 | 656,00 | 313,00 | 332,00 | 68,00 | 116,00 | 0 | 568,22 |
| 2238,81 | 1,00 | 656,00 | 272,00 | 740,00 | 67,00 | 95,00 | 0 | 408,81 |
| 1880,47 | 1,00 | 656,00 | 300,00 | 380,00 | 77,00 | 95,00 | 0 | 372,47 |
| 1998,49 | 1,00 | 656,00 | 300,00 | 260,00 | 216,00 | 120,00 | 0 | 446,49 |
| 1979,71 | 1,00 | 656,00 | 264,00 | 260,00 | 216,00 | 116,00 | 0 | 467,71 |
| 1826,09 | 1,00 | 652,00 | 264,00 | 120,00 | 216,00 | 116,00 | 0 | 458,09 |
| 1857,89 | 1,00 | 688,00 | 264,00 | 120,00 | 204,00 | 143,00 | 0 | 438,89 |
| 2282,34 | 1,00 | 926,00 | 264,00 | 324,00 | 140,00 | 160,00 | 0 | 468,34 |
| 1998,30 | 1,00 | 928,00 | 264,00 | 192,00 | 63,00 | 160,00 | 0 | 391,30 |
| 1488,37 | 1,00 | 420,00 | 288,00 | 192,00 | 63,00 | 160,00 | 0 | 365,37 |
| 1436,38 | 1,00 | 420,00 | 168,00 | 284,00 | 61,00 | 148,00 | 0 | 355,38 |
| 1561,17 | 1,00 | 304,00 | 244,00 | 284,00 | 208,00 | 148,00 | 0 | 373,17 |
| 1695,79 | 1,00 | 403,00 | 256,00 | 284,00 | 212,00 | 164,00 | 0 | 376,79 |
| 1875,56 | 1,00 | 592,00 | 256,00 | 300,00 | 204,00 | 140,00 | 0 | 383,56 |
| 2141,17 | 1,00 | 724,00 | 252,00 | 300,00 | 216,00 | 140,00 | 0 | 509,17 |
| 2923,95 | 1,00 | 724,00 | 252,00 | 360,00 | 216,00 | 184,00 | 0 | 1187,95 |
| 3018,76 | 1,00 | 1003,00 | 252,00 | 276,00 | 152,00 | 186,00 | 0 | 1149,76 |
| 4584,26 | 1,00 | 2549,00 | 252,00 | 392,00 | 152,00 | 184,00 | 0 | 1055,26 |
| 4683,34 | 1,00 | 2277,00 | 292,00 | 500,00 | 128,00 | 161,00 | 0 | 1325,34 |
| 4887,38 | 1,00 | 2274,00 | 324,00 | 500,00 | 288,00 | 152,00 | 0 | 1349,38 |
| 5137,44 | 1,00 | 2284,00 | 304,00 | 416,00 | 550,00 | 168,00 | 0 | 1415,44 |

| | | | | | | | | |
|---|---|---|---|---|---|---|---|---|
| 4103,42 | 1,00 | 1151,00 | 292,00 | 500,00 | 550,00 | 167,00 | 0 | 1443,42 |
| 4875,75 | 1,00 | 1153,00 | 316,00 | 416,00 | 548,00 | 167,00 | 0 | 2275,75 |
| 3365,08 | 1,00 | 725,00 | 316,00 | 416,00 | 541,00 | 140,00 | 0 | 1227,08 |
| 4288,90 | 1,00 | 764,00 | 316,00 | 416,00 | 1306,00 | 160,00 | 0 | 1326,90 |
| 3049,96 | 1,00 | 556,00 | 463,00 | 684,00 | 602,00 | 160,00 | 0 | 584,96 |
| 2982,77 | 1,00 | 556,00 | 520,00 | 664,00 | 595,00 | 160,00 | 0 | 487,77 |
| 3287,84 | 1,00 | 1221,00 | 520,00 | 635,00 | 312,00 | 106,00 | 0 | 493,84 |
| 3292,34 | 1,00 | 1221,00 | 497,00 | 635,00 | 312,00 | 124,00 | 0 | 503,34 |
| 3596,32 | 1,00 | 1464,00 | 464,00 | 634,00 | 388,00 | 124,00 | 0 | 522,32 |
| 3523,69 | 1,00 | 1465,00 | 464,00 | 523,00 | 388,00 | 100,00 | 0 | 583,69 |
| 3153,81 | 1,00 | 1127,00 | 464,00 | 523,00 | 393,00 | 168,00 | 0 | 478,81 |
| 3025,89 | 1,00 | 1127,00 | 379,00 | 511,00 | 373,00 | 171,00 | 0 | 464,89 |
| 2971,25 | 1,00 | 1127,00 | 384,00 | 515,00 | 320,00 | 148,00 | 0 | 477,25 |
| 3422,16 | 1,00 | 1127,00 | 336,00 | 955,00 | 320,00 | 104,00 | 0 | 580,16 |
| 4251,13 | 1,00 | 508,00 | 328,00 | 2442,00 | 232,00 | 105,00 | 0 | 636,13 |
| 1702,24 | 1,00 | 449,00 | 312,00 | 164,00 | 232,00 | 132,00 | 0 | 413,24 |
| 2254,39 | 1,00 | 856,00 | 312,00 | 163,00 | 294,00 | 181,00 | 0 | 448,39 |
| 2213,27 | 1,00 | 856,00 | 312,00 | 194,00 | 169,00 | 187,00 | 0 | 495,27 |
| 1930,20 | 1,00 | 601,00 | 312,00 | 198,00 | 168,00 | 180,00 | 0 | 471,20 |
| 2009,15 | 1,00 | 684,00 | 314,00 | 228,00 | 168,00 | 136,00 | 0 | 479,15 |
| 2027,84 | 1,00 | 684,00 | 316,00 | 269,00 | 168,00 | 132,00 | 0 | 458,84 |
| 1929,76 | 1,00 | 477,00 | 312,00 | 268,00 | 260,00 | 123,00 | 0 | 489,76 |
| 1886,13 | 1,00 | 477,00 | 316,00 | 254,00 | 262,00 | 92,00 | 0 | 485,13 |
| 1509,12 | 1,00 | 268,00 | 316,00 | 121,00 | 260,00 | 92,00 | 0 | 452,12 |
| 1482,24 | 1,00 | 524,00 | 316,00 | 125,00 | 64,00 | 89,00 | 0 | 364,24 |
| 1752,43 | 1,00 | 524,00 | 308,00 | 340,00 | 64,00 | 128,00 | 0 | 388,43 |
| 1570,59 | 1,00 | 524,00 | 311,00 | 201,00 | 64,00 | 128,00 | 0 | 342,59 |
| 1643,35 | 1,00 | 476,00 | 308,00 | 220,00 | 63,00 | 128,00 | 0 | 448,35 |
| 1853,57 | 1,00 | 477,00 | 308,00 | 263,00 | 216,00 | 124,00 | 0 | 465,57 |
| 1767,20 | 1,00 | 477,00 | 308,00 | 265,00 | 208,00 | 116,00 | 0 | 393,20 |
| 1558,04 | 1,00 | 228,00 | 308,00 | 328,00 | 208,00 | 116,00 | 0 | 370,04 |
| 1526,62 | 1,00 | 228,00 | 308,00 | 328,00 | 184,00 | 116,00 | 0 | 362,62 |
| 1729,27 | 1,00 | 476,00 | 327,00 | 322,00 | 66,00 | 130,00 | 0 | 408,27 |
| 1402,12 | 1,00 | 292,00 | 352,00 | 212,00 | 69,00 | 102,00 | 0 | 375,12 |
| 1617,42 | 1,00 | 298,00 | 384,00 | 372,00 | 63,00 | 104,00 | 0 | 396,42 |
| 1716,15 | 1,00 | 297,00 | 384,00 | 371,00 | 180,00 | 116,00 | 0 | 368,15 |
| 1747,21 | 1,00 | 297,00 | 348,00 | 404,00 | 212,00 | 128,00 | 0 | 358,21 |
| 1289,12 | 1,00 | 60,00 | 308,00 | 201,00 | 204,00 | 124,00 | 0 | 392,12 |
| 1262,24 | 1,00 | 60,00 | 308,00 | 201,00 | 204,00 | 136,00 | 0 | 353,24 |
| 1397,80 | 1,00 | 256,00 | 308,00 | 257,00 | 88,00 | 136,00 | 0 | 352,80 |
| 1503,91 | 1,00 | 257,00 | 190,00 | 376,00 | 63,00 | 216,00 | 0 | 401,91 |
| 1552,95 | 1,00 | 310,00 | 189,00 | 376,00 | 63,00 | 216,00 | 0 | 398,95 |
| 1674,35 | 1,00 | 290,00 | 172,00 | 472,00 | 66,00 | 265,00 | 0 | 409,35 |
| 1367,29 | 1,00 | 283,00 | 139,00 | 208,00 | 212,00 | 168,00 | 0 | 357,29 |

| | | | | | | | | |
|---|---|---|---|---|---|---|---|---|
| 1355,47 | 1,00 | 283,00 | 140,00 | 208,00 | 208,00 | 184,00 | 0 | 332,47 |
| 1806,83 | 1,00 | 604,00 | 140,00 | 340,00 | 145,00 | 175,00 | 0 | 402,83 |
| 1812,32 | 1,00 | 492,00 | 140,00 | 340,00 | 145,00 | 275,00 | 0 | 420,32 |
| 1404,10 | 1,00 | 129,00 | 233,00 | 332,00 | 216,00 | 272,00 | 0 | 222,10 |
| 1445,90 | 1,00 | 112,00 | 233,00 | 472,00 | 120,00 | 271,00 | 0 | 237,90 |
| 1364,22 | 1,00 | 112,00 | 221,00 | 472,00 | 220,00 | 125,00 | 0 | 214,22 |
| 1494,94 | 1,00 | 376,00 | 207,00 | 294,00 | 204,00 | 124,00 | 0 | 289,94 |
| 1399,26 | 1,00 | 376,00 | 211,00 | 304,00 | 204,00 | 124,00 | 0 | 180,26 |
| 1123,00 | 1,00 | 177,00 | 197,00 | 304,00 | 65,00 | 160,00 | 0 | 220,00 |
| 1402,31 | 1,00 | 420,00 | 192,00 | 304,00 | 60,00 | 168,00 | 0 | 258,31 |
| 1399,56 | 1,00 | 435,00 | 240,00 | 296,00 | 60,00 | 136,00 | 0 | 232,56 |
| 1003,91 | 1,00 | 130,00 | 228,00 | 295,00 | 65,00 | 164,00 | 0 | 121,91 |
| 1267,15 | 1,00 | 213,00 | 228,00 | 296,00 | 212,00 | 167,00 | 0 | 151,15 |
| 1529,07 | 1,00 | 413,00 | 129,00 | 400,00 | 212,00 | 168,00 | 0 | 207,07 |
| 1657,08 | 1,00 | 412,00 | 200,00 | 400,00 | 212,00 | 140,00 | 0 | 293,08 |
| 1326,52 | 1,00 | 411,00 | 200,00 | 232,00 | 65,00 | 164,00 | 0 | 254,52 |
| 1568,69 | 1,00 | 676,00 | 200,00 | 241,00 | 64,00 | 140,00 | 0 | 247,69 |
| 1773,63 | 1,00 | 676,00 | 244,00 | 236,00 | 64,00 | 164,00 | 0 | 389,63 |
| 1698,75 | 1,00 | 676,00 | 268,00 | 263,00 | 67,00 | 164,00 | 0 | 260,75 |
| 2013,26 | 1,00 | 676,00 | 240,00 | 316,00 | 212,00 | 116,00 | 0 | 453,26 |
| 1983,34 | 1,00 | 492,00 | 239,00 | 316,00 | 212,00 | 116,00 | 0 | 608,34 |
| 1592,05 | 1,00 | 492,00 | 11,00 | 316,00 | 112,00 | 88,00 | 0 | 573,05 |
| 1185,30 | 1,00 | 493,00 | 11,00 | 180,00 | 112,00 | 88,00 | 0 | 301,30 |
| 1431,02 | 1,00 | 507,00 | 11,00 | 384,00 | 112,00 | 89,00 | 0 | 328,02 |
| 1643,34 | 1,00 | 660,00 | 100,00 | 380,00 | 66,00 | 90,00 | 0 | 347,34 |
| 1458,59 | 1,00 | 524,00 | 100,00 | 308,00 | 64,00 | 116,00 | 0 | 346,59 |
| 1332,01 | 1,00 | 341,00 | 96,00 | 362,00 | 88,00 | 116,00 | 0 | 329,01 |
| 1572,42 | 1,00 | 336,00 | 292,00 | 252,00 | 224,00 | 116,00 | 0 | 352,42 |
| 1765,35 | 1,00 | 337,00 | 280,00 | 326,00 | 208,00 | 101,00 | 0 | 513,35 |
| 1941,28 | 1,00 | 576,00 | 280,00 | 199,00 | 208,00 | 120,00 | 0 | 558,28 |
| 1895,20 | 1,00 | 576,00 | 276,00 | 199,00 | 176,00 | 115,00 | 0 | 553,20 |
| 2055,31 | 1,00 | 656,00 | 313,00 | 332,00 | 68,00 | 117,00 | 0 | 569,31 |
| 2233,81 | 1,00 | 656,00 | 272,00 | 740,00 | 67,00 | 95,00 | 0 | 403,81 |
| 1883,47 | 1,00 | 656,00 | 300,00 | 380,00 | 77,00 | 95,00 | 0 | 375,47 |
| 1996,49 | 1,00 | 656,00 | 300,00 | 260,00 | 216,00 | 120,00 | 0 | 444,49 |
| 1980,71 | 1,00 | 656,00 | 264,00 | 260,00 | 216,00 | 116,00 | 0 | 468,71 |
| 1823,09 | 1,00 | 652,00 | 264,00 | 120,00 | 216,00 | 116,00 | 0 | 455,09 |
| 1857,89 | 1,00 | 688,00 | 264,00 | 120,00 | 204,00 | 143,00 | 0 | 438,89 |
| 2285,53 | 1,00 | 928,00 | 264,00 | 324,00 | 140,00 | 160,00 | 0 | 469,53 |
| 1998,10 | 1,00 | 926,00 | 264,00 | 192,00 | 63,00 | 160,00 | 0 | 393,10 |
| 1491,37 | 1,00 | 420,00 | 288,00 | 192,00 | 63,00 | 160,00 | 0 | 368,37 |
| 1440,38 | 1,00 | 420,00 | 168,00 | 284,00 | 61,00 | 148,00 | 0 | 359,38 |
| 1558,17 | 1,00 | 304,00 | 244,00 | 284,00 | 208,00 | 148,00 | 0 | 370,17 |
| 1691,79 | 1,00 | 403,00 | 256,00 | 284,00 | 212,00 | 164,00 | 0 | 372,79 |

| | | | | | | | | |
|---|---|---|---|---|---|---|---|---|
| 1871,56 | 1,00 | 592,00 | 256,00 | 300,00 | 204,00 | 140,00 | 0 | 379,56 |
| 1996,39 | 1,00 | 592,00 | 252,00 | 300,00 | 216,00 | 140,00 | 0 | 496,39 |
| 2879,95 | 1,00 | 724,00 | 252,00 | 360,00 | 216,00 | 184,00 | 0 | 1143,95 |
| 3160,72 | 1,00 | 1003,00 | 252,00 | 392,00 | 152,00 | 186,00 | 0 | 1175,72 |
| 4592,26 | 1,00 | 2549,00 | 252,00 | 392,00 | 152,00 | 184,00 | 0 | 1063,26 |
| 4387,50 | 1,00 | 2277,00 | 292,00 | 500,00 | 128,00 | 152,00 | 0 | 1038,50 |
| 4879,28 | 1,00 | 2273,00 | 324,00 | 500,00 | 288,00 | 152,00 | 0 | 1342,28 |
| 5140,44 | 1,00 | 2284,00 | 304,00 | 416,00 | 550,00 | 168,00 | 0 | 1418,44 |
| 4125,52 | 1,00 | 1151,00 | 293,00 | 500,00 | 550,00 | 167,00 | 0 | 1464,52 |
| 4877,75 | 1,00 | 1153,00 | 316,00 | 416,00 | 548,00 | 167,00 | 0 | 2277,75 |
| 3350,68 | 1,00 | 725,00 | 317,00 | 416,00 | 546,00 | 140,00 | 0 | 1206,68 |
| 4320,34 | 1,00 | 764,00 | 316,00 | 416,00 | 1350,00 | 160,00 | 0 | 1314,34 |
| 3048,77 | 1,00 | 556,00 | 463,00 | 683,00 | 601,00 | 160,00 | 0 | 585,77 |
| 2979,77 | 1,00 | 556,00 | 520,00 | 664,00 | 595,00 | 160,00 | 0 | 484,77 |
| 3290,93 | 1,00 | 1222,00 | 520,00 | 635,00 | 312,00 | 106,00 | 0 | 495,93 |
| 3296,43 | 1,00 | 1221,00 | 497,00 | 636,00 | 312,00 | 124,00 | 0 | 506,43 |
| 3595,32 | 1,00 | 1464,00 | 464,00 | 634,00 | 388,00 | 124,00 | 0 | 521,32 |
| 3523,89 | 1,00 | 1465,00 | 464,00 | 523,00 | 390,00 | 100,00 | 0 | 581,89 |
| 3057,67 | 1,00 | 1127,00 | 378,00 | 523,00 | 393,00 | 168,00 | 0 | 468,67 |
| 3052,91 | 1,00 | 1127,00 | 379,00 | 511,00 | 393,00 | 171,00 | 0 | 471,91 |
| 2969,25 | 1,00 | 1127,00 | 384,00 | 515,00 | 320,00 | 148,00 | 0 | 475,25 |
| 3420,16 | 1,00 | 1127,00 | 336,00 | 955,00 | 320,00 | 104,00 | 0 | 578,16 |
| 4251,23 | 1,00 | 508,00 | 328,00 | 2443,00 | 232,00 | 105,00 | 0 | 635,23 |
| 1702,15 | 1,00 | 449,00 | 312,00 | 163,00 | 232,00 | 132,00 | 0 | 414,15 |
| 2287,32 | 1,00 | 856,00 | 312,00 | 194,00 | 294,00 | 181,00 | 0 | 450,32 |
| 2213,17 | 1,00 | 856,00 | 312,00 | 194,00 | 168,00 | 187,00 | 0 | 496,17 |
| 1931,20 | 1,00 | 601,00 | 312,00 | 198,00 | 168,00 | 180,00 | 0 | 472,20 |
| 2010,15 | 1,00 | 684,00 | 314,00 | 228,00 | 168,00 | 136,00 | 0 | 480,15 |
| 2026,84 | 1,00 | 684,00 | 316,00 | 269,00 | 168,00 | 132,00 | 0 | 457,84 |
| 1939,60 | 1,00 | 471,00 | 312,00 | 283,00 | 260,00 | 123,00 | 0 | 490,60 |
| 1921,02 | 1,00 | 477,00 | 316,00 | 254,00 | 262,00 | 123,00 | 0 | 489,02 |
| 1508,03 | 1,00 | 268,00 | 316,00 | 120,00 | 260,00 | 92,00 | 0 | 452,03 |
| 1484,04 | 1,00 | 524,00 | 316,00 | 124,00 | 63,00 | 89,00 | 0 | 368,04 |
| 1751,53 | 1,00 | 524,00 | 308,00 | 340,00 | 65,00 | 128,00 | 0 | 386,53 |
| 1570,59 | 1,00 | 524,00 | 311,00 | 201,00 | 64,00 | 128,00 | 0 | 342,59 |
| 1643,35 | 1,00 | 476,00 | 308,00 | 220,00 | 63,00 | 128,00 | 0 | 448,35 |
| 1853,57 | 1,00 | 477,00 | 308,00 | 263,00 | 216,00 | 124,00 | 0 | 465,57 |
| 1767,20 | 1,00 | 477,00 | 308,00 | 265,00 | 208,00 | 116,00 | 0 | 393,20 |
| 1554,04 | 1,00 | 228,00 | 308,00 | 328,00 | 208,00 | 116,00 | 0 | 366,04 |
| 1529,62 | 1,00 | 228,00 | 308,00 | 328,00 | 184,00 | 116,00 | 0 | 365,62 |
| 1458,25 | 1,00 | 228,00 | 327,00 | 322,00 | 66,00 | 130,00 | 0 | 385,25 |
| 1638,97 | 1,00 | 476,00 | 384,00 | 212,00 | 69,00 | 102,00 | 0 | 395,97 |
| 1617,32 | 1,00 | 298,00 | 384,00 | 372,00 | 62,00 | 104,00 | 0 | 397,32 |
| 1718,15 | 1,00 | 297,00 | 384,00 | 371,00 | 180,00 | 116,00 | 0 | 370,15 |

| | | | | | | | | |
|---|---|---|---|---|---|---|---|---|
| 1738,40 | 1,00 | 297,00 | 348,00 | 404,00 | 204,00 | 128,00 | 0 | 357,40 |
| 1288,02 | 1,00 | 60,00 | 308,00 | 200,00 | 204,00 | 124,00 | 0 | 392,02 |
| 1263,24 | 1,00 | 60,00 | 308,00 | 201,00 | 204,00 | 136,00 | 0 | 354,24 |
| 1180,82 | 1,00 | 60,00 | 308,00 | 257,00 | 88,00 | 136,00 | 0 | 331,82 |
| 1501,82 | 1,00 | 256,00 | 190,00 | 376,00 | 63,00 | 216,00 | 0 | 400,82 |
| 1550,95 | 1,00 | 310,00 | 189,00 | 376,00 | 63,00 | 216,00 | 0 | 396,95 |
| 1676,44 | 1,00 | 290,00 | 172,00 | 472,00 | 66,00 | 266,00 | 0 | 410,44 |
| 1370,29 | 1,00 | 283,00 | 139,00 | 208,00 | 212,00 | 168,00 | 0 | 360,29 |
| 1360,57 | 1,00 | 284,00 | 140,00 | 208,00 | 208,00 | 184,00 | 0 | 336,57 |
| 1805,83 | 1,00 | 604,00 | 140,00 | 340,00 | 145,00 | 175,00 | 0 | 401,83 |
| 1810,32 | 1,00 | 492,00 | 140,00 | 340,00 | 145,00 | 275,00 | 0 | 418,32 |
| 1395,10 | 1,00 | 129,00 | 233,00 | 332,00 | 216,00 | 272,00 | 0 | 213,10 |
| 1436,71 | 1,00 | 112,00 | 233,00 | 472,00 | 120,00 | 269,00 | 0 | 230,71 |
| 1438,22 | 1,00 | 112,00 | 221,00 | 472,00 | 220,00 | 125,00 | 0 | 288,22 |
| 1501,94 | 1,00 | 376,00 | 207,00 | 294,00 | 204,00 | 124,00 | 0 | 296,94 |
| 1397,26 | 1,00 | 376,00 | 211,00 | 304,00 | 204,00 | 124,00 | 0 | 178,26 |
| 1129,39 | 1,00 | 181,00 | 197,00 | 304,00 | 65,00 | 160,00 | 0 | 222,39 |
| 1371,31 | 1,00 | 420,00 | 192,00 | 304,00 | 60,00 | 168,00 | 0 | 227,31 |
| 1391,56 | 1,00 | 435,00 | 240,00 | 296,00 | 60,00 | 136,00 | 0 | 224,56 |
| 983,30 | 1,00 | 130,00 | 228,00 | 295,00 | 65,00 | 136,00 | 0 | 129,30 |
| 1261,15 | 1,00 | 213,00 | 228,00 | 296,00 | 212,00 | 167,00 | 0 | 145,15 |
| 1526,07 | 1,00 | 413,00 | 129,00 | 400,00 | 212,00 | 168,00 | 0 | 204,07 |
| 1656,08 | 1,00 | 412,00 | 200,00 | 400,00 | 212,00 | 140,00 | 0 | 292,08 |
| 1324,62 | 1,00 | 412,00 | 200,00 | 232,00 | 65,00 | 164,00 | 0 | 251,62 |
| 1573,70 | 1,00 | 677,00 | 199,00 | 241,00 | 64,00 | 140,00 | 0 | 252,70 |
| 1771,53 | 1,00 | 676,00 | 244,00 | 236,00 | 63,00 | 164,00 | 0 | 388,53 |
| 1852,38 | 1,00 | 676,00 | 268,00 | 263,00 | 212,00 | 164,00 | 0 | 269,38 |
| 2014,26 | 1,00 | 676,00 | 240,00 | 316,00 | 212,00 | 116,00 | 0 | 454,26 |
| 1983,34 | 1,00 | 492,00 | 239,00 | 316,00 | 212,00 | 116,00 | 0 | 608,34 |
| 1589,05 | 1,00 | 492,00 | 11,00 | 316,00 | 112,00 | 88,00 | 0 | 570,05 |
| 1186,30 | 1,00 | 493,00 | 11,00 | 180,00 | 112,00 | 88,00 | 0 | 302,30 |
| 1426,02 | 1,00 | 507,00 | 11,00 | 384,00 | 112,00 | 89,00 | 0 | 323,02 |
| 1642,25 | 1,00 | 660,00 | 100,00 | 380,00 | 66,00 | 89,00 | 0 | 347,25 |
| 1461,59 | 1,00 | 524,00 | 100,00 | 308,00 | 64,00 | 116,00 | 0 | 349,59 |
| 1328,01 | 1,00 | 341,00 | 96,00 | 362,00 | 88,00 | 116,00 | 0 | 325,01 |
| 1419,70 | 1,00 | 336,00 | 292,00 | 252,00 | 88,00 | 116,00 | 0 | 335,70 |
| 1781,76 | 1,00 | 337,00 | 280,00 | 326,00 | 208,00 | 116,00 | 0 | 514,76 |
| 1940,28 | 1,00 | 576,00 | 280,00 | 199,00 | 208,00 | 120,00 | 0 | 557,28 |
| 1893,20 | 1,00 | 576,00 | 276,00 | 199,00 | 176,00 | 115,00 | 0 | 551,20 |
| 2053,31 | 1,00 | 656,00 | 313,00 | 332,00 | 68,00 | 117,00 | 0 | 567,31 |
| 2260,87 | 1,00 | 656,00 | 272,00 | 740,00 | 67,00 | 117,00 | 0 | 408,87 |
| 1889,57 | 1,00 | 656,00 | 300,00 | 380,00 | 78,00 | 95,00 | 0 | 380,57 |
| 1996,49 | 1,00 | 656,00 | 300,00 | 260,00 | 216,00 | 120,00 | 0 | 444,49 |
| 2019,11 | 1,00 | 656,00 | 300,00 | 260,00 | 216,00 | 116,00 | 0 | 471,11 |

| | | | | | | | | |
|---|---|---|---|---|---|---|---|---|
| 1824,09 | 1,00 | 652,00 | 264,00 | 120,00 | 216,00 | 116,00 | 0 | 456,09 |
| 1859,89 | 1,00 | 688,00 | 264,00 | 120,00 | 204,00 | 143,00 | 0 | 440,89 |
| 2005,80 | 1,00 | 689,00 | 264,00 | 324,00 | 140,00 | 143,00 | 0 | 445,80 |
| 2001,10 | 1,00 | 926,00 | 264,00 | 192,00 | 63,00 | 160,00 | 0 | 396,10 |
| 1493,28 | 1,00 | 420,00 | 288,00 | 192,00 | 63,00 | 159,00 | 0 | 371,28 |
| 1439,38 | 1,00 | 420,00 | 168,00 | 284,00 | 61,00 | 148,00 | 0 | 358,38 |
| 1562,17 | 1,00 | 304,00 | 244,00 | 284,00 | 208,00 | 148,00 | 0 | 374,17 |
| 1689,79 | 1,00 | 403,00 | 256,00 | 284,00 | 212,00 | 164,00 | 0 | 370,79 |
| 1867,56 | 1,00 | 592,00 | 256,00 | 300,00 | 204,00 | 140,00 | 0 | 375,56 |
| 2000,77 | 1,00 | 592,00 | 256,00 | 300,00 | 216,00 | 140,00 | 0 | 496,77 |
| 2831,84 | 1,00 | 724,00 | 252,00 | 360,00 | 216,00 | 140,00 | 0 | 1139,84 |
| 3149,72 | 1,00 | 1003,00 | 252,00 | 392,00 | 152,00 | 186,00 | 0 | 1164,72 |
| 4701,46 | 1,00 | 2549,00 | 252,00 | 500,00 | 152,00 | 184,00 | 0 | 1064,46 |
| 4417,48 | 1,00 | 2277,00 | 292,00 | 500,00 | 128,00 | 184,00 | 0 | 1036,48 |
| 4872,25 | 1,00 | 2282,00 | 325,00 | 500,00 | 288,00 | 152,00 | 0 | 1325,25 |
| 5115,40 | 1,00 | 2284,00 | 293,00 | 416,00 | 550,00 | 168,00 | 0 | 1404,40 |
| 4106,52 | 1,00 | 1151,00 | 293,00 | 500,00 | 550,00 | 167,00 | 0 | 1445,52 |
| 4889,75 | 1,00 | 1153,00 | 316,00 | 416,00 | 548,00 | 167,00 | 0 | 2289,75 |
| 3348,68 | 1,00 | 725,00 | 317,00 | 416,00 | 546,00 | 140,00 | 0 | 1204,68 |
| 4305,34 | 1,00 | 764,00 | 316,00 | 416,00 | 1350,00 | 160,00 | 0 | 1299,34 |
| 3048,77 | 1,00 | 556,00 | 463,00 | 683,00 | 601,00 | 160,00 | 0 | 585,77 |
| 3000,56 | 1,00 | 556,00 | 520,00 | 683,00 | 595,00 | 160,00 | 0 | 486,56 |
| 2567,62 | 1,00 | 556,00 | 522,00 | 635,00 | 312,00 | 106,00 | 0 | 436,62 |
| 3298,62 | 1,00 | 1221,00 | 497,00 | 638,00 | 312,00 | 124,00 | 0 | 506,62 |
| 3630,45 | 1,00 | 1464,00 | 497,00 | 634,00 | 388,00 | 124,00 | 0 | 523,45 |
| 3151,16 | 1,00 | 1127,00 | 464,00 | 523,00 | 390,00 | 100,00 | 0 | 547,16 |
| 3057,67 | 1,00 | 1127,00 | 378,00 | 523,00 | 393,00 | 168,00 | 0 | 468,67 |
| 2977,54 | 1,00 | 1127,00 | 379,00 | 511,00 | 320,00 | 171,00 | 0 | 469,54 |
| 2970,25 | 1,00 | 1127,00 | 384,00 | 515,00 | 320,00 | 148,00 | 0 | 476,25 |
| 3422,16 | 1,00 | 1127,00 | 336,00 | 955,00 | 320,00 | 104,00 | 0 | 580,16 |
| 4283,94 | 1,00 | 508,00 | 328,00 | 2445,00 | 232,00 | 132,00 | 0 | 638,94 |

The first column of the table shows the average power values related to the power supplied from the electrical cabinet 1 to the electrical line 100, to which the six users $U_1$, $U_2$, $U_3$, $U_4$, $U_5$, $U_6$ are connected. Said average power values have been acquired in each predetermined unit of time of 15 minutes.

The second column of the table shows the constant values $\alpha$ of power absorbed by an illegal connection to the electrical line 100, present in the matrix X.

From the third column to the eighth column, the table shows the values of each sequence of values of absorbed power $(f_i)_k$ associated with a respective user $U_1$, $U_2$, $U_3$, $U_4$, $U_5$, $U_6$. The power values of each sequence of power values are the values measured by the electricity meter associated with a respective user.

The ninth column shows the values of the sequence of difference values $(D)_k$.

All the power values given in the table are expressed in the same units. In the example being described, the measurement unit is kilowatts (kw).

However, it is possible to use any unit of measurement, for example Joule, provided that all the power values are expressed with the same unit of measurement.

Below the method will be described with reference to its steps.

With reference to step A), the first column of the table shows an average value of power s with reference to the power supplied from said transformer room 1 to said power line 100 and measured by said power meter 10, in such a way as to obtain a sequence of average power values $(s)_k$ (with the index k ranging from 1 to 1344) in each predetermined unit of time of 15 minutes in the predetermined time period.

With reference to step B) the average value of the average power values is calculated with reference to the average values of each sequence of power values $(s)_k$ and the standard deviation $\sigma_s$ reported to the power supplied from said transformer 1 to said power line 100 and measured by said power meter 10:

$$\bar{s} = \frac{1}{M} \sum_{k=1}^{M} (s)_k = 2141,52 \, kWh$$

$$\sigma_S = \frac{1}{M} \sqrt{\sum_{k=1}^{M} ((s)_k - \bar{s})^2} = 966,20 \, kWh$$

With reference to step C), from the third column to the eighth column shows the powers absorbed by a respective user and measured by the electricity meters respectively associated with the first user $U_1$, the second user $U_2$, the third user $U_3$, the fourth user $U_4$, the fifth user $U_5$ and the sixth user $U_6$.

The power absorbed by each user are the powers absorbed in each predetermined time unit of 15 minutes present in the predetermined time period of 14 consecutive days, in such a way as to obtain for each user U1, U2, U3, U4, U5, U6 a respective sequence of values of power absorbed by the user itself:

$\{(f_1)_1, (f_1)_2 \ldots (f_1)_{1344}\}$
$\{(f_2)_1, (f_2)_2 \ldots (f_2)_{1344}\}$
$\{(f_3)_1, (f_3)_2 \ldots (f_3)_{1344}\}$
$\{(f_4)_1, (f_4)_2 \ldots (f_4)_{1344}\}$
$\{(f_5)_1, (f_5)_2 \ldots (f_5)_{1344}\}$
$\{(f_6)_1, (f_6)_2 \ldots (f_6)_{1344}\}$

With reference to the step D), the average value $\bar{f}_i$ and the standard deviation $\sigma_i$ of each sequence of values of power absorbed by a respective user $U_1$, $U_2$, $U_3$, $U_4$, $U_5$ e $U_6$ are calculated.

Below the results obtained with the formulas mentioned in the step D).

|  | $U_1$ ($f_1$) | $U_2$ ($f_2$) | $U_3$ ($f_3$) | $U_4$ ($f_4$) | $U_5$ ($f_5$) | $U_6$ ($f_6$) |
|---|---|---|---|---|---|---|
| $\bar{f}_i$ | 606,00 | 275,10 | 367,14 | 204,28 | 142,59 | 0 |
| $\sigma_i$ | 474,03 | 94,89 | 294,46 | 167,14 | 37,53 | 0 |

With reference to step E), the ninth column of the table shows the sequence of difference values $(D)_k$. Each difference value of said sequence of difference values is equal to the difference between the power measured by said power meter 10 (i.e. the power supplied from said transformer room 1 to said power line 100) and the sum of the powers absorbed by each user $U_1$, $U_2$, $U_3$, $U_4$, $U_5$, $U_6$ for each predetermined time unit of 15 minutes in the predetermined time period of 14 consecutive days.

Consequently, in case of six users:

$$(D)_k = (s)_k - \left( (f_1)_k + (f_2)_k + (f_3)_k + (f_4)_k + (f_5)_k + (f_6)_k \right)$$

With reference to step F), the average value $\bar{D}$ and the standard deviation $\sigma_D$ of said sequence of difference values are calculated with the formulas mentioned in step F).

Below, the obtained results.

| $\bar{D}$ | 546,40 |
|---|---|
| $\sigma_D$ | 397,04 |

With reference to the step G), an average value of the efficiency $\bar{e}$ associated with said power line 100 in said predetermined time period is determined with the formula mentioned in said step G).

Below the result:

| Average value of efficiency $\bar{e}$ | 0,74 |
|---|---|

With reference to step H), said average value of efficiency $\bar{e}$ must be compared with a predetermined efficiency threshold.

In this example, reference is made to a power line 100 having an efficiency equal to about 93% in the absence of frauds.

In the example being described, the predetermined efficiency threshold is equal to 0,9.

With reference to step I), in the example being described, the average value of efficiency $\bar{e}$ f said power line 100 is less than said predetermined efficiency threshold. Consequently, the steps from I1) to I5) of the method above disclosed are not performed and the method proceeds to step L) comprising the steps L1), L2) and L3).

With reference to step L1), each statistical correlation coefficient $\rho_1$, $\rho_2$, $\rho_3$, $\rho_4$, $\rho_5$, $\rho_6$ of each sequence of values of power $(f_i)_k$ absorbed by a respective user $U_1$, $U_2$, $U_3$, $U_4$, $U_5$, $U_6$ with said sequence of difference values $(D)_k$ in the predetermined time period normalized with the product of the standard deviations $\sigma_i$ and $\sigma_s$.

Below the values of the statistical correlation coefficients obtained with the formula mentioned in the step L1).

|  | $U_1$ $(f_1)$ | $U_2$ $(f_2)$ | $U_3$ $(f_3)$ | $U_4$ $(f_4)$ | $U_5$ $(f_5)$ | $U_6$ $(f_6)$ |
|---|---|---|---|---|---|---|
| $\rho_i$ | 0,45 | 0,08 | 0,10 | 0,45 | 0,03 | ### |

As it can be seen from the obtained results of the statistical correlation coefficients, the sixth user $U_6$ has a statistical correlation coefficient that can not be calculated since $(f_6)_k$ is equal to zero for each predetermined time unit.

With reference to step L2), each statistical correlation coefficient $\rho_i$ associated with a respective user $U_1, U_2, U_3, U_4, U_5, U_6$ is compared with a predetermined correlation threshold.

In the example being described, said predetermined correlation threshold has been set equal to 0,1.

|  | $U_1$ $(f_1)$ | $U_2$ $(f_2)$ | $U_3$ $(f_3)$ | $U_4$ $(f_4)$ | $U_5$ $(f_5)$ | $U_6$ $(f_6)$ |
|---|---|---|---|---|---|---|
| >0.1 | si | no | si | si | No | ------ |

With reference to the step L3), the first user $U_1$, the third user $U_3$ and the fourth $U_4$ are reported to an entity responsible for the supply of electrical energy since electrical losses due to a malfunctioning or tampering of the electricity meter are associated with them.

In particular, a high probability of fraud can be associated with to the users $U_1$ and $U_4$ and a low probability of fraud can be associated with the third U3 users.

The sixth user $U_6$ may be reported to the entity for the supply of electrical energy since the electricity meter associated with it measures a constant value over time, so that said entity can verify the cause leading such an electricity meter to measure a value constant over time.

Furthermore, the steps for determining the presence of at least one illegal connection to the power line 100 have been performed.

With particular reference to the step M1), an M-dimensional column vector y is defined whose components are I values present in the ninth column of the table above mentioned.

$$y = \begin{pmatrix} 808,63 \\ 1087,50 \\ \cdot \\ \cdot \\ \cdot \\ 638,94 \end{pmatrix}$$

With particular reference to the step M2) a matrix X having M rows and N+1 columns, i.e. a matrix with 13444 rows and 7 columns.

$$X = \begin{pmatrix} 1 & 134,40 & 308,00 & 228,00 & 275,20 & 144,00 & 0 \\ 1 & 247,20 & 312,00 & 164,00 & 236,80 & 180,00 & 0 \\ \cdot & \cdot & \cdot & \cdot & \cdot & \cdot & \cdot \\ \cdot & \cdot & \cdot & \cdot & \cdot & \cdot & \cdot \\ \cdot & \cdot & \cdot & \cdot & \cdot & \cdot & \cdot \\ 1 & 508,00 & 328,00 & 2445,00 & 232,00 & 132,00 & 0 \end{pmatrix}$$

With reference to the matrix X, in the example being described, each constant value $\alpha$ present in the first column has been set equal to 1.

Furthermore, it should be noted that:

- the second column consists of the values of the sequence of values of power absorbed by the first user $U_1$ for each predetermined time unit present in the predetermined period of time, given in the table;
- the third column consists of the values of the sequence of values of power absorbed by the second user $U_2$ for each predetermined time unit present in the predetermined time period, given in the table;
- the fourth column consists of the values of the sequence of values of power absorbed by the third user $U_3$ for each predetermined time unit present in the predetermined time period, given in the table;
- the fifth column consists of the values of the sequence of the values of power absorbed by the fourth user $U_4$ for each predetermined time unit present in the predetermined time period of time, given in the table;
- the sixth column consists of the values of the sequence of the values of power absorbed by the fifth user $U_5$ for each predetermined time unit present in the predetermined time period, given in table.

With reference to the seventh column of the matrix X, each component of the column has a value equal to zero, due to the fact that the power absorbed by the sixth user $U_6$ for time unit is equal to zero.

With reference to the step M3) a linear equation in matrix form with the formula mentioned in said step M3). in particular, the following column vector is obtained by the method of least squares:

$$\theta = \begin{pmatrix} 429 \\ 62 \\ 0,33 \\ -0,94 \\ 0,01 \\ 1,01 \\ -0,25 \\ 0 \end{pmatrix}$$

With reference to the step M4) the first parameter of the column vector $\theta$ is compared with a predetermined third threshold. In the example being described, said predetermined third threshold has been set equal to 100.

In particular, in the example being described, the first parameter $\theta_0$ of the column vector $\theta$ is referred to the vector having an unitary power value for all the components of the first column of the matrix X.

The first parameter $\theta_0$ of the column vector $\theta$ has a value greater than the predetermined third threshold and consequently the presence of at least one illegal connection to the entity responsible for the supply of the electrical energy is reported.

The present invention also relates also to a system for determining electrical losses of at least one power line 100.

**Example of system**

Making reference to Figure 2, said system comprises said power line 100, as well as:

- a transformer room 1 for providing electric current to said six users $U_1, U_2...U_6$ through said power line 100,
- at least an electricity meter (not shown) associated with a respective user $U_1, U_2...U_6$ for measuring the power absorbed by said user,
- the power meter 10 for measuring the power supplied from said transformer room 1 to said power line 100 in predetermined time units present in a predetermined time period.

The electricity meter measures the power absorbed from each user $U_1, U_2...U_6$ in predetermined time units present in a predetermined time period, in such as to obtain for each user a respective sequence of average values of power $(s)_k$.

The power meter 10 is positioned on said power line 100 between said transform room 1 and said users $U_1, U_2...U_6$, and measures the power supplied from said transformer room 1 to said power line 100 in such as to obtain the sequence of a sequence of average values of power $(s)_k$ in each of said predetermined time units.

The system comprises a central unit (not shown) comprising a computer configured to receive and process said sequence of values of absorbed power $(f_j)_k$ and said sequence of average values of power $(s)_k$ in order to determine the electrical losses of said power line due to a malfunctioning or tampering of an electricity meter and/or an illegal connection to said power line.

Advantageously, according to the method object of the invention, it is possible to determine electrical losses due to a malfunctioning or tampering of an electricity meter and/or determine electrical losses due to the presence of at least one illegal connection to the power line.

The present invention has been described for illustrative, but not limitative purposes with reference to a preferred embodiment, but it is well evident that one skilled in the art can introduce modifications to the same without departing from the relevant scope, as defined in the enclosed claims.

**Claims**

1. Method for determining electrical losses of at least one power line (100) due to a malfunctioning or tampering of an electricity meter and/or to an illegal connection to said power line, said at least one power line (100) being connected to a plurality of users $(U_1, U_2...U_N)$ and to a transformer room (1) for providing with electric current, through said at least one power line (100), said plurality of users $(U_1, U_2...U_N)$, and to at least one power meter (10) to measure the power supplied from said transformer room (1) to said power line (100) in predetermined time units present in a predetermined period of time, said power meter being arranged on said at least one power line (100) between said transformer room (1) and said users $(U_1, U_2...U_N)$, said method comprising the following steps:

   A) acquiring an average value of power s with reference to the power supplied from said transformer room (1) to said power line (100) and measured by said power meter (10), in such a way as to obtain a sequence of average values of power in each predetermined time unit present in the predetermined time period $(s)_k$, with k=1,...,M where M is a positive integer, where k is the index of the number of the predetermined time units in the predetermined time period;

   B) calculating the average value $\bar{s}$ of the average values of power with reference to the average values of each sequence of power values $(s)_k$ and a standard deviation $\sigma_s$ referred to the power supplied from said transformer room (1) to said power line (100) and measured by said power meter (10):

$$\bar{s} = \frac{1}{M}\sum_{k=1}^{M}(s)_k$$

$$\sigma_S = \frac{1}{M} \sqrt{\sum_{k=1}^{M} ((s)_k - \bar{s})^2}$$

C) acquiring the power absorbed by each user ($U_1, U_2 ... U_N$) in each predetermined time unit present in the predetermined time period, so as to obtain for each user ($U_1, U_2 ... U_N$) a respective sequence of values of absorbed power $(f_i)_k$, with i=1,...,N where N is a positive integer, where i is the index of number of users:

$\{(f_1)_1, (f_1)_2 ... (f_1)_M\}$
$\{(f_2)_1, (f_2)_2 ... (f_2)_M\}$
$\{(f_N)_1, (f_N)_2 ... (f_N)_M\}$

D) calculating the mean value $\bar{f}_i$ and the standard deviation $\sigma_i$ of each sequence of values of power absorbed by each user ($U_1, U_2 ... U_N$):

$$\bar{f}_i = \frac{1}{M} \sum_{k=1}^{M} (f_i)_k$$

$$\sigma_i = \frac{1}{M} \sqrt{\sum_{k=1}^{M} ((f_i)_k - \bar{f}_i)^2}$$

E) calculating a sequence of difference values $(D)_k$, each of which is equal to the difference between the power supplied from said transformer room (1) to said power line (100) and measured by said power meter (10) and the sum of the powers absorbed by each user ($U_1, U_2 ... U_N$) for each predetermined time unit present in the predetermined time period:

$$(D)_k = (s)_k - \sum_{i=1}^{N} (f_i)_k$$

F) calculating the mean value $\bar{D}$ and the standard deviation $\sigma_D$ of said sequence of difference values:

$$\bar{D} = \frac{1}{M} \sum_{k=1}^{M} (D)_k$$

$$\sigma_D = \frac{1}{M} \sqrt{\sum_{k=1}^{M} ((D)_k - \bar{D})^2}$$

G) determining an average value of efficiency $\bar{e}$ associated with said power line (100) in the predetermined time period with the following formula:

$$\overline{e} = \frac{1}{M} \sum_{k=1}^{M} \left( \frac{\sum_{i=1}^{N} (f_i)_k}{(s)_k} \right)$$

H) comparing said average value of efficiency $\overline{e}$ with a predetermined first threshold or predetermined efficiency threshold;

I) if the average value of said efficiency $\overline{e}$ is greater than or equal to the predetermined efficiency threshold, no electrical loss is reported to an entity responsible for the supply of electricity with reference to electrical losses due to a malfunctioning or tampering with a electricity meter associated with a respective user $(U_1, U_2...U_N)$;

L) if the average value of said efficiency $\overline{e}$ is less than said predetermined efficiency threshold, performing the following steps:

L1) calculating the statistical correlation coefficient $\rho_i$ associated with each user $(U_1, U_2...U_N)$ between each sequence of values of power absorbed $(f_i)_k$ by a respective user $(U_1, U_2...U_N)$, and said sequence of difference values $(D)_k$ in the predetermined time period, normalized with the product of the standard deviations of the respective sequences of values of power consumed and the standard deviation of the sequence of difference values, with the following formula:

$$\rho_i = \frac{\sum_{k=1}^{M} \left( (f_i)_k - \overline{f}_i \right) \left( (D)_k - \overline{D} \right)}{\sigma_i \sigma_D}$$

L2) comparing the statistical correlation coefficient $\rho_i$ associated with each user $(U_1, U_2...U_N)$ with a predetermined second threshold or predetermined correlation threshold;

L3) if one or more statistical correlation coefficients $\rho_i$ associated to one or more respective users $(U_1, U_2...U_N)$ are greater or equal to said predetermined correlation threshold, reporting said users to an entity responsible for the supply of electricity with reference to electrical losses due to a malfunctioning or tampering of one or more electricity meters associated with said users;

M) determining the presence of at least one illegal connection to said power line (100) by the following steps:

M1) defining a M-dimensional column vector y formed by a sequence of difference values $(D)_k$:

$$y = \begin{pmatrix} (D)_1 \\ (D)_2 \\ \cdot \\ \cdot \\ \cdot \\ (D)_M \end{pmatrix}$$

M2) defining a matrix X with M rows and N+1 columns, where the first column is a column of constant values $\alpha$, equal to each other, and each of the remaining columns is composed of a sequence of values of power absorbed by a respective user $(U_1, U_2...U_N)$ in each predetermined time unit:

$$X = \begin{pmatrix} \alpha & (f_1)_1 & (f_2)_1 & \cdot & \cdot & \cdot & (f_N)_1 \\ \alpha & (f_1)_2 & (f_2)_2 & \cdot & \cdot & \cdot & (f_N)_2 \\ \cdot & \cdot & \cdot & & \cdot & \cdot & \cdot & \cdot \\ \cdot & \cdot & \cdot & & \cdot & \cdot & \cdot & \cdot \\ \cdot & \cdot & \cdot & & \cdot & \cdot & \cdot & \cdot \\ \alpha & (f_1)_M & (f_2)_M & \cdot & \cdot & \cdot & (f_N)_M \end{pmatrix}$$

M3) defining a linear equation in matrix form with the following formula:

$$\theta = \left(X^T X\right)^{-1} X^T y$$

where $\theta$ is a column vector so defined:

$$\theta = \begin{pmatrix} \theta_0 \\ \theta_1 \cdot \\ \cdot \\ \cdot \\ \theta_N \end{pmatrix}$$

$\theta_0, \theta_1 \dots \theta_N$ are the components of the column vector $\theta$ constituting the parameters that solve said linear equation in matrix form,

$X^T$ is the transposed matrix of the matrix X,

$(X^T X)^{-1}$ is the pseudo inverse matrix of Moore-Penrose of the matrix resulting from the multiplication of the transposed matrix $X^T$ and the matrix X,

y is the M-dimensional column vector defined at the step M1);

M4) comparing the first parameter $\theta_0$ of said column vector $\theta$ with a predetermined third threshold, where said predetermined third threshold is selected such that the result of the multiplication between the said predetermined third threshold and a constant value $\alpha$ is a predetermined average value of absorbed power for unit of time above which at least one illegal connection to said power line is to be found;

M5) if said first parameter $\theta_0$ is greater than or equal to said predetermined third threshold, reporting at least one electrical loss to an entity responsible for the supply of electricity due to at least one illegal connection to said power line (100).

2. Method according to the previous claim, **characterized in that**, after the step I), comprises the following steps:

I1) calculating the autocorrelation $A_D$ of said sequence of difference values $(D)_k$ normalized with the square of the standard deviation $\sigma_D$ of said sequence of difference values:

$$A_D = \frac{\sum_{k=1}^{M-\tau} \left((D)_k - \overline{D}\right)\left((D)_{k+\tau} - \overline{D}\right)}{\sigma_D^2}$$

where $\tau$ is the ratio between a further predetermined time period and a predetermined time unit, where said further predetermined time period and said predetermined time unit have the same units of measurement;

I2) calculating the autocorrelations $A_i$ of each of said sequence of values of power absorbed $(f_i)_k$ by each user $(U_1, U_2 \dots U_N)$ normalized with the square of the standard deviation $\sigma_i$ of each sequence of values of absorbed power:

$$A_i = \frac{\sum_{k=1}^{M-\tau}\left((f_i)_k - \bar{f}_i\right)\left((f_i)_{k+\tau} - \bar{f}_i\right)}{\sigma_i^2}$$

13) obtaining a weighted average $\overline{A}$ of said autocorrelations $A_i$ of sequences of values of power absorbed by each user ($U_1, U_2 ... U_N$):

$$\overline{A} = \sum_{i=1}^{N} \beta_i A_i = \sum_{i=1}^{N} \frac{\bar{f}_i}{\overline{s} - \overline{D}} A_i$$

where $\beta_i$ is a weight defined by the ratio between said average value $\bar{f}_i$ of each sequence of values of absorbed power and the difference between said average value $\overline{s}$ of the average values of power and said average value $\overline{D}$ of said sequence of difference values;

14) comparing the value of said autocorrelation $A_D$ with the value of said weighted average $\overline{A}$;

15) if the value of said autocorrelation $A_D$ is greater than the value of said weighted average $\overline{A}$, reporting at least one electrical loss to an entity responsible for the supply of electricity due to at least one illegal connection to said power line (100).

3. Method according to any one of claims 1-2, **characterized in that**

- the values of said sequence of values of power absorbed $(f_i)_k$ by each user,
- the mean value $\bar{f}_i$ and the standard deviation $\sigma_i$ of each sequence of values of power absorbed $(f_i)_k$ by each user,
- the values of said sequence of difference values $(D)_k$,
- the mean value $\overline{D}$ and the standard deviation $\sigma_D$ of said sequence of difference values $(D)_k$,

are values of derivatives of order zero.

4. Method according to any one of claims 1-2, **characterized in that**

- the values of said sequence of values of power absorbed $(f_i)_k$ by each user,
- the mean value $\bar{f}_i$ and the standard deviation $\sigma_i$ of each sequence of values of power absorbed $(f_i)_k$ by each user,
- the values of said sequence of difference values $(D)_k$,
- the mean value $\overline{D}$ and the standard deviation $\sigma_D$ of said sequence of difference values $(D)_k$,

are values of higher order derivatives.

5. Method according to the previous claim, **characterized in that** said higher order derivatives are derivatives of the first order.

6. Method according to any one of the previous claims, **characterized in that** said predetermined third threshold is chosen in function of the unit of measurement used for the powers absorbed by each user and for the sequences of values of power absorbed $(f_i)_k$ by a respective user.

7. Method according to any one of the previous claims, **characterized in that**, when the standard deviation $\sigma_i$ of one or more sequences of values of absorbed power $\{(f_1)_1,(f_1)_2...(f_1)_M; (f_2)_1,(f_2)_2...(f_2)_M;... (f_N)_1,(f_N)_2...(f_N)_M\}$ by a respective user ($U_1, U_2 ... U_N$) is equal to zero, it is not possible to calculate the statistical correlation coefficient $\rho_i$ of said one or more sequences of values of absorbed power $(f_i)_k$, and the respective user ($U_1, U_2 ... U_N$) is reported to said entity responsible for the supply of electricity.

8. Method according to any one of the previous claims, **characterized in that** said predetermined correlation threshold is chosen in a first range of values, from a value greater than or equal to 0,4 to a value equal to 1, or in a second range of values, from a value greater than or equal to 0,2 to a value lower than 0,4, or in a third range of values, from a value greater than or equal to 0,1 to a value lower than 0,2.

9. Computer program, comprising code means configured in such a way that, when executed on a computer, perform the steps of the method according to any of previous claim.

10. System for determining electrical losses of at least one power line (100), said at least one power line (100) being connected to a plurality of users ($U_1,U_2...U_N$), said system comprising said at least one power line, as well as:

- a transformer room (1) for providing with electric current said users of said plurality of users ($U_1,U_2...U_N$) through said at least one power line (100),
- at least one electricity meter associated with a respective user of said plurality of users ($U_1,U_2...U_N$) for measuring the power absorbed by said user, said electricity meter measuring the power absorbed by each user of said plurality of users ($U_1,U_2... U_N$) in predetermined time units present in a predetermined time period, so as to obtain for each user ($U_1,U_2...U_N$) a respective sequence of values of absorbed power ($f_i)_k$, with i index of the number of users, i=1,...,N, with N a positive integer, and k index of the predetermined time unit, k=1,...,M, with M a positive integer,
- at least a power meter (10) for measuring the power supplied from said transformer room (1) to said at least one power line (100) in predetermined time units present in a predetermined time period, so as to obtain a sequence of average values of power $(s)_k$ in each of said predetermined time units, said power meter (10) being positioned on said power line (100) between said transformer room (1) and said users ($U_1, U_2...U_N$),

**characterized in that**
said system comprises a central unit with a computer configured to receive said sequence of values of absorbed power ($f_i)_k$ and said sequence of average values of power $(s)_k$, through a communication channel, and to run the program according to claim 9.

**Patentansprüche**

1. Verfahren zum Bestimmen von elektrischen Verlusten mindestens einer Stromleitung (100) aufgrund einer Störung oder einer Manipulation eines Stromzählers und/oder aufgrund eines illegalen Anschlusses an die Stromleitung, wobei die mindestens eine Stromleitung (100) an eine Vielzahl von Nutzern ($U_1, U_2...U_N$) und an einen Transformatorraum (1), um der Vielzahl von Nutzern ($U_1, U_2...U_N$) elektrischen Strom durch die mindestens eine Stromleitung (100) bereitzustellen, und an mindestens einen Stromzähler (10) angeschlossen ist, um in vorgegebenen Zeiteinheiten, vorliegend in einem vorgegebenen Zeitraum, den Strom zu messen, der von dem Transformatorraum (1) an die Stromleitung (100) geliefert wird, wobei der Stromzähler an der mindestens einen Stromleitung (100) zwischen dem Transformatorraum (1) und den Nutzern ($U_1, U_2...U_N$) angeordnet ist, wobei das Verfahren die folgenden Schritte umfasst:

A) Ermitteln eines Durchschnittwertes des Stroms s mit Bezug auf den von dem Transformatorraum (1) an die Stromleitung (100) gelieferten und von dem Stromzähler (10) gemessenen Strom in einer Weise, dass eine Folge von Durchschnittswerten des Stroms in jeder vorgegebenen Zeiteinheit, vorliegend in dem vorgegebenen Zeitraum $(s)_k$, erhalten wird, wobei k=1,...,M, wobei M eine positive ganze Zahl ist, wobei k der Index der Anzahl der vorgegebenen Zeiteinheiten in dem vorgegebenen Zeitraum ist;
B) Berechnen des Durchschnittswertes $\bar{s}$ der Durchschnittswerte des Stroms mit Bezug auf die Durchschnittswerte jeder Folge von Stromwerten $(s)_k$ und einer Standardabweichung $\sigma_s$ bezogen auf den von dem Transformatorraum (1) an die Stromleitung (100) gelieferten und von dem Stromzähler (10) gemessenen Strom:

$$\bar{s} = \frac{1}{M}\sum_{k=1}^{M}(s)_k$$

$$\sigma_S = \frac{1}{M}\sqrt{\sum_{k=1}^{M}((s)_k - \bar{s})^2}$$

C) Ermitteln des von jedem Nutzer ($U_1$, $U_2$...$U_N$) verbrauchten Stroms in jeder vorgegebenen Zeiteinheit, vorliegend in dem vorgegebenen Zeitraum, um für jeden Nutzer ($U_1$, $U_2$...$U_N$) eine jeweilige Folge von Werten des verbrauchten Stroms $(f_i)_k$ zu erhalten, wobei i=1,...,N, wobei N eine positive ganze Zahl ist, wobei i der Index der Anzahl von Nutzern ist:

$\{(f_1)_1, (f_1)_2...(f_1)_M\}$
$\{(f_2)_1, (f_2)_2...(f_2)_M\}$ ...
$\{(f_N)_1, (f_N)_2...(f_N)_M\}$

D) Berechnen des Mittelwertes $\overline{f_i}$ und der Standardabweichung $\sigma_i$ jeder Folge von Werten des von jedem Nutzer ($U_1$, $U_2$...$U_N$) verbrauchten Stroms:

$$\overline{f_i} = \frac{1}{M}\sum_{k=1}^{M}(f_i)_k$$

$$\sigma_i = \frac{1}{M}\sqrt{\sum_{k=1}^{M}((f_i)_k - \overline{f_i})^2}$$

E) Berechnen einer Folge von Differenzwerten $(D)_k$, von denen jeder gleich der Differenz zwischen dem von dem Transformatorraum (1) an die Stromleitung (100) gelieferten und von dem Stromzähler (10) gemessenen Strom und der Summe der von jedem Nutzer ($U_1$, $U_2$...$U_N$) verbrauchten Ströme für jede vorgegebene Zeiteinheit, vorliegend in dem vorgegebenen Zeitraum, ist:

$$(D)_k = (s)_k - \sum_{i=1}^{N}(f_i)_k$$

F) Berechnen des Mittelwertes $\overline{D}$ und der Standardabweichung $\sigma_D$ der Folge von Differenzwerten:

$$\overline{D} = \frac{1}{M}\sum_{k=1}^{M}(D)_k$$

$$\sigma_D = \frac{1}{M}\sqrt{\sum_{k=1}^{M}((D)_k - \overline{D})^2}$$

G) Bestimmen eines Durchschnittswertes der Effizienz $\overline{e}$, assoziiert mit der Stromleitung (100), in dem vorgegebenen Zeitraum mit der folgenden Formel:

$$\overline{e} = \frac{1}{M}\sum_{k=1}^{M}\left(\frac{\sum_{i=1}^{N}(f_i)_k}{(s)_k}\right)$$

H) Vergleichen des Durchschnittswertes der Effizienz $\overline{e}$ mit einem vorgegebenen ersten Schwellenwert oder einem vorgegebenen Effizienzschwellenwert;
I) wenn der durchschnittliche Wert der Effizienz $\overline{e}$ größer als oder gleich dem vorgegebenen Effizienzschwellenwert ist, wird kein elektrischer Verlust mit Bezug auf elektrische Verluste aufgrund einer Störung oder einer Manipulation eines Stromzählers, assoziiert mit einem jeweiligen Nutzer ($U_1$, $U_2$...$U_N$), an eine für die Elektrizitätsversorgung verantwortliche Stelle gemeldet;

L) wenn der durchschnittliche Wert der Effizienz $\bar{e}$ kleiner als der vorgegebene Effizienzschwellenwert ist, werden die folgenden Schritte durchgeführt:

L1) Berechnen des statistischen Korrelationskoeffizienten $\rho_i$, assoziiert mit jedem Nutzer ($U_1$, $U_2$...$U_N$), zwischen jeder Folge von Werten des von einem jeweiligen Nutzer ($U_1$, $U_2$...$U_N$) verbrauchten Stroms $(f_i)_k$ und der Folge von Differenzwerten $(D)_k$ in dem vorgegebenen Zeitraum, normalisiert mit dem Produkt aus den Standardabweichungen der jeweiligen Folgen von Werten des verbrauchten Stroms und der Standardabweichung der Folge von Differenzwerten, mit der folgenden Formel:

$$\rho_i = \frac{\sum_{k=1}^{M}\left((f_i)_k - \bar{f}_i\right)\left((D)_k - \overline{D}\right)}{\sigma_i \sigma_D}$$

L2) Vergleichen des statistischen Korrelationskoeffizienten $\rho_i$, assoziiert mit jedem Nutzer ($U_1$, $U_2$...$U_N$), mit einem vorgegebenen zweiten Schwellenwert oder einem vorgegebenen Korrelationsschwellenwert;

L3) Melden der Nutzer mit Bezug auf elektrische Verluste aufgrund einer Störung oder einer Manipulation eines oder mehrerer Stromzähler, assoziiert mit den Nutzern, an eine für die Elektrizitätsversorgung verantwortliche Stelle, wenn einer oder mehrere der statistischen Korrelationskoeffizienten $\rho_i$, assoziiert mit einem oder mehreren jeweiligen Nutzern ($U_1$, $U_2$...$U_N$), größer als oder gleich dem vorgegebenen Korrelationsschwellenwert sind;

M) Bestimmen des Vorliegens mindestens eines illegalen Anschlusses an die Stromleitung (100) durch die folgenden Schritte:

M1) Definieren eines M-dimensionalen Spaltenvektors y, gebildet durch eine Folge von Differenzwerten $(D)_k$:

$$y = \begin{pmatrix} (D)_1 \\ (D)_2 \\ \cdot \\ \cdot \\ \cdot \\ (D)_M \end{pmatrix}$$

M2) Definieren einer Matrix mit M Zeilen und N+1 Spalten, wobei die erste Spalte eine Spalte konstanter Werte $\alpha$, einander gleichwertig, ist, und jede der verbleibenden Spalten aus einer Folge von Werten des von einem jeweiligen Nutzer ($U_1$, $U_2$...$U_N$) verbrauchten Stroms in jeder vorgegebenen Zeiteinheit zusammengesetzt ist:

$$X = \begin{pmatrix} \alpha & (f_1)_1 & (f_2)_1 & \cdot & \cdot & \cdot & (f_N)_1 \\ \alpha & (f_1)_2 & (f_2)_2 & \cdot & \cdot & \cdot & (f_N)_2 \\ \cdot & \cdot & \cdot & & \cdot & \cdot & \cdot \\ \cdot & \cdot & \cdot & & \cdot & \cdot & \cdot \\ \cdot & \cdot & \cdot & & \cdot & \cdot & \cdot \\ \alpha & (f_1)_M & (f_2)_M & \cdot & \cdot & \cdot & (f_N)_M \end{pmatrix}$$

M3) Definieren einer linearen Gleichung in Matrixform mit der folgenden Formel:

$$\theta = \left(X^T X\right)^{-1} X^T y$$

wobei $\theta$ ein Spaltenvektor ist, der so definiert ist:

$$\theta = \begin{pmatrix} \theta_0 \\ \theta_1 \cdot \\ \cdot \\ \cdot \\ \theta_N \end{pmatrix}$$

wobei $\theta_0$, $\theta_1$...$\theta_N$ die Komponenten des Spaltenvektors $\theta$ sind, welche die Parameter darstellen, die die lineare Gleichung in Matrixform lösen,
$X^T$ die transponierte Matrix der Matrix X ist,
$(X^TX)^{-1}$ die pseudoinverse Moore-Penrose-Matrix der aus der Multiplikation der transponierten Matrix $X^T$ und der Matrix X resultierenden Matrix ist,
y der M-dimensionale Spaltenvektor, definiert in Schritt M1), ist;

M4) Vergleichen des ersten Parameters $\theta_0$ des Spaltenvektors $\theta$ mit einem vorgegebenen dritten Schwellenwert, wobei der vorgegebene dritte Schwellenwert ausgewählt ist, sodass das Ergebnis der Multiplikation des vorgegebenen dritten Schwellenwertes und eines konstanten Wertes $\alpha$ ein vorgegebener Durchschnittswert des verbrauchten Stroms für die Zeiteinheit ist, oberhalb dessen mindestens ein illegaler Anschluss an die Stromleitung zu finden ist;
M5) Melden mindestens eines elektrischen Verlustes aufgrund mindestens eines illegalen Anschlusses an die Stromleitung (100) an eine für die Elektrizitätsversorgung verantwortliche Stelle, wenn der erste Parameter $\theta_0$ größer als oder gleich dem vorgegebenen dritten Schwellenwert ist.

2. Verfahren nach dem vorstehenden Anspruch, **dadurch gekennzeichnet, dass** es nach Schritt I) die folgenden Schritte umfasst:

I1) Berechnen der Autokorrelation $A_D$ der Folge von Differenzwerten $(D)_k$, normalisiert mit dem Quadrat der Standardabweichung $\sigma_D$ der Folge von Differenzwerten:

$$A_D = \frac{\sum_{k=1}^{M-\tau} \left( (D)_k - \overline{D} \right)\left( (D)_{k+\tau} - \overline{D} \right)}{\sigma_D^2}$$

wobei $\tau$ das Verhältnis zwischen einem weiteren vorgegebenen Zeitraum und einer vorgegebenen Zeiteinheit ist, wobei der weitere vorgegebene Zeitraum und die vorgegebene Zeiteinheit dieselben Maßeinheiten aufweisen;
I2) Berechnen der Autokorrelationen $A_i$ jeder der Folge von Werten des von jedem Nutzer ($U_1$, $U_2$...$U_N$) verbrauchten Stroms $(f_i)_k$, normalisiert mit dem Quadrat der Standardabweichung $\sigma_i$ jeder Folge von Werten des verbrauchten Stroms:

$$A_i = \frac{\sum_{k=1}^{M-\tau} \left( (f_i)_k - \bar{f_i} \right)\left( (f_i)_{k+\tau} - \bar{f_i} \right)}{\sigma_i^2}$$

I3) Erhalten eines gewichteten Durchschnitts $\overline{A}$ der Autokorrelationen $A_i$ von Folgen von Werten des von jedem Nutzer ($U_1$, $U_2$...$U_N$) verbrauchten Stroms:

$$\overline{A} = \sum_{i=1}^{N} \beta_i A_i = \sum_{i=1}^{N} \frac{\overline{f_i}}{\overline{s} - \overline{D}} A_i$$

wobei $\beta_i$ ein Gewicht ist, das durch das Verhältnis zwischen dem Durchschnittswert $\overline{f_i}$ jeder Folge von Werten des verbrauchten Stroms und der Differenz zwischen dem Durchschnittswert $\overline{s}$ der Durchschnittswerte des Stroms und dem Durchschnittswert $\overline{D}$ der Folge von Differenzwerten definiert wird;

I4) Vergleichen des Wertes der Autokorrelation $A_D$ mit dem Wert des gewichteten Durchschnitts $\overline{A}$;

I5) Melden mindestens eines elektrischen Verlustes aufgrund mindestens eines illegalen Anschlusses an die Stromleitung (100) an eine für die Elektrizitätsversorgung verantwortliche Stelle, wenn der Wert der Autokorrelation $A_D$ größer als der Wert des gewichteten Durchschnitts $\overline{A}$ ist.

3. Verfahren nach einem der Ansprüche 1-2, **dadurch gekennzeichnet, dass**

- die Werte der Folge von Werten des von jedem Nutzer verbrauchten Stroms $(fi)_k$,
- der Mittelwert $\overline{f_i}$ und die Standardabweichung $\sigma_i$ jeder Folge von Werten des von jedem Nutzer verbrauchten Stroms $(f_i)_k$,
- die Werte der Folge von Differenzwerten $(D)_k$,
- der Mittelwert $\overline{D}$ und die Standardabweichung $\sigma_D$ der Folge von Differenzwerten $(D)_k$,

Werte von Derivaten nullter Ordnung sind.

4. Verfahren nach einem der Ansprüche 1-2, **dadurch gekennzeichnet, dass**

- die Werte der Folge von Werten des von jedem Nutzer verbrauchten Stroms $(f_i)_k$,
- der Mittelwert $\overline{f_i}$ und die Standardabweichung $\sigma i$ jeder Folge von Werten des von jedem Nutzer verbrauchten Stroms $(f_i)_k$,
- die Werte der Folge von Differenzwerten $(D)_k$,
- der Mittelwert $\overline{D}$ und die Standardabweichung $\sigma_D$ der Folge von Differenzwerten $(D)_k$,

Werte von Derivaten höherer Ordnung sind.

5. Verfahren nach dem vorstehenden Anspruch, **dadurch gekennzeichnet, dass** die Derivate höherer Ordnung Derivate erster Ordnung sind.

6. Verfahren nach einem der vorstehenden Ansprüche, **dadurch gekennzeichnet, dass** der vorgegebene dritte Schwellenwert gewählt wird in Funktion der Maßeinheit, die für den von jedem Nutzer verbrauchten Ströme und für die Folgen von Werten des von einem jeweiligen Nutzer verbrauchten Stroms $(f_i)_k$ verwendet wird.

7. Verfahren nach einem der vorstehenden Ansprüche, **dadurch gekennzeichnet, dass**, wenn die Standardabweichung $\sigma_i$ einer oder mehrerer Folgen von Werten des von einem jeweiligen Nutzer $(U_1, U_2...U_N)$ verbrauchten Stroms $\{(f_1)_1, (f_1)_2...(f_1)_M; (f_2)_1, (f_2)_2...(f_2)_M; ... (f_N)_1, (f_N)_2...(F_N)_M\}$ gleich null ist, es nicht möglich ist, den statistischen Korrelationskoeffizienten $\rho_i$ der einen oder der mehreren Folgen von Werten des verbrauchten Stroms $(f_i)_k$ zu berechnen, und der jeweilige Nutzer $(U_1, U_2...U_N)$ an die für die Elektrizitätsversorgung verantwortliche Stelle gemeldet wird.

8. Verfahren nach einem der vorstehenden Ansprüche, **dadurch gekennzeichnet, dass** der vorgegebene Korrelationsschwellenwert gewählt wird in einem ersten Bereich von Werten, von einem Wert größer als oder gleich 0,4 bis zu einem Wert gleich 1, oder in einem zweiten Bereich von Werten, von einem Wert größer als oder gleich 0,2 bis zu einem Wert kleiner als 0,4, oder in einem dritten Bereich von Werten, von einem Wert größer als oder gleich 0,1 bis zu einem Wert kleiner als 0,2.

9. Computerprogramm, umfassend Codemittel, die so konfiguriert sind, dass sie bei Ausführung auf einem Computer die Schritte des Verfahrens nach einem der vorstehenden Ansprüche durchführen.

10. System zum Bestimmen von elektrischen Verlusten mindestens einer Stromleitung (100), wobei die mindestens eine Stromleitung (100) an eine Vielzahl von Nutzern ($U_1$, $U_2$...$U_N$) angeschlossen ist, wobei das System die mindestens eine Stromleitung sowie Folgendes umfasst:

- einen Transformatorraum (1) zum Bereitstellen von elektrischem Strom an die Nutzer der Vielzahl von Nutzern ($U_1$, $U_2$...$U_N$) durch die mindestens eine Stromleitung (100),
- mindestens einen Elektrizitätszähler, assoziiert mit einem jeweiligen Nutzer der Vielzahl von Nutzern ($U_1$, $U_2$...$U_N$), zum Messen des von dem Nutzer verbrauchten Stroms, wobei der Elektrizitätszähler den von jedem Nutzer der Vielzahl von Nutzern ($U_1$, $U_2$...$U_N$) verbrauchten Strom in vorgegebenen Zeiteinheiten, vorliegend in einem vorgegebenen Zeitraum, misst, um für jeden Nutzer ($U_1$, $U_2$...$U_N$) eine jeweilige Folge von Werten des verbrauchten Stroms $(f_i)_k$ zu erhalten, wobei $i$ der Index der Anzahl von Nutzern ist, i=1,...N, wobei N eine positive ganze Zahl ist, und k der Index der vorgegebenen Zeiteinheit ist, k=1,...,M, wobei M eine positive ganze Zahl ist,
- mindestens einen Stromzähler (10) zum Messen des von dem Transformatorraum (1) an die mindestens eine Stromleitung (100) gelieferten Stroms in vorgegebenen Zeiteinheiten, vorliegend in einem vorgegebenen Zeitraum, um eine Folge von Durchschnittswerten des Stroms $(s)_k$ in jeder der vorgegebenen Zeiteinheiten zu erhalten, wobei der Stromzähler (10) auf der Stromleitung (100) zwischen dem Transformatorraum (1) und den Nutzern ($U_1$, $U_2$...$U_N$) positioniert ist,

**dadurch gekennzeichnet, dass**

das System eine zentrale Einheit mit einem Computer umfasst, konfiguriert, um die Folge von Werten des verbrauchten Stroms $(f_i)_k$ und die Folge von Durchschnittswerten des Stroms $(s)_k$ durch einen Kommunikationskanal zu empfangen und das Programm nach Anspruch 9 auszuführen.

**Revendications**

1. Procédé pour déterminer les pertes électriques d'au moins une ligne électrique (100) dues au dysfonctionnement ou à l'altération d'un compteur électrique et/ou à une connexion illégale à ladite ligne électrique, ladite au moins une ligne électrique (100) étant connectée à une pluralité d'utilisateurs ($U_1$, $U_2$...$U_N$) et à une salle de transformateur (1) pour fournir un courant électrique, par l'intermédiaire de ladite au moins une ligne électrique (100), à ladite pluralité d'utilisateurs ($U_1$, $U_2$...$U_N$), et à au moins un wattmètre (10) pour mesurer la puissance fournie à partir de ladite salle de transformateur (1) à ladite ligne électrique (100) dans des unités temporelles prédéterminées présentes dans une période de temps prédéterminée, ledit wattmètre étant agencé sur ladite au moins une ligne électrique (100) entre ladite salle de transformateur (1) et lesdits utilisateurs ($U_1$, $U_2$...$U_N$), ledit procédé comprenant les étapes suivantes :

A) l'acquisition d'une valeur moyenne de puissance s en se référant à la puissance fournie à partir de la salle de transformateur (1) à ladite ligne électrique (100) et mesurée par ledit wattmètre (10), de manière à obtenir une séquence de valeurs moyennes de puissance dans chaque unité temporelle prédéterminée présente dans la période de temps prédéterminée $(s)_k$, avec k=1,...,M où M est un nombre entier positif, où k est l'indice du nombre des unités temporelles prédéterminées dans la période de temps prédéterminée ;
B) le calcul de la valeur moyenne $\bar{s}$ des valeurs moyennes de puissance en se référant aux valeurs moyennes de chaque séquence de valeurs de puissance $(s)_k$ et à un écart-type $\sigma_s$ par rapport à la puissance fournie à partir de la salle de transformateur (1) à ladite ligne électrique (100) et mesurée par ledit wattmètre (10) :

$$\bar{s} = \frac{1}{M} \sum_{k=1}^{M} (s)_k$$

$$\sigma_S = \frac{1}{M} \sqrt{\sum_{k=1}^{M} ((s)_k - \bar{s})^2}$$

C) l'acquisition de la puissance absorbée par chaque utilisateur ($U_1$, $U_2$...$U_N$) dans chaque unité temporelle prédéterminée présente dans la période de temps prédéterminée, afin d'obtenir pour chaque utilisateur ($U_1$, $U_2$...$U_N$) une séquence respective de valeurs de puissance absorbée $(f_i)_k$, avec i=1,...,N où N est un nombre entier positif, où i est l'indice du nombre d'utilisateurs :

$$\{(f_1)_1,\ (f_1)_2...(f_1)_M\}$$
$$\{(f_2)_1,\ (f_2)_2...(f_2)_M\}$$
$$...$$
$$\{(f_N)_1,\ (f_N)_2...(f_N)_M\}$$

D) le calcul de la valeur moyenne $\overline{f_i}$ et de l'écart-type $\sigma_i$ de chaque séquence de valeurs de puissance absorbée par chaque utilisateur ($U_1$, $U_2$...$U_N$) :

$$\overline{f_i} = \frac{1}{M}\sum_{k=1}^{M}(f_i)_k$$

$$\sigma_i = \frac{1}{M}\sqrt{\sum_{k=1}^{M}((f_i)_k - \overline{f_i})^2}$$

E) le calcul d'une séquence de valeurs de différence $(D)_k$, chacune étant égale à la différence entre la puissance fournie à partir de ladite salle de transformateur (1) à ladite ligne électrique (100) et mesurée par ledit wattmètre (10) et la somme des puissances absorbées par chaque utilisateur ($U_1$, $U_2$...$U_N$) pour chaque unité temporelle prédéterminée présente dans la période de temps prédéterminée :

$$(D)_k = (s)_k - \sum_{i=1}^{N}(f_i)_k$$

F) le calcul de la valeur moyenne $\overline{D}$ et de l'écart-type $\sigma_D$ de ladite séquence de valeurs de différence :

$$\overline{D} = \frac{1}{M}\sum_{k=1}^{M}(D)_k$$

$$\sigma_D = \frac{1}{M}\sqrt{\sum_{k=1}^{M}((D)_k - \overline{D})^2}$$

G) la détermination d'une valeur moyenne de rendement $\overline{e}$ associée à ladite ligne électrique (100) dans la période de temps prédéterminée avec la formule suivante :

$$\overline{e} = \frac{1}{M}\sum_{k=1}^{M}\left(\frac{\sum_{i=1}^{N}(f_i)_k}{(s)_k}\right)$$

H) la comparaison de ladite valeur moyenne de rendement $\bar{e}$ à un premier seuil prédéterminé ou à un seuil de rendement prédéterminé ;

I) si la valeur moyenne dudit rendement $\bar{e}$ est supérieure ou égale au seuil de rendement prédéterminé, aucune perte électrique n'est rapportée à une entité responsable de la fourniture d'électricité en se référant aux pertes électriques dues à un dysfonctionnement ou à une altération d'un compteur électrique associé à un utilisateur respectif ($U_1$, $U_2$...$U_N$) ;

L) si la valeur moyenne dudit rendement $\bar{e}$ est inférieure audit seuil de rendement prédéterminé, la mise en oeuvre des étapes suivantes :

L1) le calcul du coefficient de corrélation statistique $\rho_i$ associé à chaque utilisateur ($U_1$, $U_2$...$U_N$) entre chaque séquence de valeurs de puissance absorbée $(f_i)_k$ par un utilisateur respectif ($U_1$, $U_2$...$U_N$), et ladite séquence de valeurs de différence $(D)_k$ dans la période de temps prédéterminé, normalisé avec le produit des écarts-types des séquences respectives de valeurs de puissance consommée et l'écart-type de la séquence de valeurs de différence, avec la formule suivante :

$$\rho_i = \frac{\sum_{k=1}^{M}\left((f_i)_k - \bar{f_i}\right)\left((D)_k - \overline{D}\right)}{\sigma_i \sigma_D}$$

L2) la comparaison du coefficient de corrélation statistique $\rho_i$ associé à chaque utilisateur ($U_1$, $U_2$...$U_N$) à un deuxième seuil prédéterminé ou à un seuil de corrélation prédéterminé ;

L3) si un ou plusieurs coefficients de corrélation statistique $\rho_i$ associés à un ou plusieurs utilisateurs respectifs ($U_1$, $U_2$...$U_N$) sont supérieurs ou égaux audit seuil de corrélation prédéterminé, le fait de signaler lesdits utilisateurs à une entité responsable de la fourniture d'électricité en se référant aux pertes électriques dues à un dysfonctionnement ou à une altération d'un ou de plusieurs compteurs électriques associés auxdits utilisateurs ;

M) la détermination de la présence d'au moins une connexion illégale à ladite ligne électrique (100) par les étapes suivantes :

M1) la définition d'un vecteur colonne à M dimensions y formé par une séquence de valeurs de différence $(D)_k$ :

$$y = \begin{pmatrix} (D)_1 \\ (D)_2 \\ \cdot \\ \cdot \\ \cdot \\ (D)_M \end{pmatrix}$$

M2) la définition d'une matrice X à M rangées et N+1 colonnes, où la première colonne est une colonne de valeurs constantes $\alpha$, égales les unes aux autres, et chacune des colonnes restantes est composée d'une séquence de valeurs de puissance absorbée par un utilisateur respectif ($U_1$, $U_2$...$U_N$) dans chaque unité temporelle prédéterminée :

$$X = \begin{pmatrix} \alpha & (f_1)_1 & (f_2)_1 & \cdots & (f_N)_1 \\ \alpha & (f_1)_2 & (f_2)_2 & \cdots & (f_N)_2 \\ \cdot & \cdot & \cdot & \cdots & \cdot \\ \cdot & \cdot & \cdot & \cdots & \cdot \\ \cdot & \cdot & \cdot & \cdots & \cdot \\ \alpha & (f_1)_M & (f_2)_M & \cdots & (f_N)_M \end{pmatrix}$$

M3) la définition d'une équation linéaire sous forme de matrice avec la formule suivante :

$$\theta = \left(X^T X\right)^{-1} X^T y$$

où $\theta$ est un vecteur colonne ainsi défini :

$$\theta = \begin{pmatrix} \theta_0 \\ \theta_1 \cdot \\ \cdot \\ \cdot \\ \theta_N \end{pmatrix}$$

$\theta_0$, $\theta_1 ... \theta_N$ sont les composantes du vecteur colonne $\theta$ constituant les paramètres qui résolvent ladite équation linéaire sous forme de matrice,
$X^T$ est la matrice transposée de la matrice X,
$(X^T X)^{-1}$ est la matrice pseudo inverse de Moore-Penrose de la matrice résultant de la multiplication de la matrice $X^T$ transposée et de la matrice X,
y est le vecteur colonne à M dimensions défini à l'étape M1) ;

M4) la comparaison du premier paramètre $\theta_0$ audit vecteur colonne $\theta$ à un troisième seuil prédéterminé, où ledit troisième seuil prédéterminé est sélectionné de façon que le résultat de la multiplication entre ledit troisième seuil prédéterminé et une valeur constante $\alpha$ soit une valeur moyenne prédéterminée de puissance absorbée pour une unité de temps au-dessus de laquelle au moins une connexion illégale à ladite ligne électrique doit être trouvée ;
M5) si ledit premier paramètre $\theta_0$ est supérieur ou égal audit troisième seuil prédéterminé, le fait de signaler au moins une perte électrique à une entité responsable de la fourniture d'électricité due à au moins une connexion illégale à ladite ligne électrique (100).

2. Procédé selon la revendication précédente, **caractérisé en ce que**, après l'étape I), il comprend les étapes suivantes :

I1) le calcul de l'autocorrélation $A_D$ de ladite séquence de valeurs de différence $(D)_k$ normalisée avec le carré de l'écart-type $\sigma_D$ de ladite séquence de valeurs de différence :

$$A_D = \frac{\sum_{k=1}^{M-\tau} \left((D)_k - \overline{D}\right)\left((D)_{k+\tau} - \overline{D}\right)}{\sigma_D^2}$$

où $\tau$ est le rapport entre une période de temps prédéterminée supplémentaire et une unité temporelle prédéterminée, où ladite période de temps prédéterminée supplémentaire et ladite unité temporelle prédéterminée ont les mêmes unités de mesure ;

I2) le calcul des autocorrélations $A_i$ de chacune de ladite séquence de valeurs de puissance absorbée $(f_i)_k$ par chaque utilisateur ($U_1$, $U_2$...$U_N$) normalisées avec le carré de l'écart-type $\sigma_i$ de chaque séquence de valeurs de puissance absorbée :

$$A_i = \frac{\sum_{k=1}^{M-\tau}\left((f_i)_k - \bar{f}_i\right)\left((f_i)_{k+\tau} - \bar{f}_i\right)}{\sigma_i^2}$$

I3) l'obtention **d'une** moyenne pondérée $\overline{A}$ desdites autocorrélations $A_i$ de séquences de valeurs de puissance absorbée par chaque utilisateur ($U_1$, $U_2$...$U_N$) :

$$\overline{A} = \sum_{i=1}^{N}\beta_i A_i = \sum_{i=1}^{N}\frac{\bar{f}_i}{\bar{s} - \overline{D}} A_i$$

où $\beta_i$ est un poids défini par le rapport entre ladite valeur moyenne $\bar{f}_i$ de chaque séquence de valeurs de puissance absorbée et la différence entre ladite valeur moyenne $\bar{s}$ des valeurs moyennes de puissance et ladite valeur moyenne $\overline{D}$ de ladite séquence de valeurs de différence ;

I4) la comparaison de la valeur de ladite autocorrélation $A_D$ à la valeur de ladite moyenne pondérée $\overline{A}$ ;

I5) si la valeur de ladite autocorrélation $A_D$ est supérieure à la valeur de ladite moyenne pondérée $\overline{A}$, le fait de signaler au moins une perte électrique à une entité responsable de la fourniture d'électricité due à au moins une connexion illégale à ladite ligne électrique (100).

3.  Procédé selon l'une quelconque des revendications 1-2, **caractérisé en ce que**

    - les valeurs de ladite séquence de valeurs de puissance absorbée $(f_i)_k$ par chaque utilisateur,
    - la valeur moyenne $\bar{f}_i$ et l'écart-type $\sigma_i$ de chaque séquence de valeurs de puissance absorbée $(f_i)_k$ par chaque utilisateur,
    - les valeurs de ladite séquence de valeurs de différence $(D)_k$,
    - la valeur moyenne $\overline{D}$ et l'écart-type $\sigma_D$ de ladite séquence de valeurs de différence $(D)_k$,

    sont des valeurs de dérivés d'ordre zéro.

4.  Procédé selon l'une quelconque des revendications 1-2, **caractérisé en ce que**

    - les valeurs de ladite séquence de valeurs de puissance absorbée $(f_i)_k$ par chaque utilisateur,
    - la valeur moyenne $\bar{f}_i$ et l'écart-type $\sigma_i$ de chaque séquence de valeurs de puissance absorbée $(f_i)_k$ par chaque utilisateur,
    - les valeurs de ladite séquence de valeurs de différence $(D)_k$,
    - la valeur moyenne $\overline{D}$ et l'écart-type $\sigma_D$ de ladite séquence de valeurs de différence $(D)_k$,

    sont des valeurs de dérivés d'ordre supérieur.

5.  Procédé selon la revendication précédente, **caractérisé en ce que** lesdites dérivés d'ordre supérieur sont des dérivés du premier ordre.

6.  Procédé selon l'une quelconque des revendications précédentes, **caractérisé en ce que** ledit troisième seuil prédéterminé est choisi en fonction de l'unité de mesure utilisée pour les puissances absorbées par chaque utilisateur et pour les séquences de valeurs de puissance absorbée $(f_i)_k$ par un utilisateur respectif.

**7.** Procédé selon l'une quelconque des revendications précédentes, **caractérisé en ce que**, quand l'écart-type $\sigma_i$ d'une ou de plusieurs séquences de valeurs de puissance absorbée $\{(f_1)_1,(f_1)_2...(f_1)_M ; (f_2)_1,(f_2)_2...(f_2)_M ;... (f_N)_1,(f_N)_2...(f_N)_M\}$ par un utilisateur respectif $(U_1, U_2...U_N)$ est égal à zéro, il n'est pas possible de calculer le coefficient de corrélation statistique $\rho_i$ desdites une ou plusieurs séquences de valeurs de puissance absorbée $(f_i)_k$, et l'utilisateur respectif $(U_1, U_2...U_N)$ est signalé à ladite entité responsable pour la fourniture d'électricité.

**8.** Procédé selon l'une quelconque des revendications précédentes, **caractérisé en ce que** ledit seuil de corrélation prédéterminé est choisi dans une première plage de valeurs, allant d'une valeur supérieure ou égale à 0,4 à une valeur égale à 1, ou dans une deuxième plage de valeurs, allant d'une valeur supérieure ou égale à 0,2 à une valeur inférieure à 0,4, ou dans une troisième plage de valeurs, allant d'une valeur supérieure ou égale à 0,1 à une valeur inférieure à 0,2.

**9.** Programme informatique, comprenant des moyens de code configurés de manière à, quand ils sont exécutés sur un donateur, mettre en oeuvre les étapes du procédé selon l'une quelconque des revendications précédentes.

**10.** Système pour déterminer des pertes électriques d'au moins une ligne électrique (100), ladite au moins une ligne électrique (100) étant connectée à une pluralité d'utilisateurs $(U_1, U_2...U_N)$, ledit système comprenant ladite au moins une ligne électrique, ainsi que :

- une salle de transformateur (1) pour fournir un courant électrique auxdits utilisateurs de ladite pluralité d'utilisateurs $(U_1, U_2...U_N)$ par l'intermédiaire de ladite au moins une ligne électrique (100),
- au moins un compteur électrique associé à un utilisateur respectif de ladite pluralité d'utilisateurs $(U_1, U_2...U_N)$ pour mesurer la puissance absorbée par ledit utilisateur, ledit compteur électrique mesurant la puissance absorbée par chaque utilisateur de ladite pluralité d'utilisateurs $(U_1, U_2...U_N)$ dans des unités temporelles prédéterminées présentes dans une période de temps prédéterminée, afin d'obtenir pour chaque utilisateur $(U_1, U_2...U_N)$ une séquence respective de valeurs de puissance absorbée $(f_i)_k$, avec $i$ l'indice du nombre d'utilisateurs, i=1,...,N, avec N un nombre entier positif, et k l'indice de l'unité temporelle prédéterminée, k=1,...,M, avec M un nombre entier positif,
- au moins un wattmètre (10) pour mesurer la puissance fournie à partir de ladite salle de transformateur (1) à ladite au moins une ligne électrique (100) dans des unités temporelles prédéterminées présentes dans une période de temps prédéterminée, afin d'obtenir une séquence de valeurs moyennes de puissance $(s)_k$ dans chacune desdites unités temporelles prédéterminées, ledit wattmètre (10) étant positionné sur ladite ligne électrique (100) entre ladite salle de transformateur (1) et lesdits utilisateurs $(U_1, U_2...U_N)$,

**caractérisé en ce que**
ledit système comprend une unité centrale avec un ordinateur configuré pour recevoir ladite séquence de valeurs de puissance absorbée $(f_i)_k$ et ladite séquence de valeurs moyennes de puissance $(s)_k$, par l'intermédiaire d'un canal de communication, et pour exécuter le programme selon la revendication 9.

Fig. 1

Fig. 2

**EP 3 304 101 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **NAGI.** *Detection of Abnormaliteis and Electricity Theft using Genetic support vector machines*
- A statistical method to minimize electrical energy losses in a local electricity distribution network. **FOURIE J W et al.** AFRICON, 2004. 7TH AFRICON CONFERENCE IN AFRICA GABORONE, BOTSWANA SEPT. 15-17, 2004. IEEE, 15 September 2004, vol. 2, 667-673
- Non-Technical Losses in power system: A review. **ABHISHEK CHAUHAN et al.** POWER, ENERGY AND CONTROL (ICPEC), 2013 INTERNATIONAL CONFERENCE ON. IEEE, 06 February 2013, 558-561
- Non-Technical Loss Detection Using State Estimation and Analysis of Variance. **SHIH-CHE HUANG et al.** IEEE TRANSACTIONS ON POWER SYSTEMS. IEEE SERVICE CENTER, 01 August 2013, vol. 28, 2959-2966
- Power Utility Nontechnical Loss Analysis With Extreme Learning Machine Method. **NIZAR A H et al.** IEEE TRANSACTIONS ON POWER SYSTEMS. IEEE SERVICE CENTER, 01 August 2008, vol. 23, 946-955